# EUROPEAN PATENT SPECIFICATION

(11) **EP 3 911 794 B1**
(45) Date of publication and mention of the grant of the patent: **30.07.2025**
(21) Application number: 20759426.8
(22) Date of filing: 18.02.2020
(51) Int. Cl.: D06M 10/02, D06M 23/00, C23C 4/134, H05H 1/24, D06B 5/08, B05D 1/00, H05H 1/46, D06B 19/00

(54) **SYSTEM FOR TREATMENT AND/OR COATING OF SUBSTRATES**
SYSTEM ZUR BEHANDLUNG UND/ODER BESCHICHTUNG VON SUBSTRATEN
SYSTÈME DE TRAITEMENT ET/OU DE REVÊTEMENT DE SUBSTRATS

(30) Priority: 19.02.2019 AU 2019900536
(43) Date of publication of application: 24.11.2021
(60) Divisional application: 25184534.3
(73) Proprietor: Xefco Pty Ltd, Lilyfield NSW 2040 (AU)
(72) Inventor: HUSSEY, Thomas, Drummoyne, New South Wales 2047 (AU); CONOLLY, Brian, Northwood, New South Wales 2066 (AU); WHITBY, Scott, Chatswood, New South Wales 2067 (AU)
(74) Representative: Doherty, William
(86) International application number: PCT/AU2020/050139
(87) International publication number: WO 2020/168382

(56) References cited:
- US-A1- 2004 152 381
- US-A1- 2005 130 529
- US-A1- 2006 118 242
- US-A1- 2011 287 193
- US-A1- 2014 023 856
- US-A1- 2014 220 262
- US-A1- 2018 202 046
- US-B2- 6 841 201

## Description

### TECHNICAL FIELD

The present disclosure relates to a system for treatment of materials. More particularly, a system for treating a substrate or textile with at least one of a chemical treatment, a physical treatment, a vapour deposition treatment, or a plasma treatment.

### BACKGROUND

Fabrics, materials or textiles are used in everyday life throughout the world for a wide range of applications. Typically fabrics will be manufactured for use in clothing, but may have a wide range of uses in other applications. Depending on the application of the textile, there may be a number of desired functions the textile is to perform. As such, applying functional coatings, polymer coatings, films or performing other treatment processes is typically desirable.

Other articles into which fabrics may be manufactured as well are commodities, such as backpacks, umbrellas, tents, blinds, screens, canopies, tapestry, household textiles, sleeping bags etc. Fabrics are also utilised as filtration media articles for use, for example, in heating, insulation, ventilation or air conditioning systems or for use in exhaust filters, diesel filters, liquid filters, filtration media for medical applications and so on. Typically, insulation materials are non-woven, knitted or otherwise formed into materials with a regular fibre structure or regular arrangement of the fibres. The methods and processes of this invention are applicable to all such fabrics or substrates which may be used for these applications.

The use of ionized gases, which may be plasma, for treating, modifying and etching of material surfaces is well established within the field of fabrics. Vacuum-based plasmas and near-atmospheric pressure plasmas have been used for surface modification of materials ranging from plastic wrap to non-woven materials and textiles, the plasma being used to provide an abundant source of active chemical species, which are formed inside the plasma, from the interaction between resident electrons in the plasma and neutral or other gas phase components of the plasma. Typically, the active species responsible for surface treatment processes have such short lifetimes that the substrate 1 must be placed inside the plasma, which may be referred to as "in-situ" plasma processing. In this process a substrate is present together inside a process chamber in contact with the plasma so that the short-lived active chemical species of the plasma are able to react with the substrate before decay mechanisms, such as recombination, neutralization or radiative emission can de-activate or inhibit the intended surface treatment reactions.

In addition to vacuum-based plasmas, there are a variety of plasmas that operate at or near atmospheric pressure. Included are dielectric barrier discharges, which have a dielectric film or cover placed on one or both of the powered and ground electrodes; corona discharges, which typically involve a wire or sharply-pointed electrode; micro-hollow discharges, which consist of a series of closely-packed hollow tubes that form either the radiofrequency electrode or ground electrode to generate a plasma. A flow-through design may be used by these devices, which consists of parallel-placed screen electrode and in which a plasma is generated by the passage of gas through the two or more screen electrodes; plasma jets in which a high gas fraction of helium is used along with electrical power and a close electrode gap to form an arc-free, non-thermal plasma; and a plasma torch, which uses an of an arc intentionally formed between two interposed electrodes to generate extremely high temperatures for applications such as sintering, ceramic formation and incineration.

The use of atmospheric pressure gases for generating a plasma provides a greatly simplified means of treatment for large or high volume substrates, such as plastics, textiles, non-wovens, carpet, and other large flexible or inflexible objects, such as aircraft wings and fuselage, ships, flooring, commercial structures. Treatment of these substrates using vacuum-based plasmas is complicated, dangerous and typically prohibitively expensive. The present state of the art for plasmas operating at or near atmospheric pressure also limits the use of plasma for treatment of these commercially-important substrates. Further, plasmas operating at or near atmospheric pressure are still limited by the use of a processing chamber in which a plasma is generated, which again may lower the production rate of commercially-important substrates.

A known atmospheric pressure plasma chamber is disclosed in US 7288204 B2 in which there is taught a method for generating an atmospheric pressure glow plasma. This method utilises a plasma treatment within a treatment chamber and gases are blown into the chamber. This method has a number of functional problems with regards to being used outside of a chamber.

Other chamber plasma processing methods are also known, and will generally restrict the volume of substrate which can be treated in a single processing run due to the size of the chamber and also due to the application methods. Some systems are disclosed in US2018/202046A1, US2011/287192A1, US2014/220262A1, and US2006/118242A1.

Other known plasma treatment devices include plasma torches, however these devices are generally destructive for most materials as the torch can achieve temperatures of up to 5,000°C up to 28,000°C during use. These devices are typically used for welding, cutting or other industrial purposes and typically have limited applications in treatment of substrates, but may be used depending on the substrate being treated and the desired processing.

Any discussion of the prior art throughout the specification should in no way be considered as an admission that such prior art is widely known or forms part of common general knowledge in the field.

### SUMMARY

### PROBLEMS TO BE SOLVED

It may be advantageous to provide for a system which provides for an improved treatment process.

It may be advantageous to provide for a plasma treatment system.

It may be advantageous to provide for an improved plasma deposition system.

It may be advantageous to provide for a system with removable modules.

It may be advantageous to provide for a shower head for atmospheric treatments.

It may be advantageous to provide for a system which can treat materials and substrates within atmosphere.

It may be advantageous to provide for a system which can be used in open atmosphere conditions and pressures.

It may be advantageous to provide for a plasma treatment system with removable electrodes.

It may be advantageous to provide for a plasma treatment system with removable gas delivery modules.

It may be advantageous to provide for a system with improved processing speeds.

It may be advantageous to provide for a modular system which may be easier to maintain and clean.

It may be advantageous to provide for a modular treatment head.

It may be advantageous to provide for an improved monomer plasma polymerisation system.

It may be advantageous to provide for an improved substrate processing system.

It is an object of the present invention to overcome or ameliorate at least one of the disadvantages of the prior art, or to provide a useful alternative.

### MEANS FOR SOLVING THE PROBLEM

A first aspect of the present invention may relate to a system for treating a substrate, as defined in the appended claims.

According to the invention the module is a plasma module comprising two or more electrodes. The two or more electrodes comprise a ground electrode and a radiofrequency electrode. A plasma region is formed between the two or more electrodes. The module is movable relative to the substrate plane. The module is connected to a fluid supply for delivery of fluid to the module. Preferably, the module may be connected to a power source and a controller, the power source being adapted to power the module and the controller being adapted to control functions of the module. Preferably, the substrate plane may be defined by a pair of rollers either side of the module. Preferably, a vertical stack of modules are provided to treat a substrate. Preferably, a fluid collection means may be disposed relatively under the substrate to collect excess fluids from the module. Preferably, the treatment module may be selected from the group of a; coating module, film applicator module, plasma module, dyeing module, heat module, radiation module, and a thermal module. Preferably, the treatment module may be a plurality of treatment modules arranged in series.

In the context of the present invention, the words "comprise", "comprising" and the like are to be construed in their inclusive, as opposed to their exclusive, sense, that is in the sense of "including, but not limited to".

The invention is to be interpreted with reference to the at least one of the technical problems described or affiliated with the background art. The present aims to solve or ameliorate at least one of the technical problems and this may result in one or more advantageous effects as defined by this specification and described in detail with reference to the preferred embodiments of the present invention.

### BRIEF DESCRIPTION OF THE FIGURES

Figure 1 illustrates a schematic view of an embodiment of a system for treatment of materials, substrates and textiles;
Figure 2 illustrates another schematic of an embodiment of a system for treatment of materials;
Figure 3 illustrates a further schematic of an embodiment of a system for treatment of materials;
Figure 4 illustrates yet a further schematic of an embodiment of a system for treatment of materials;
Figure 5 illustrates yet another schematic of an embodiment of a system for treatment of materials;
Figure 6 illustrates an embodiment of a substrate 1 passing under an electrode arrangement of a shower head module;
Figure 7 illustrates another embodiment of a substrate passing under an electrode arrangement of a shower head module in which a high pressure region and a low pressure region are formed;
Figure 8 illustrates an embodiment of a shower head module with direct gas feeds to outlet nozzles;
Figure 9 illustrates an embodiment of a module with a plurality of blocks installed therein;
Figure 10 illustrates yet another embodiment of a module in which electrodes are elongated;
Figure 11 illustrates another embodiment of a module with a common gas chamber;
Figure 12 illustrates yet another embodiment of a module with fluid entrainment means;
Figure 13A illustrates a schematic embodiment of a fluid injector for use with a module;
Figure 13B illustrates another schematic embodiment of a fluid injector for use with a module;
Figure 13C illustrates yet another schematic embodiment of a fluid injector for use with a module;
Figure 14 illustrates a perspective view of an embodiment of a block which can be mounted in a module;
Figure 15 illustrates a perspective view an embodiment of a block rack which can be used in a module;
Figure 16 illustrates another perspective view of an embodiment of a block rack which can be used in a module;
Figure 17 illustrates a top view of an embodiment of a block rack which can be used in a module;
Figure 18 illustrates a step down depressurisation apparatus which can be used with the system;
Figure 19A illustrates a side view of an embodiment of a series of connected treatment modules with electrodes at nozzle;
Figure 19B illustrates a side view of an embodiment of a series of connected treatment modules with electrodes below the electrodes;
Figure 20 illustrates a side view of another embodiment of a pivoting block arrangement of a module;
Figure 21 illustrates a side view of a further embodiment of a pivoting block arrangement of a module;
Figure 22A illustrates a top view of an embodiment of an outlet plate which may be used to direct flow of fluids from a module;
Figure 22B illustrates a top view of another embodiment of an outlet plate which may be used to direct flow of fluids from a module;
Figure 22C illustrates a top view of yet another embodiment of an outlet plate which may be used to direct flow of fluids from a module;
Figure 23 illustrates a top view of an embodiment of two module series with electrodes disposed parallel and perpendicular to the substrate movement;
Figure 24 illustrates a top view of another embodiment of a module series with an offset module
Figure 25 illustrates a top view of yet another embodiment of a module series with a stepped module configuration;
Figure 26 illustrates a top view of another embodiment of a module series with an offset module;
Figure 27 illustrates an embodiment of a retrofitted frame system with a plurality of modules;
Figure 28 illustrates a perspective view of an embodiment of an electrode rack for retaining electrodes;
Figure 29 illustrates a perspective view of an embodiment of an electrode rack side;
Figure 30 illustrates another view of an embodiment of electrode rack portion;
Figure 31 illustrates a sectional view of an embodiment of a recess adapted to receive an electrode;
Figure 32 shows a top view of an embodiment of an electrode rack assembled with a rack connector;
Figure 33 illustrates a perspective view of an embodiment of a blade electrode; and
Figures 34A and 34B illustrates an embodiment of an electrode with multiple cores and plasma regions which may be formed.

### DESCRIPTION OF THE INVENTION

Preferred embodiments of the invention will now be described with reference to the accompanying drawings and non-limiting examples.

### List of features

1 Substrate
3 Frame
5 Local region
10 System
20 Module
22 Plastic module block housing
23 Distal end
24 Proximal end
25 Module series (25A, 25B, 25C, 25D)
30 Power source
33 Fluid supply
35 Cooling system
37 Fluid delivery system
40 Fluid collection means
50 High pressure region
55 Low pressure region
60 Injection assembly
61 Fluid injector
62 Fluid flow control means (Throttle)
101 Electrodes
101A Core
101B Sheath
101C Fluid channel
102 Ground electrode
103 Reaction gap
104 RF electrode
105 Linear sides of electrode
106 Plasma region
107 Fluid inlet
108 Manifold
110 Fluid conduit (from manifold)
112 Outlet
114 Further gas inlet
116 Gas chamber
118 Entrainment gas injector
118A Entrainment port
119 Gas chamber inlet
120 Gas Injector Block
121 Block halves (121A, 121B)
122 Gas cavity
124 Tapered section
126 Elongate porous element
128 Curved edges
130 Block rack
131 Outer wall
131A front wall
131B rear wall
131C side walls
132 Support structure
134 Flange
136 Outlet aperture
138 Inlet aperture
139 Pivot bar
140 Electrode rack
141 Sides (141A, 141B, 141C)
143 Lip
145 Recess
146 Core recess
148 Gasket
150 Outlet plate
160 Abutment edge
162 Projection
164 Extension
200 Partial pressure chamber apparatus
210 - 250 Partial pressure chamber
300 Module series arrangement

There is described herein a system for treatment and processing of materials. More specifically, the system 10 may have particular utility in processing substrates 1 or sheets of materials. Other articles may also be treated by the system 10; however for simplicity reference will be made to substrates throughout this specification. As such, it is not a limitation of the system to only be used in the treatment of substrates 1.

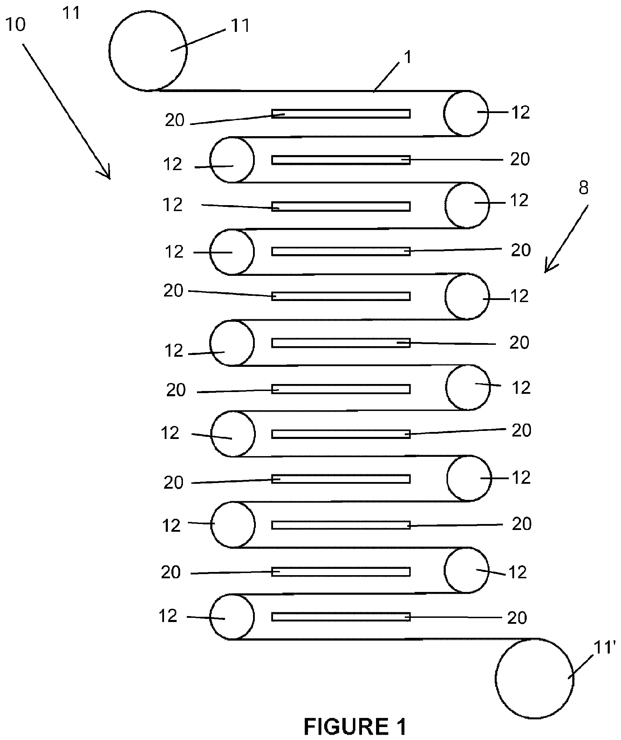

Schematic embodiments of a system 10 are illustrated in Figures 1 to 5 in which a substrate 1 is treated and/or processed by the system. The systems illustrated comprise a number of treatment modules 20 which are used to treat a substrate 1. The treatment modules 20 may be shower head modules, spray modules, deposition modules, heating modules, or any other treatment module. Each module 20 may be removably mounted in the system 10 and be used to pre-treat, treat, coat, cover, heat, shrink, dye, radiate, deposit, activate or perform any desired treatment process to a substrate 1.

A transportation means is provided to the system to transport a substrate 1 from a pre-processed location 11 to a processed location 11'. In the embodiments, the transportation system may include a plurality of rollers 12 or conveyors for example. A substrate 1 may be moved through the system via any other conventional means, such as pin tracks, tracks, clamps or any other means.

Substrate 1 treatments may involve physical alterations, chemical alterations, coatings, application of films, surface activations, sterilisation, polymerisation or other desired treatment process. The system 10 may comprise any number of modules to perform said treatments.

A module 20 preferably comprises a housing 22 and a fluid delivery system 37. The fluid delivery system comprises a fluid inlet 107 coupled with a fluid source 30 and a fluid outlet 112. The fluid delivery system 37 may partially be mounted within the housing 22. Optionally, the fluid delivery system 37 may also comprise a chamber 116, which is in fluid communication with the fluid inlet 107, and the fluid outlet 112, such that fluid is directed into the chamber 116 via the fluid inlet 107, and out of the chamber via fluid outlet 112. The fluid chamber 116 being in fluid communication with an outlet 112 of the module 20, and the outlet 112 adapted to allow release of fluids supplied via the fluid inlet 107 to the fluid chamber 116. Fluids provided to the chamber 116 may be from a fluid source 33. The fluid source 33 may comprise at least one fluid selected from the following group; a precursor gas, a monomer, a delivery gas, a treatment chemical, a treatment compound, a hydrophobic fluid, a hydrophilic fluid, a pigment, a dye, as sterilant, or any other predetermined fluid for supply to a substrate 1 or to clean the module 20.

A power source 30 is preferably coupled with a module 20, such that the module 20 can be activated, deactivated, altered or otherwise manipulated by a user of the system for a desired treatment process. The power source may also be an RF source to charge an RF electrode 104. Electrodes 101 may be formed with a core 101A and a sheath 101B. The core 101A being a conductive material, such as copper or stainless steel for example, and the sheath 101B being a dielectric material. The core 101A may be any conductive material which can withstand heating to temperatures which are equal to or less than that of the plasma formed in the plasma region or withstand temperatures induced by charging the electrode 101. Preferably, the melting point of the core 101A exceeds 500°C, but more preferably exceeds 1000°C. The sheath 101B selected is to be formed from a dielectric material which can encompass or encapsulate the core material to reduce arcing and assist with stabilisation of plasma formed in the plasma region. Optionally, an air gap or fluid gap may be provided around the core which can assist with cooling and dielectric properties of the electrode 101. For example, air or inert gas may be used as a cooling fluid which may be passed between the electrode core 101A and the sheath 101B. In another embodiment, the electrode 101 is provided with one or more fluid cooling channels or a cooling channel which is used to cool the electrode 101.

While electrode sheaths 101B may be a rectangular shape or circular shape, the core 101A may be any predetermined shape which may or may not correspond with the shape of the electrode sheath. For example, an electrode 101 may be a blade type electrode 101 which has a rectangular sheath cross section, however the core may be circular or any other predetermined shape. Fluid conduits may have any predetermined cross section, this may include a regular shape, a sinusoidal shape or a waveform shape cross section. The general shape of the sheath may define the type of electrode 101 regardless of the cross section of the core 101A.

The space between the electrodes may be referred to as a reaction gap 103, wherein a reaction between a voltage and a plasma fluid may be observed, or where polymerisation occurs. The plasma region(s) 106 is formed within the reaction gap 103, and may fill the entire reaction gap 103, or a portion thereof.

The module has a distal end 23 and a proximal end 24. The proximal end 24 being the side closest to the substrate 1 to be processed and the distal end 23 being the end furthest away from the substrate 1.

The outlets 112 may be fitted with a sealing means to stop or restrict flow of a fluid via outlet 112. This may be advantageous in the event of an emergency stop of the system 10 as the sealing means can prevent further delivery of fluids and contain potentially flammable fluids or hazardous chemicals. Sealing means may be actuated by a controller connected with the module 20 or may move into a sealing position in the absence of a current if there is an emergency stop of the system 10. The sealing means can be actuated to open or restrict flow of a fluid to allow for greater fluid delivery control to a substrate. Optionally, outlets 112 can be fitted with nozzles, grills, meshes, or fixed flow restrictor means to control the flow of fluids. The flow of fluids may also be increased or decreased by internal pressures within the chamber 116 or the pressure from the fluid inlet 107. A pressure valve may also be provided to the module 20 to increase or decrease internal pressures which may assist with controlling the flow rate of the fluids for treatment. Alternatively, the fluid inlet 107 is coupled with a manifold 108 which can distribute fluids via fluid conduits 110 within the module housing 22. Fluid conduits may be in fluid communication with one or more chambers 116 which may allow for more effective distribution of fluids. The manifold 107 may be adapted to provide more than one fluid to a chamber 116 or directly to the outlets 112.

Optionally, a fluid reservoir (not shown) can be mounted to a module 20 which is filled with a desired fluid, such as a treatment fluid or dye. The desired fluid can then be allowed to flow from the fluid reservoir through the module 20 and be provided to a substrate 1 via outlet 112. The fluid reservoir may be a mountable tank of fluids which can be used for treatment processing and can be easily swapped or replaced between processing or during processing. The fluid reservoir may be similar to the fluid source 33 in that it can provide a fluid to a module 20, and that the reservoir can be filled while in use such that processing need not stop. It will be appreciated that some modules 20 may be fitted with multiple mounting means to allow for more than one fluid reservoir to be mounted to the module 20. This may be of particular advantage in relation to fluids which are required to be mixed immediately prior to application to a substrate 1. The mounting location for a fluid reservoir may be a keyed fit such that only predetermined reservoir connectors can be mated with the module 20 which may prevent users from mounting fluids which are not to be used with predetermined modules 20. For example, a dyeing module 20 may not allow functional coating chemical fluid reservoirs to be mounted with the module 20. Optionally, a key can be used to lock the fluid reservoir to the module 20 which may also provide for a further safety means which may prevent mounting of a reservoir which is not to be used with a module 20. Further a key can be used to lock and/or connect the fluid source 33 with other components of the fluid delivery system 37.

Optionally, a splash guard or fluid guard is provided adjacent to the substrate 1 to contain fluids or direct fluids towards a fluid collection system 40. This may be beneficial for collection and recycling of fluids from modules 20, and may keep processing areas cleaner as smaller volumes of fluids or no fluids will leave the processing area as they can be directed to and collected by the fluid collection system 40. Fluid collection systems may utilise vacuum systems to suck in fluids, or may be trough systems which are angled or shaped to direct flow of a fluid to a collection drain to be either recycled, collected or disposed of.

In at least one embodiment, the outlet 112 may impart a desired effect to the fluids when exiting to allow for a substrate 1 to be treated in a desired manner. For example, the fluid released from outlets 112 may be a mist, a stream, a pulsed fluid release, a bead, a droplet or any other ejection or release of fluids. It is most preferred that the outlets 112 are adapted to dispense, eject, distribute or otherwise provide a fluid evenly to a substrate 1 surface. If there are applications in which the substrate surface 1 is to be unevenly coated, the module 20 may be adapted to provide said uneven coating. The outlet 112 may comprise a nozzle which is adapted to dispense fluids in a desired manner.

The housing 22 of at least one module 20 is preferably shaped to allow for further modules 20 to be mounted adjacently. Each module housing 22 may be fitted with a mounting means to allow for adjacent mounting of modules and mounting to a frame (not shown) of the system 10. Alternatively, a mounting means can be used to mount the modules in a desired manner in the system 10.

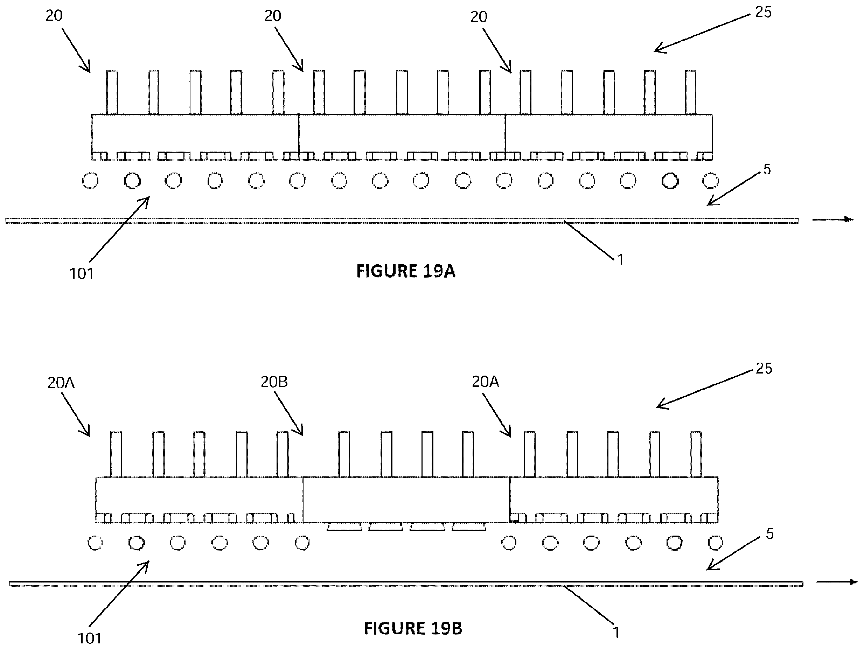

Module housings may be secured to racks internal the module 20. Portions of the housing 22 may be accessible without dismounting the modules from the system. This may allow for replacement of internal components, such as heating elements, electrodes or blocks. Further, portions of the housing may be removable if multiple modules are mounted adjacently in a module series. This may allow for electrode 101 mounting or heating element mounting at, or near to, the area in which the housing was removed, see for example Figure 19A.

A desired fluid flow may be imparted by the fluid delivery system 37 for providing fluids to the electrodes and subsequently to the substrate. Preferably, fluid outlet 112 or fluid conduit 110 may be used to impart said desired fluid flow. It is preferred that if fluids are expelled from a module that the fluids have a laminar flow. As discussed above, if the fluid delivery system 37 comprises chamber 116, the chamber may be shaped to impart a desired fluid flow to fluids being ejected via the outlet 112 module 20. A desired flow may be a turbulent flow, or a laminar flow for example. It is preferred that if fluids are expelled from a module that a laminar flow may be preferred to more effectively treat a substrate. It is preferred that multiple outlets 112 are provided for each module 20 adapted to release fluids, however a single outlet 112 may be desirable depending on the function of the module 20. Reference will be made herein to modules 20 comprising a plurality of outlets 112.

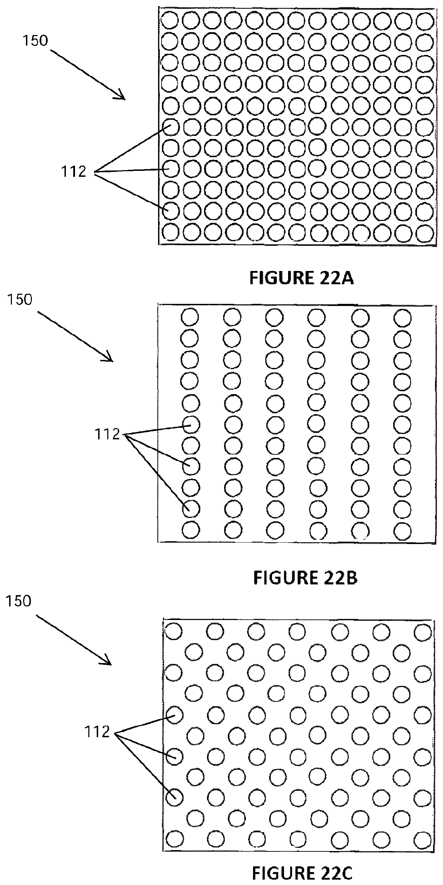

In another embodiment, the outlets 112 of the module 20 may be defined by an outlet plate 150 which may be a grill, mesh or sheet comprising a plurality of apertures or channels through which fluids can be expelled from the module 20 and act as outlets 112. Example of an outlet plates 150 are shown in Figures 22A-22C. Each of the plates 150 may have an array of outlets 112 through which fluids can be dispensed to a substrate 1. The plate may be mounted to the housing 22 of the module 20, or may be mounted to a rack 130 or 140 of the module 20. The array of apertures may correspond to a desired deposition pattern which may correspond with outlets of blocks 120 within the module 20. Each of the illustrated examples of the plates 150 may be used for a specific treatment method, or may be used for a predetermined module configuration. The array of outlets 112 may correspond to blocks 120 of a module 20 (if present) as can be seen in Figure 22B. The outlets 112 may also be configured to align with electrode spacings such that fluids are directed to between the electrodes 101, and preferably the plate 150 is configured to be parallel to the plane of the electrodes 101, or the axis of the apertures 112 may be configured such that they are generally aligned with the centre of desired plasma regions 106.

The substrate 1 to be treated may be, for example, a textile, a fabric, a woven material, a non-woven material, a foil, a polymer, a sheet, or any other desired material which can be provided to the system in sheets. It is preferred that substrates 1 treated by the system 10 are flexible to allow for movement through the system 10 if the system is a vertical stack as shown in Figures 1 to 5, for example. A roll of pre-treated substrate 11 may be provided at an upper end of the system 10 and be passed through the system 10 to a treated substrate location 11'. As the substrate 1 is passed through the system 10, the substrate can be processed and/or treated by at least one module 20 of the system 10. Once the substrate has undergone the desired treatments, the treated substrate 1 can be rolled up at an end 11' of the system 10.

It will be appreciated that conventional plasma treatment apparatuses generally require a vacuum chamber or a chamber in which substrates are treated. As such, use of plasma is not commonly used outside of an enclosed depressurised chamber, and there are a number of problems associated with the use of plasma in non-vacuum chambers or in areas which are not within chambers. One such problem is even distribution or uniform distribution of delivery gases and monomers contained therein without the presence of a vacuum. Another problem is the introduction of fluids into the plasma region 106 or reaction region 106 which may cause polymerisation of dangerous/undesired molecules or ionisation of molecules which may damage a substrate 1 being processed or impact the quality of the treatment. As such, the system modules 20 described herein may be used to address these issues.

### Plasma Modules

According to the invention the system is provided with a plasma module 20. The plasma module 20 may also be a pre-treatment module 20. The plasma module 20 may be a module which can treat a substrate 1 with a desired treatment process. A plasma region 106 may be used for treating at least one surface of a substrate 1 which may be provided by a plasma module 20. The plasma region 106 may be a discharge area, such as the area between two electrodes 101 for example. The surface of a substrate 1 may be activated by a plasma region 106 which can allow for an improved adhesion of a subsequent coating, such as a chemical or physical coating. Activation of a surface of a substrate 1 may also change the surface properties of said substrate 1. For example, functional coatings may be modified or the surface of a substrate may be modified by passing a substrate 1 under, near to or through an electromagnetic field, a radiation source, a plasma field or by passing a substrate 1 under or over a treatment module 20. A plasma module 20 is preferably used by the system 10 and generates a plasma region. The plasma region 106 may optionally be a plasma field in which magnetic fields influence the plasma of the plasma region in a desired manner. In at least one embodiment it is preferred that the plasma generated in the plasma region is an atmospheric-pressure plasma glow (APG). APG may be encouraged by introducing a monomer into a plasma region 106, or may be encouraged by using a Penning mixture. The monomer may be used as a low ionisation fluid which can form part of the Penning mixture with a plasma gas. In some embodiments, the plasma gas is an argon gas and the monomer selected for polymerisation has a lesser ionisation threshold.

As the plasma module 20 can be used in atmosphere, the delivery gas for generating a plasma in the plasma region 106 may be pumped into the local region 5 (region between the substrate and the module) for a predetermined amount of time such that local atmosphere is evacuated from the local region 5 before igniting the delivery gas such that local atmosphere molecules are not ionised or activated. Purging local atmosphere may also be desirable if the system is used within an enclosed chamber such that ionised matter can be predicted and functional treatment properties can be controlled.

Polymerisation and/or re-polymerisation of a surface may also be achieved by passing a substrate 1 under a plasma field. It will also be appreciated that an electromagnetic field may also be used to pre-treat a substrate. Another pre-treatment may also include supply of a sterilant gas to a substrate, such as ozone, ethylene oxide, or hydrogen peroxide. Other non-FDA approved sterilant gases may also be used by the system with appropriate safety provisions. Sterilant gases may be vacuumed collected or removed after treatments such that the sterilant gases are not introduced into the atmosphere external the processing location or move into breathable gas areas which could impact safety. In at least one embodiment, gases used with the system 10 are breathable gases which may improve safety in the event that gas removal apparatuses or gas collection apparatuses fail. It is preferred that any undeposited polymer and fluids from a module 20 are captured and recycled. Recycling monomer, polymer and fluids from the treatment module 20 may allow for feeding of these fluids back into the treatment module 20 such that they can be recycled until they are consumed or taken out of the system 10.

The plasma module 20 may be connected to a fluid delivery system 37 which comprises at least one fluid inlet 107 which may deliver a delivery gas to electrodes 101. The electrodes 101 are a combination of RF electrodes 104 and ground electrodes 102, or in any embodiment electrodes 102 and 104 may be positive and negative electrodes, which are connected to a power supply 30. The position of electrodes 102 and 104 may be swapped if desired, or polarity may be selectively swapped. The electrodes 101 can be charged such that when the delivery gas is provided between or near to the electrodes 101 a plasma region 106 is created by the electrodes 101 energising/ionising the delivery gas. The frequency and amplitude of the electrodes 101 will depend on the delivery gas provided to the electrodes 101 and/or depend on the substrate 1 to be treated by the plasma region 106. The voltage Vₐ needed to apply to the electrodes 102, 104 in order to ignite a plasma in the plasma region 106 is equal to Vₐ=V_{ig}+V_{d}+V_{nca}, in which V_{ig} is the (local) voltage necessary to ignite a plasma, V_{d} is the voltage drop over a dielectric barrier on an electrode (if present), and V_{nca} is the additional voltage drop over any non-conducting (insulating) areas.

At least one further fluid may be provided to the plasma region 106 which is carried by the delivery gas, or injected directly into the plasma region 106. The further fluid will typically be used to treat a substrate 1 or apply a coating. In one embodiment, the further fluid may be a monomer which can be polymerised by the plasma region 106, and may be used for a plasma enhanced chemical vapour deposition (PECVD). Optionally, the further fluid is provided to the plasma module 20 by at least one further inlet. If a delivery gas and at least one further fluid are provided to the module 20 the fluids are preferably mixed together in a desired ratio such that a known amount of further fluids can be delivered to a substrate 1 via an outlet 112.

The spacing of the electrode 104 and the planar ground electrode 102 may be any desired spacing. The electrodes 104 may be constructed with parallel, grounded, hollow circular or oval tubes having a desired diameter. It is preferred that the electrodes 101 have a uniform spacing such that corona discharges are less likely to occur during use which can damage electrodes 101. Spacings may have a maximum distance such that a desired plasma density can be formed. Further, it is preferred that the electrodes 101 comprise a uniform diameter or cross-sectional area.

In at least one embodiment, the electrical energy from the power source 30 supplied to the electrodes 101 is in a frequency range between about 1 MHz and about 100 MHz. Optionally, the power source may be used to adjust for a load deviation of 50 Ohms in the system. An AC power supply or a DC power supply may be used depending on the desired treatment process. Optionally, the AC power supply is a three-phase power supply.

In one embodiment, it is preferred that the power supply 30 provides an AC voltage with an amplitude in the range of 3-6 kV (optimal 5 kV), at frequency in the range of 1 kHz-1 MHz (optimum 10-500 kHz). These amplitudes and frequencies may allow for a desired plasma to be generated between the electrodes 101, preferably allowing for a stable plasma glow. Upon reaching a break down voltage, which is dependent on the gas used and the properties of the dielectric, plasma will be generated between the dielectric and the substrate. Simultaneously, the substrate 1 may be moved in any direction past the plasma in order to treat the substrate 1 surface nearest to the plasma.

The distance between the electrodes, may be referred to as the discharge space and defines the plasma region. The discharge space may be in the range of 0.1mm to 5 mm. The volumetric gas flux of gas flow may be within the range of 1 L/min and 50 L/min, but more preferably is within the range of 5L/min to 15L/min. The thickness of dielectric on the electrodes may be in a range of 1µm to 1000µm, but in one embodiment may be more preferably between 250µm to 500 µm. The stability of the plasma generated may be affected by the surface of the dielectric and the thickness of the dielectric. For example, organic dielectrics, such as PEN or PET, may be used to provide for better plasma stability in comparison to other dielectrics used.

A substrate 1 or textile to be processed can be initially disposed outside of the plasma region 106 generated by the plasma module 20, and passed into plasma regions 106 formed by the RF electrode 104 and the ground electrode 102. The RF electrode 104 and the ground electrode 102 may be collectively referred to herein as electrodes 101. The substrate 1 is maintained at a predetermined distance from the electrodes 101 while being passed such that a uniform exposure to the plasma regions 106 is achieved. It will be appreciated that the electrodes 101 moved relative to the substrate 1 such that a desired effect can be imparted to the substrate. In this way portions of the textile may be activated, sterilised or treated with a predetermined pattern or array. Flowing fluids, preferably gas, vapour and/or a spray/mist of liquid, is provided to the plasma region 106 between the electrodes 101 to generate plasma. Active components produced in the plasma discharge from electrodes 101 flows through spacings of the electrodes and onto the substrate 1. The plasma generated around/between the electrodes may assist with reducing fluid build-up on electrodes 101.

In an embodiment, the densest plasma can be formed between the surface of RF electrode 104 and the surface of grounded electrodes 102. It is preferred that the fluid flow from the outlet 112 flows through the densest plasma regions before deposition on the substrate 1.

The substrate 1 may be moved through the system using an appropriate moving apparatus, such as rollers 12, which can physically move the substrate 1 through the system 10. Any conventional substrate 1 movement equipment may be used with the system 10. Optionally, the substrate 1 may be fixed, mounted, clamped, held or pinned to a movement apparatus to be moved through the system 10.

The fluid delivery system 37 is used to supply a block 120 of the module with fluids or supply fluids directly to an electrode pair 102, 104 or electrode arrangement 101. The fluid delivery system 37 may comprise a fluid inlet 107 connected to a manifold 108, and the manifold being in fluid communication with at least one fluid conduit. One or more fluid sources 30 may be connected to the fluid delivery system 37 such that fluids can be mixed by the fluid delivery system 37 before being provided to a plasma region 106. Optionally, multiple fluid outlets 112 may be provided, with each fluid outlet 112 being used to provide a discrete fluid to the plasma region 106. For example, a first fluid outlet 112 may provide a delivery gas, and a second fluid outlet 112 may provide a monomer. The above configurations may be of particular advantage when supplying a monomer to the plasma region 106. At least one fluid conduit 110 may be connected to a respective block 120 of a module for delivering a fluid to an outlet 112 of the module 20. The fluid delivery system may be used to impart a desired pressure to the fluid which may be used to regulate flow from the module. It will be appreciated that the system 1 may be adapted to dynamically adjust pressures flow rates during processing. The desired pressure may be within a predetermined range and may be a constant pressure or continuous pressure. The outlet 112 may be a fluid channel or may be a plurality of apertures spaced apart along the length thereof, such that fluid (delivery gas) emerges from the outlet 112 through an electrode pair 102, 104 discharge region which can ionise the gas and travel to substrate 1 through the local region 5. The plasma formed between electrodes 101 may be used to polymerise a monomer which has been provided to the plasma. The monomer may be polymerised at the surface of the substrate such that the polymerisation forms a bond with the surface of the substrate at the time of polymerisation. It will be appreciated that some monomers may be polymerised in the plasma region 106, in the local region 105 and on the surface of the substrate 1, such that the polymerised monomers bond with the surface of the substrate 1.

The outlet 112, which may be a nozzle or channel, from the gas block 120 to the electrodes 101 is preferably tapered which may assist with directing flow of fluids from the gas cavity 122 to the plasma regions 106 and then to the substrate 1. The electrode 101 may be manufactured as an integral piece with the module 20 or may be manufactured in multiple pieces such that replacement of the electrodes 101 can be readily made. The plasma face of the electrode 101 is the surface of the electrode which is near to, or exposed to, plasma regions 106 or ionised particles formed between electrodes.

Optionally, in an unillustrated embodiment, electrodes 101 (such as tube electrodes) may be provided directly under the outlet 112 and fluids flow over the electrode and into the densest plasma regions such that the fluids traverse more than 50% of the diameter of the electrode. This method may be used to control the number of activated species (ionised particles) which reach a substrate 1. In another embodiment, the delivery gas is provided to the plasma region electrodes 101 and not directed to flow over the electrodes 101.

If the electrodes are round electrode tubes, it is preferred that the diameter of the tubes is reduced and/or the spacing between electrodes 101 is increased to improve the speed of processing a substrate 1 as impedance of flow may be reduced. For example, the flux of activated species may be increased when the spacing is increased or the diameter of the electrode tubes 101 is decreased. Further, increasing the distance between the electrodes 101 may reduce the potential for corona discharges. Increasing the flux of activated species by increasing the plasma density to increase the number of active species, improving the flow of the active species by eliminating electrodes 101 as physical obstacles, and bringing substrate 1 closer to the plasma regions 106, such that a greater number of active species may reach the substrate 1 unimpeded before they decay and become inactive.

The system 10 has at least one RF electrode 104 having at least one elongated planar surface; at least one grounded electrode 102 having at least one elongated planar surface parallel to the planar surface of the RF electrode 104. These electrodes may replace the round tube electrodes as previously mentioned. The system includes a power source 30 coupled to power supply to at least one first electrode. A cooling system 35 can supply a source of coolant having a chosen temperature for cooling the first electrode and a second electrode. A fluid delivery system 37 adapted to supply a source of delivery gas to the first electrode and/or the second electrode via a gas manifold and/or fluid conduit 110. A plasma region is generated between the first electrode and the second electrode when the delivery gas is ignited. The plasma region defined by the space between the first electrode and the second electrode may be bound by the planar surfaces of the respective electrodes and ionised gases from the plasma region may exit the plasma region generally parallel to the electrode faces. The ionised or activated gases may exit the plasma region generally perpendicular to the surface of a substrate 1 to be treated. An atmospheric-pressure plasma can be formed the plasma region 106. Preferably, the power supply has frequencies between about 100 kHz and 100 MHz. The substrate 1 to be processed may be disposed at a chosen distance, which can be minimized to allow for more activated species or ionised fluids to interact with the substrate 1. The distance between the substrate and the proximal end of the module may be referred to as the local region 5. As the module 20 for generating plasma regions can be used in atmosphere, the delivery gas for generating a plasma in the plasma region 106 may be pumped into the local region 5 for a predetermined amount of time such that local atmosphere is evacuated from the local region 5 before igniting the delivery gas such that local atmosphere molecules are not ionised or activated. Further, as ignition of the delivery gases requires energisation, delivery gases within the local region 5 are not ignited when the delivery gases in the plasma region are ignited. A sensor may be provided in the local region to detect whether a delivery gas in the plasma region can be ignited.

In one embodiment, the system 10 can operate at atmospheric-pressure and does not require the use of a vacuum chamber or sterile chamber to function. In another embodiment, at least a portion of the system 10 is not within a vacuum or depressurised chamber while still having processing occur in atmosphere (not in a chamber). As the system is adapted to function outside of a pressure chamber the system 10 operational costs can be reduced, and processing speeds can be increased as chambers do not require degassing periods.

Further, the system 10 may produce a large area, non-thermal or thermal, stable discharge and the temperature of the module or components thereof can be controlled using a cooling system 35. The cooling system 35 may utilise a fluid coolant such as an inert gas or a liquid coolant which can be used to reduce the temperature of the electrodes. The cooling system 35 may be adapted to regulate temperatures of the module, or components thereof, and not only the electrodes 101. Preferably, an ideal coolant has high thermal capacity, low viscosity, is low-cost, non-toxic, chemically inert and neither causes nor promotes corrosion of the cooling system. Suitable fluids may include at least one of; antifreeze, water, deionized water, nitrogen (gas or liquid), hydrogen, sulfur hexafluoride, steam, air, polyalkylene glycol, oil, mineral oil, liquid salts, carbon dioxide, nanofluids, or any other desired coolant safe for use near high temperature areas such as the plasma regions generated by the system.

Preferably, conduits of the cooling system can be run through the hollow cores of the electrodes 101. Further, the cooling system 35 may transport fluids near to portions of a module 20 which require cooling. Coolants used for the system 10 may be any desired coolant, but are preferably fluids which can be recycled, such as water. Each predetermined module 20 may be in communication with a respective cooling system 35, or a central cooling system 35 may be used to cool all predetermined modules 20 of the system. It will be appreciated that a pump may be used to pump or push fluids through the system 10 or components thereof. Depending on the height of the system 10 a stepped coolant system may be used to reduce the pressure head for pumping fluids. It is preferred that the coolants used for the system 10 are within a closed circuit such that they are not introduced into the processing.

In at least one embodiment, dielectric coatings may be used on the electrodes 101 (or selected electrodes 104, 102) to reduce the potential for arcing which can cause damage to the electrodes 101 or other system components. Coatings may also reduce the potential for build-up of processing fluids on the electrodes 101 or other components of the module 20. It will be appreciated that while the substrate 1 is preferably disposed outside of the plasma discharge area, it may be advantageous to position the substrate 1 as close as possible to the electrodes 101 to have the most activated or treated monomers be deposited on the substrate.

It will be appreciated that atmospheric pressures may be in the range of about 0,666 Bar-1,333 Bar (500 Torr-1000 Torr). Further, any gases delivered to the plasma regions 106 generated by the electrodes may be initially in the temperature range of -10°C to 30°C before entering the plasma regions.

The active chemical species or active physical species of the plasma exit the plasma region 106 before being deposited onto or interact with a substrate 1 disposed outside of the plasma region 106, thereby permitting substrate 1 surface processing, without simultaneous exposure of the substrate 1 to the electric fields or the plasma between the electrodes 101. In this way the substrate 1 is not likely to be damaged and the integrity of the substrate 1 is maintained while providing the desired treatment. It will be appreciated that if the system 10 uses high power densities, has minimum distances between the plasma sources and the substrates 1, the lower operating plasma temperatures need to be and may allow for accelerated processing rates of substrates. Further, having a minimum distance or a distance which is in the range of 1mm to 50mm may reduce the potential for activated species exiting the plasma region to become inactive before reaching the substrate treatment surface.

The system 10 may be used for polymerization, surface cleaning and modification, etching, adhesion promotion, and sterilization, or any other desired treatment process. Polymerisation may be free radical-induced or through dehydrogenation-based polymerisation for example, however other polymerisation processes may be achieved by use of the system.

It is preferred that active species in the plasma generated by the system have as long as possible activation to more successfully be deposited onto or interact with a substrate. Extending the active species life may be achieved by the addition of small amounts of N₂ or O₂, or other gases, or mixtures thereof to a noble gas, such as helium, or a mixture of noble gases may be used in a delivery gas. It will be appreciated that the substrate 1 being polymerised or treated may limit the desired gases which are used for the treatment processes. Optionally, monomers are deposited on a substrate 1 prior to the substrate 1 being passed near to the electrodes such that the plasma regions 106 are used to polymerise the monomers.

Active chemical or physical species exiting the plasma impact the substrate 1 before these species, which are generated in the plasma, are deactivated by collisions, thereby generating chemical and/or physical changes to the workpiece without exposure of the workpiece to the electrical field between the electrodes.

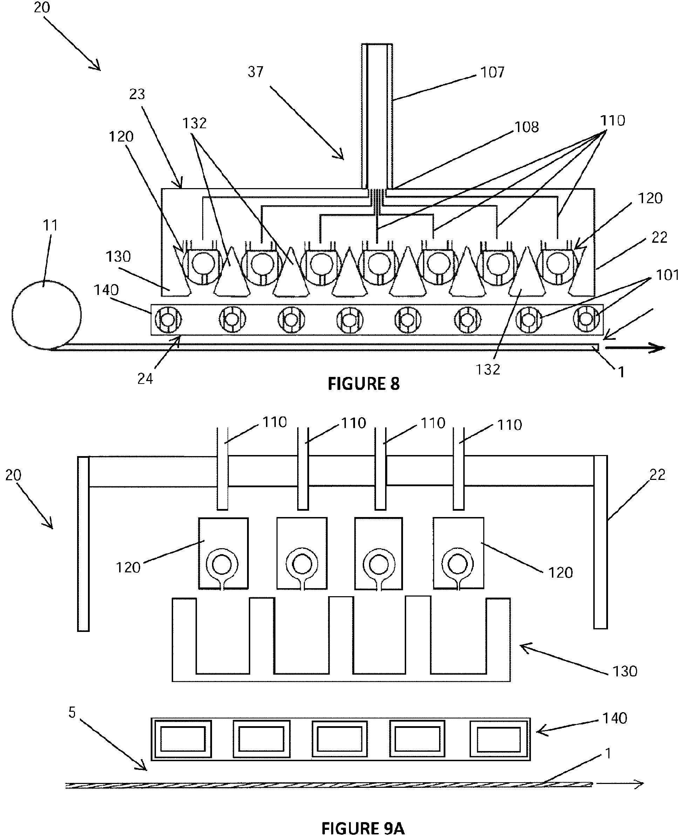

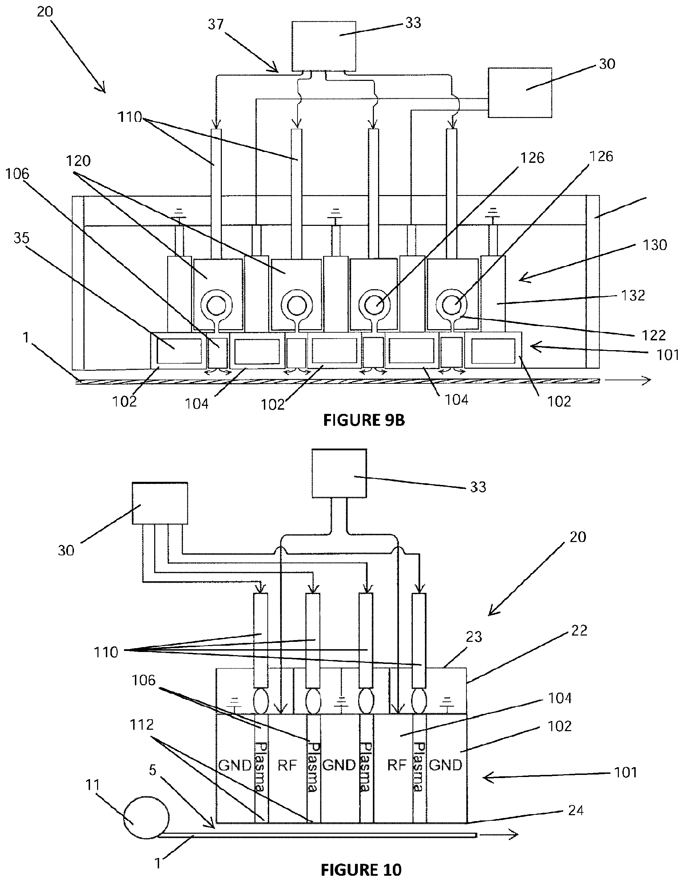

Electrodes may be alternating RF powered and grounded parallel opposing planar electrodes (see Figures 9 and 10 for example). The electrodes 101 can be supplied with a delivery gas or other gas from the manifold, and the gas is directed into gas inlet tubes and subsequently into gas distribution channels. In this embodiment, the plasma regions are oriented perpendicular to the substrate 1 to be processed. Preferably, at least a portion of the substrate 1 is disposed near to the excited delivery gases exiting the discharge region of the electrodes. Preferably, the substrate 1 is within 0mm to 10mm away from the proximal end 24 of the module 20 during processing such activated monomers or excited gases can be deposited on a substrate 1 or interact with a substrate 1 more quickly and therefore production times may also be improved. In addition, as the substrate 1 is relatively near to the exit for the excited gases excited species impinge unimpeded on the substrate 1 more readily. RF electrodes 104 can be powered by a power source 30, which may include impedance matching circuitry, and grounded electrodes also being perpendicular to the substrate 1. In this way the electrodes are parallel which can improve the quality of the plasma regions 106 generated.

As will also be described in more detail hereinbelow, a chosen number of plasma regions 106 may be included in a treatment module 20. The plasma regions 106 either being identical or differing in gas composition, flow rate or applied RF power density (with appropriate RF power matching, as needed, because of different discharge impedances) determined by their desired function. It will be appreciated that the treatment modules 20 may have a number of gases delivered thereto via the fluid delivery system 37. Each gas may be a delivery gas which carries a vaporised fluid, such as a monomer to the plasma regions 106 to be polymerised. Alternatively, gases for the plasma region are delivered to the electrodes 101 to treat or sterilise a surface of a substrate 1 without polymerisation of a monomer.

In yet another embodiment, the module 20 has a number of modular gas injection blocks which deliver gas to between an RF electrode 104 and a ground electrode 102. Gas injection blocks have outlets 112 fed by fluid inlets 107 for delivery of the delivery gas to plasma regions 106. Optionally, the electrodes 101 can be held in parallel by stanchions 132 such that movement of the electrodes 101 is reduced or, more preferably, eliminated. The electrodes 101 can be cooled by a cooling system 35. Other methods for cooling the electrodes 101 may be used which are common in the art. A portion of the module 20 may be formed form a thermoplastic material or other non-conductive material.

Electrode lengths, widths, gap spacings, and the number of electrodes are chosen depending on the substrate 1 to be treated. An example of a system 10 adapted for industrial-scale textile fabric treatment may comprise electrodes with a spacing of between 1mm to 4mm, and at least two plasma regions 106. However, other modules may have typical electrode spacings formed between alternating RF powered grounded parallel opposing planar electrode surfaces may be between about 0.2 mm and approximately 10 mm, more typically between about 1mm and about 5mm. Electrodes 101 may be fabricated with a hollow structure, round, ovoid, square or rectangular stainless steel, aluminium, copper, or brass tubing, or other metallic conductors. The hollow structure of the electrodes 101 may allow for cooling of the electrodes 101, by pumping a coolant through the hollow structure of the electrodes 101. Preferably, the electrodes 101 are shaped to minimise the potential for arcing or other edge effects when in use, and therefore any edges of electrodes 101 may be curved 128 or otherwise chamfered 128.

In one embodiment, the electrodes 101 may be formed with a width of between 1cm to 3cm and a height between 1cm to 3cm, or a diameter between 1cm to 4.5cm. The cross-section of the electrodes is preferably uniform along the length of the electrode 101 such that a relatively more uniform plasma field can be generated. It will be appreciated that in other embodiments, portions of the electrodes 101 may have a different diameter, cross-sectional area or cross-section such that differing effects or strengths may be imparted to a plasma region 106.

The module 20 may reduce the RF power consumed by reducing the cross-sectional area of the electrode 101. Having a smaller cross-sectional area may also generate a smaller plasma volume or a less dense plasma region. These may be advantageous as modules may be fabricated as more compact systems and the distance between the distal end 23 and the proximal end 24 of the module 20 can be minimised.

Fewer electrodes 101 may be used in a module to generate fewer plasma regions or weaker plasma densities while also maintaining a constant total delivery gas flow. Further, reducing the distance between the plasma discharge and the substrate 1 may also reduce the overall energy requirements. Reducing the distance between the substrate 1 and the plasma discharge may allow for a more compact system to process a substrate, or may allow for more modules 20 to be installed in the system without a reduction of size of the system. Including more modules 20 in the system 10 may increase the overall processing length of the system 10 which may allow for additional treatment times while maintaining a desired processing speed.

The plasma region 106 generated by a plasma module 20 may be an atmospheric pressure plasma. Electrodes 101 for generation of the plasma region 106 may be coated with a dielectric film to prevent formation of an arc that would otherwise form between the electrodes 101. This may be referred to as a Dielectric Barrier Discharge (DBD). By accumulating charge on the surface of the dielectric as an arc forms, the build-up of charge acts to quench a potential arc, which typically reforms elsewhere on the electrode. In some situations, a high gas fraction (for example >50%) of helium is added to the process gas to help homogenize the discharge. DBDs have the advantage of having a large gap between the electrodes which may assist with reduction of power consumption. However, since electrical power must be transmitted through the dielectric cover, the power density that a DBD discharge can achieve is limited by the dielectric cover. While low power density can produce slower processing, the present system 10 may use of multiple modules 20 and control electrode 101 spacing to negate this known problem. Further, the thickness of the dielectric coatings on the electrodes may also be minimised to reduce other adverse effects of DBD systems. Optionally, the DBDs may be pulsed on and off to allow for heat dissipation as DBDs may have undesirably high temperatures during prolonged plasma operation. Other methods to cool the electrodes101 may also include coolant systems in which coolant is pumped through the core 101A of an electrode, or heat sinks may be used to rapidly transfer thermal energy from the plasma regions. Optionally, the electrode is made from a heat sink material.

DBD may be non-thermal discharges generated by the application of high voltages across small gaps wherein a non-conducting coating prevents the transition of the plasma discharge into an arc. It will be appreciated that this is not the same as a corona discharge. DBD may have particular utility in web treatment of fabrics or other similar substrates. The application of the discharge to synthetic fabrics and plastics functionalizes the surface and allows for paints, glues and similar materials to adhere. The dielectric barrier discharge is a low temperature atmospheric pressure plasma. Using DBD may allow for fewer cooling requirements and may extend functional life of a module 20 or components thereof before requiring replacement. The DBD configuration may also be used for generating low temperature plasma jets which may have utility for processing metallic substrates. Plasma jets may be produced by fast propagating guided ionisation waves known as plasma bullets.

A further atmospheric plasma may be a capacitive discharge. Capacitive discharges may be established by use of an RF power to a powered electrode 101, such as an RF electrode 104, with a ground electrode 102 held at a close proximity, such as in the range of 1mm to 15mm. These discharges may be stabilised by the use of noble gases or other relatively inert gases.

Another type of plasma module 20 may utilise corona discharges for surface treatment and activation. In these discharges, a high electric field is generated in the vicinity of a wire or other electrode having sharply pointed edges. If the electric field is sufficient to remove electrons from neutral gas species, then there will be ionization localised around the wire or said edges. Such plasmas are typically used for surface modification reactions, such as plastic food wrap. These particular modules 20 may find particular use for treatment of dry (moisture content <3%), non-conductive substrates 1. Commonly, corona discharges may be used for the generation of ozone and particle precipitators.

Yet another plasma module 20 may use an arc discharge which functions with a high thermal discharge of around 10,000 K. Arc discharges may be used for vaporisation of a fluid or may be used to treat metal substrates.

Plasma treatment modules 20 may prime a substrate 1 for better acceptance of secondary manufacturing applications. Plasma can be used as a reactive treatment process where positive and negative ions, electrons, and radicals react and collide as long as an electric potential difference exists. Plasma treatment of a substrate 1 may microscopically alter the surface to allow for improved bonding, a cleaning of the surface which may enhance the surface wetting of adhesives or over-moulded elastomers, functionalise groups (such as carbonyl and hydroxyl groups) which may improve surface energy, and may establish hydrophobic and hydrophilic properties.

### Other System Modules

Additional modules 20 which may be used with the system 10 according to claim 1 are described below. It will be appreciated that any combination of modules may be used with a system 10, and the system may allow for modules 20 to be swapped or changed to allow for a desired substrate 1 processing. Other modules 20 may also utilise fluid inlets, power sources, controllers, electronics, or other means which may be used with plasma modules 20. In at least one embodiment of the system, the system does not use a plasma module and other treatment modules are disposed throughout the system 10.

A coating module 20 may be a module with a fluid applicator which can partially cover, cover or coat a substrate 1 region. Fluids may be a chemical coating, a wetting coating, or another fluid coating, and is preferably a liquid coating. The fluids applied may provide for a physical property or may provide for a functional coating. Functional coatings can provide a number of properties such as abrasion resistance, antimicrobial, antistatic, hydrophobic, hydrophilic, washable, flame-resistant coatings, reflective coatings, absorbing coatings, colourisation coatings, reactive coatings or any other desired functional coating. Heating modules 20 may be used to heat treat coatings applied to a substrate 1. It will be appreciated that heating elements may also be provided in the coating module and act as both a fluid applicator and heat treatment module.

The coating module 20 comprises a module housing 22 which houses a fluid delivery means and an outlet 112. The fluid delivery means may be supplied a fluid from a fluid inlet which is in fluid communication with a fluid source 33. A power source 30 may be used to activate the spraying devices of the coating module. Spraying devices may use a propellant or pressurised gas to allow distribution of fluids from the coating module 20 to the substrate 1.

In another embodiment, the coating provided may be a ceramic coating. Ceramic coatings may provide for abrasion resistant coatings or thermal coatings. Conductive and insulative properties may also be imparted to a substrate 1 by the use of ceramic coatings. For example, carbon coatings may allow for conductive properties or insulative properties depending on the carbon structure.

As discussed above, another module 20 may be a heat treatment module 20 which can be used to bake, heat treat or seal a substrate 1. The heat treatment module 20 may include heat lamps or heating elements which can achieve a desired temperature. Temperatures may be used to melt films or set coatings or films on a substrate 1. Films may be heat sensitive and shrink or expand with the application of heat or close proximity of a high temperature. Heat treatment modules 20 may use heat lamps, UV lights, e-beam, UV-beam, fire, heating devices, heated gases or any other desired heating element to achieve a desired temperature. Thermal sensors may be provided near to the heating module 20 or as part of the heat treatment module 20 to sense temperature and be used to regulate temperature of the heat treatment module 20. heat treatment modules 20 may provide a constant heat or temperature to a portion of a substrate. Alternatively, the heat treatment module 20 may pulse or vary temperatures emitted such that a range of temperatures are experienced by a portion of a substrate 1 during processing. In another embodiment, the heat lamps or heating devices in the heat treatment module may be arranged such that a heat gradient is provided by the heating elements. For example, a series of five heating elements may be provided in a heat treatment module 20 with each heating element being of a varying temperature, but are preferably arranged with the coolest element positioned at one end and the hottest element disposed at the opposite end. In this way heat may be ramped up for treating a portion of a substrate 1.

Other heating element arrangements may also be used to allow for a desired heat treatment process. As modules 20 may be adapted to be connected or mounted in series 25, heating modules may have heating elements arranged in a "sawtooth" arrangement. A sawtooth arrangement may be where a coolest element is arranged at a first end of a first module 20A, and a hottest element arranged at a second end of the first module 20A, with the second end of the first module 20A being adjacent to a further module 20B in which a similar arrangement is present. In this way the hottest element from the first module 20A is arranged adjacent to the coolest element of a second module 20B. Any other array of heating elements may also be provided for use with the heating modules 20.

Heat treatment module preferably comprises a housing 22 which houses at least one heating element. The heating elements of the module 20 receive power from a power supply 30 which can be used to charge the heating element to a desired temperature. A controller may be coupled with the heat treatment module 20 and/or the power supply 30 to control the power delivered to the module 20, and control the temperature of the heating element. At least one sensor may be used to monitor temperature proximal the heating elements and/or the temperature of the heating element. Optionally, the module 20 may comprise a plurality of heating elements.

A shield or other heat blocking device may be used to focus heat to a desired location and prevent heat from radiating to adjacent modules or equipment. The shielding may be formed as part of the housing and extend in the proximal direction towards the substrate 1.

A power source 30 may be used to activate the heating elements of the heating module. It will be appreciated that a heating module may not be fitted with a fluid delivery system 37 as fluids may not be required to be delivered via the module 20.

A film applicator module 20 may also be part of the system 10 and used to apply a coating or film to a substrate 1. The film may be a functional film, such as a hydrophilic film or hydrophobic film, or the film may be an aesthetic coating such as a decal or other predetermined film. Films may have a functional property, such as a UV reactive property, a reflective property, luminescent coating property, a water resistant property, a waterproof property, or another functional or visual property. Films applied to a substrate 1 may be fixed with an adhesive or subsequent treatment process from another module. Films may be pressed or applied to the substrate 1 via physical means or by pressurised gases urging the film to a substrate 1. Films may also be cured by a module of the system 10, which may involve a plasma treatment, a heat treatment, or a chemical treatment. Films may or may not be applied to one or two surfaces of a substrate 1, and may be fixed only on a portion of the surface. Films may also be heat treated, radiation treated, dyed, or otherwise processed by another module to impart a desired property to the film. For example, films may be heat shrinkable, textured, conductive or mouldable. Bonds between films and substrates 1 may also be improved by plasma modules 20 which clean or activate the surface of the substrate 1 prior to application of a film. Plasma modules may also be used to "breakdown" or alter a functional treatment which has previously been applied to a substrate 1. Altering or breaking down a functional coating in this way may allow for improved bonding of films or further coatings onto a substrate 1. Conductive films also have utility when being used for conducting electricity or for thermal conduction. Thermal films can be used as heat sinks or to transfer heat on the substrate.

The film applicator module 20 may have at least one roller and a film mount (not shown). The film mount may be used to support a roll of film or other sheet which may be applied to a substrate 1. The roller may be used to guide the film from the roll through the module 20. It is preferred that a film is applied to a substrate 1 and the substrate moving through the system 10 will pull the film at the same rate of speed. As such, the film module 20 may be free of motors or actuators to effect deposition of the film. Alternatively, the film applicator module 20 may have actuators to realign the film being deposited, or may have a motor to lead the first portion of film from the roll to the substrate 1. A paddle or other abutment means may be provided at the proximal end of the module which may be used to straighten and/or press the film to the substrate 1. One end of the paddle may be attached to the module 20, and a free end may project towards the substrate 1 upper surface (surface to be treated 2). In one embodiment, the free end of the paddle may be positioned at generally the same height as the substrate surface to be treated such that the film may be adequately pressed to the substrate 1.

The film module 20 may also be used to screen print, or laser print on a substrate 1 and may also function as a printing module (see below). Any predetermined printing method may also be used by the system 10 to impart a desired image, shape or deposition to a substrate. Multiple layers of film and/or printing may be applied to a substrate 1 by a film module 20, or multiple film modules 20.

Optionally, a ceramic coating or enamel coating can be applied by the film module 20 to a substrate 1. Any such coating may be applied such that air bubbles are removed during application and contact between the film and the substrate 1 is optimised. Films applied may be sacrificial films which are removed during processing or when the substrate 1 is to be in use. For example, a sacrificial coating may be a coating for a medial substrate.

A printing module 20 may be a module adapted to transfer a pattern or image to a substrate. The image or pattern transferred to a substrate 1 may be for aesthetics, or may have a functional property, such as a tactile feel or the printed material has a functional property. Printing modules 20 may have a reservoir for a deposition element such that a desired shape, pattern or feature may be printed onto a substrate 1. The deposition element may have a series of moving heads which can print transversely to the direction of the substrate moving through the system. Alternatively, an array of deposition heads are provided at the proximal end of the module which can be activated in any predetermined configuration to print or apply an ink or other printable fluid or material to the substrate. The heads of the printing module 20may be static or move along a guided track to allow for printing to be achieved.

Dyeing modules 20 may be used to apply a coating or deposition of a dye or pigment to a substrate 1. The dye or pigment may be applied in a powdered form and a reactant fluid applied to the powder. The powder and reactant fluid may be treated or polymerised by a further module. Dyeing modules 20 may be ahead of a further treatment module for setting the dye and/or the reactant fluid of the dye and the untreated dye may require a soaking time before treating the dye. In another embodiment, the dye may be applied in fluid form which can be sprayed onto the substrate. Application of a dye may be only on one side of a substrate 1 only. In yet a further, embodiment, the dye module may be a bath or other conventional dying machine or system.

Dyeing modules may have a fluid inlet 107 which can allow for delivery of fluids to a chamber 116 of the module. Alternatively, the fluid inlet 107 is connected to a manifold 108 which distributes the fluids to a predetermined number of outlets 112. At any desired time, the outlets 112 may be closed to stop the application of a dye or pigment to a substrate 1. Similar to other modules which receive fluids, a fluid reservoir may be mounted to the module for delivery of fluids to the module.

Preferably, the system is adapted to record the volume of fluids used by a module 20 and can determine remaining fluids within a fluid supply or fluid reservoir. Sensors may also be provided at inlets and outlets to verify the volume of fluids being consumed. Optionally, fluid reservoirs may also have a sensor at the outlet which connects to the fluid inlet of the module 20. Another treatment module 20 may utilise radiation treatments such as UV radiation, microwaves, electromagnetic radiation, gamma radiation or X-ray which may be used to activate a surface, clean a surface or impart a desired property. It will be appreciated that any predetermined radiation type can be used with the system 10. Radiation modules may have at least one radiation source installed therein, such as a lamp or radiation pellet. Other conventional radiation treatment sources may also be employed by a radiation module 20. Radiation shielding may also be used to reduce potential radiation exposure to nearby persons or prevent or reduce the potential for radiation to contaminate adjacent components of the system 10.

Radiation modules 20 may be utilised for ionization which may be of particular use for processing paper substrates or substrates which are required to be sterile or for medial use. Radiation may also be used to activate or excite particular substrates 1 such that a desired effect is established, such as excitation of a particle to cause luminescence. The radiation module 20 may also use electromagnetic wavelengths which may interact with the substrate 1. For example, phosphorescent substrates may be excited by heat or light interactions for a short period of time which may have utility for further processing steps or short term uses.

While all modules 20 are preferably provided with a module housing, the housing may be optionally removed and the internal components of the module may still be adapted to function and/or remain in a predetermined configuration.

Modules 20 may also be used to activate surfaces of a substrate 1 and/or deposit monomers onto a substrate 1. This may be achieved by a plasma module 20 which can be used to generate a plasma region 106. The plasma region may optionally be a plasma field in which magnetic fields influence the plasma. In at least one embodiment it is preferred that the plasma region 106 is an atmospheric-pressure plasma glow (APG). Plasma glows may be generated by DC power or low frequency RF (<100kHz) electric field between two electrodes 101. Other plasma treatments may be achieved by the plasma module 20, such as plasma corona treatments or plasma torch treatments.

Modification processes may also be used by the system in which a substrate 1 can be etched, cut, punctured, deformed or otherwise physically altered by a treatment head. The physical alteration may be desired before or after treatment or processing of a substrate. Functional properties may also be imparted to the substrate, such as a tactile property which may improve a tactile sensation or gripability. Physical alterations of a substrate 1 may be achieved by kinetic processes, heat treatments, or chemical treatments. Chemical treatments may be used to form a desired microstructure surface, or a desired surface property. A visual property may also be imparted to a substrate 1 by physical alterations. Other treatment processes such as laser etching, sintering, laser cutting, laser surface treatments may be achieved by specialised modules 20. Lasers may be used to achieve at least one of the aforementioned processes.

A fluid may be delivered to a substrate 1 via a module 20 of the system 10. Each module 20 may be adapted to deliver a controlled discrete fluid to a substrate 1. Any number of fluids may be provided by a module 20 or array of modules to a substrate 1. Fluids may include chemicals, gases or plasma, for example. Other fluids may also include dyes which may be hardened, polymerised, or set using heat or plasma fields. It will be appreciated that the dye may be applied by a first module 20A and a second module 20B may be used to set, harden or polymerise the dye. Altematively, the dye may be applied and set, hardened, or otherwise polymerised by the same module 20.

The system 10 may comprise any number of modules 20 which may be used to treat or process a substrate 1. Each module 20 may have a specific function, a unique function, or all modules may have the same function. Some modules may be adapted to alternate functions or perform selected functions at desired intervals. It will be appreciated that any mix or combination of modules 20 may be used with the system 10. Each module 20 may be selectively activated or deactivated for processing a substrate 1. Processing a substrate 1 may include any desired treatment or processing methods. Modules 20 may be selectively activated or deactivated after predetermined lengths of substrate 1 have been treated. This may allow substrates 1 to be cut at the end of processing and multiple different substrates may be continuously treated by the system 10 in this way. Optionally, the substrate 1 may be a homogenous substrate 1 and treatments may be altered at desired intervals or lengths of the substrate 1 such that multiple processed substrates may be manufactured by the system 10. Substrates may be separated or cut at a finishing region at the end of the system 10. The end of the system 10 may be any stage of the system where processing is finished or the substrate 1 proceeds to a finishing location.

The substrate 1 may be provided into the system by conventional conveying means which can transport the substrate 1 from a first location 11, through the system 10 and to a final location 11' where the substrate 1 has been processed/treated. It will be appreciated that a substrate 1 which is to pass through the system 10 may be referred to as a "pre-processed substrate" (11) and a substrate 1 which has passed through the system is a "processed substrate" (11'). The term "pre-processed substrate" (11') may also include substrates 1 which have been processed previously, but said substrate is to be again processed by the system 10. It will be appreciated that the term "processed" may be interchangeably used with the term "treated".

A user terminal 9 may be used to activate, deactivate or otherwise interact with the system 10. The user terminal 9 may be installed with predetermined system functions which may be executed to activate and operate the system 10. A user interface may be provided on the user terminal 9 which may allow input of substrate and the desired treatment processes therefor, such as substrate grade, substrate thickness, substrate desired treatments, or any other predetermined inputs. The system 10 may be adapted to provide error messages to a user if the system 10 is attempting to treat a substrate with processing treatments which may cause damage to at least one of the; system 10, substrate 1 or modules 20. For example, if a substrate 1 has a low melting point heat treatments of the system 10 may not be suitable and therefore an error message may be provided which may indicate the issue with selections. Based on the inputs to the user terminal 9, a controller associated with the user terminal may actuate portions of the system 10 and prepare suitable modules for treatment processing. For example, if a substrate is to be heat treated, heating modules 20 (also referred to as "heat treatment modules") may be warmed up to a predetermined temperature before processing can begin, and the relative locations of the modules may be altered to allow for processing of a substrate 1. The user terminal may also have access to a data storage device which can record usage, store processing data, store processing functions, store executable programs or any other predetermined function.

In one embodiment, a use terminal 9 is fitted with predetermined inputs only, such that operators may only make limited inputs to allow the system 10 to adequately treat a substrate 1. Each usage of the system 10 may be logged and each module 20 may have an internal counter or other measurement means to determine the volume or length of substrates which have been treated. In this way it can be verified whether systems are being used outside of prearranged treatment schedules or whether additional treatment processes are being undertaken without knowledge of the owner of the system. Any data stored with the system may be hashed or otherwise encrypted such that tampering with data records by users of the system 10 cannot be easily achieved. Time stamps and or processing stamps may be imprinted or market on substrates treated at the tail end of the substrate 1. The tail end of the substrate 1 may be the last portion of the substrate 1 which is to be treated. Time stamps may comprise information including, but not limited to, a time, a date, a location, a machine identification number, a region of manufacture, local temperatures or any other desired data set. Processing stamps may include codes or identifiers which denote the treatment processes which have been applied to a substrate. Optionally, if there are any errors in treatments, such as a fluid has spattered or been applied in a manner which is not desired, the region of the substrate with inferior treatments may also be denoted, which may assist with visual inspection of treated substrates. It will be appreciated that the substrate 1 length may be pre-determined, but also may be calculated by the system 10 during processing to allow for a matching of lengths.

Data from the system 10 may be uploaded to a server, a storage device or network. Data can also be communicated to a further device or remote server. The further device may be a monitoring system which may monitor a plurality of systems 10 and may notify users of potential machinery errors or other system 10 errors. This may be beneficial as systems 10 can be monitored remotely and repairs or maintenance of systems 10 can be more effectively delegated. The system may be connected to the Internet continuously, or at intervals to allow for third party monitoring, or third party actuation of the system 10. If the system 10 does not connect to the Internet and receive a confirmation signature from a third party device in a predetermined time period, the system 10 may be adapted to cease processing of a substrate 1 until such a signature is received. In this way the signature may allow for a predetermined usage period of the system 10 before being shut down. Optionally, a signature is a hash which is confirmed by the system 10 and a predetermined processing time can be used for the system. Optionally, signatures may be required for specific treatments, such as radiation treatments which may require regulation of radioactive components of the system.

The usage data and efficiency data for each module 20 of the system 10 may be recorded and accessed in real time. These data sets may be transmitted to a server associated with the system and accessed remotely. If a module efficiency or usage is outside of predetermined thresholds, the system may require maintenance or manual inspection for the system to continue processing treatments. In at least one embodiment, the system 10 can be remotely shut down by a third party.

### Illustrated Embodiments

Referring Figure 1 there is shown a schematic diagram of an embodiment of a roll-to-roll treatment system 10. Figure 1 may more particularly be a plasma deposition system 10. The system 10 preferably comprises at least one plasma module 20 and a series of rollers for guiding and moving a substrate 1. Optionally, adjacent to the system 10 are sterile chambers or protective chambers (not shown) which may be used to house rolls of substrates to control moisture content prior to processing. Other chambers may also be used, such as drying chambers which can be used to lower the moisture content of substrates prior to processing. The protective chambers may be a first protective chamber and a second protective chamber may be used for unwinding and winding up of the substrate 1 and may also be used to wrap or apply a protective storage cover to a roll of substrate 1. Protective covers or wraps may be polymer bags for example or another barrier which can keep external the bag or barrier moisture from interacting with the substrate 1. These chambers may be known in the art and standard protective chambers may be used. The processing portion of the system 10 is preferably not within a chamber and is in open atmosphere or in a room. The room for processing may be suitable for operators to enter without breathing equipment or other safety equipment.

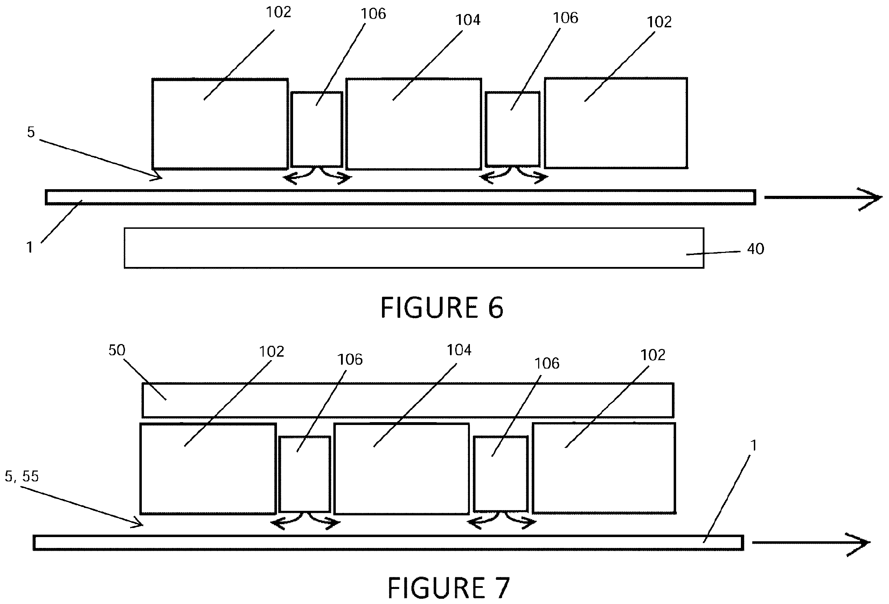

An array of modules 20 are arranged throughout the system 10 and a series of rollers 12 are arranged with respect to the module 20 arrangement. A frame may be used to support the modules 20 and roller 12 of the system 10. Optionally, the frame has a housing or shield which can be used to cover at least one of the modules 20, substrate 1 being processed and the rollers 12 such that persons working near to the system 10 cannot injure themselves. The modules 20 may be referred to as "shower heads" which can be used to deliver a fluid to a substrate 1 and preferably provide a plasma treatment to the substrate 1. Unlike conventional systems, the electrodes 101 are disposed horizontally such that gases can be affected by gravity, atmosphere and ambient conditions. Further, fluid collection means 40 (see Figure 6 for example) may be disposed below the substrate to collect excess fluids from the module 20.

The size of the rollers 12 may depend on the size of the modules 20 of the system 10. The rollers may also act as tensioners to maintain a desired tautness or tension of the substrate 1. Each module 20 of the system 10 may be of a uniform size such that modules 20 can be disposed at any location in the system 10. This may be of particular benefit for continuous processing systems 10 as there may be required to be waiting times between treatment processes or application of fluids to a substrate. A substrate 1 may be guided from a roll by load cells, or other suitable movement means, to the rollers 12 and to the processing area. The processing area may be any portion of the system 10 which can treat a substrate 1 or apply a fluid to a substrate 1.

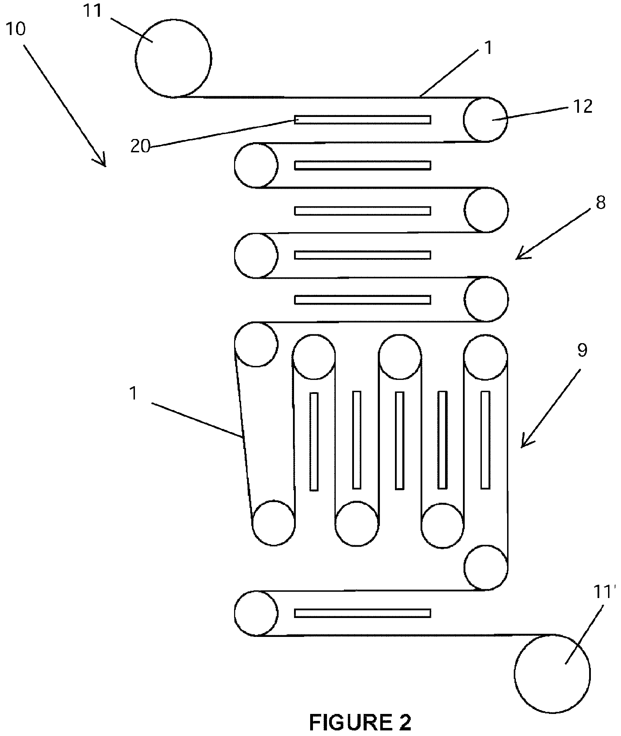

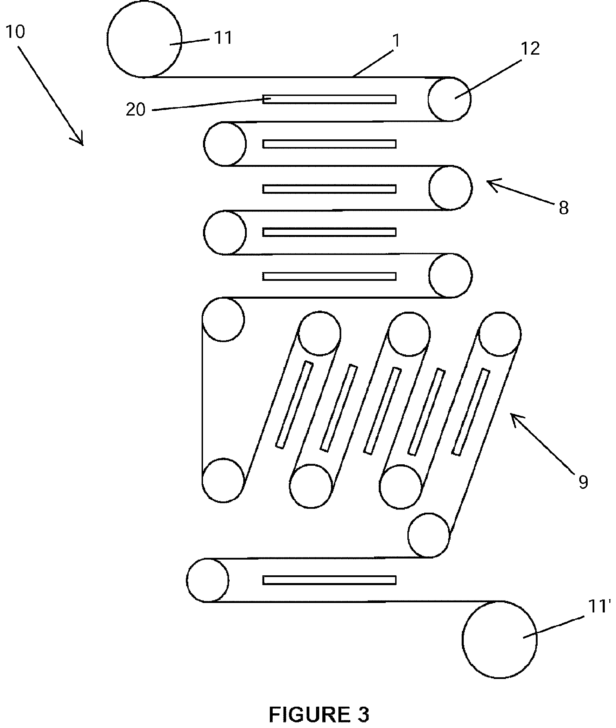

In the most basic arrangement, a plasma module 20 comprises a radiofrequency (RF) electrode 104 and a ground electrode 102 arranged in a parallel relationship. It will be appreciated that the electrodes of the system may be arranged such that ground electrodes and RF electrodes 104 are disposed in an alternating array. The array of modules 20 may be preferably arranged in a vertical stack with the modules 20 being generally horizontal relative to the ground as shown in Figure 1. Each module 20 in the vertical stack is preferably parallel, however portions of the stack may be modified to have a plurality of modules which are not horizontal (see for example, Figures 2 and 3 in which several electrodes are arranged such that they vertical in arrangement (Figure 2), or are disposed at an angle between 90 degrees and 0 degrees (Figure 3)).

Spaces between the modules 20 can be used to pass a substrate 1 to be treated by a respective module 20. Treatments may be any predetermined or desired treatments as described herein, or undergo treatments which are known in the art.

The rollers 12 of the system are arranged to guide a sheet or substrate 1 from a pre-processed roll 11 to a processed roll 11'. It will be appreciated that the pre-processed roll 11 may have been processed or treated previously, but is to be processed by the system 10, and is pre-processed with regards to the upcoming processing only.

In use, an electromagnetic field can be applied a plasma region 106 struck between the radiofrequency electrode 104 and the ground electrode 102. A monomer can also be provided to the plasma field struck between the electrodes 101 and the monomer may be polymerised to coat or generally be deposited on the substrate 1. The coating or deposition of the monomer may be only on the side of the substrate 1 directly facing the module 20 at the time of treatment, such as to only coat a single surface of said substrate 1. A primary plasma can be struck between a RF electrode 104 and a ground electrode 102. This may be beneficial for selectively coating portions of a substrate 1. For example, if a monomer is being deposited and polymerised on the first side of the substrate, the monomer may not be able to reach the second side of the substrate, and therefore the second side of the substrate 1 will not receive a polymer layer thereon. Other treatment processes may be more effective at processing both sides of the substrate, such as passing the substrate 1 through (or near) a plasma filed or plasma region such that both sides of the substrate 1 are treated. In some embodiments, modules 20 may be disposed on either side of the substrate 1 such that the substrate1 receives two or more treatments simultaneously such that the first side and the second side of the substrate 1 are treated. It will be appreciated that the first and second sides of the substrate 1 need not receive the same treatment process.

Portions of the system 10 may have modules 20 disposed on either side of the substrate 1 such that plasma generated can activate each substrate 1 side for certain processes. More homogeneous or uniform treatments may provide superior substrate 1 properties, such as water or oil repellency properties as more uniform structures 1 are less likely to have irregularities or other disadvantageous effects.

In some embodiments, the system may utilise electrode arrangements 101 which are mirrored, such that ground electrodes 102 are adjacently disposed (ground-ground) or RF electrodes 104 are adjacently disposed (RF-RF). In this way plasma regions are not generated between like electrodes 101.

By increasing the number of electrode layers in a module 20 it is possible to increase the speed within which the substrate 1 passes through the system 10 without compromising quality of treatment processes. In another embodiment, increasing the number of modules 20 of a system may also increase the speed in which the substrate 1 can move through the system to complete a desired treatment or treatments. It will be appreciated that the speed of the substrate 1 through the system 10 may also be increased by ejecting a larger volume of monomer or treatment fluid from a module. Larger volumes of monomers can be ejected and directed towards a substrate 1 in atmospheric conditions relative to within a chamber with a low pressure or vacuum. This is one advantage of the system as larger volumes of monomers may be directed towards a substrate 1 which can therefore increase the speed in which a fluid or monomer may be delivered and subsequently polymerised or treated. As such, the system 10 may provide for faster production of polymerised substrates using a plasma field. Further, monomers polymerised in a plasma field can be disposed in thinner layers with improved adhesion to a substrate 1 which is further advantageous over other deposition or treatment methods.

As behaviours of gases can be more easily predicted within atmosphere, the gases and monomers may be more easily directed towards a substrate 1 and polymerisation in atmospheric conditions may be more effective.

In one embodiment, if a plasma field is generated between a ground electrode, RF electrode and a further ground electrode the plasma region generated may not be considered to be a primary or secondary plasma field. The plasma field generated may be considered to be an extended plasma field and may be extended between alternating electrodes (ground or RF) at predetermined spacing. The strength of the plasma generated between these electrodes 101 may be varied by modifying the relative spacing between adjacent electrodes. It will be appreciated that if spacing between all electrodes is uniform the extended plasma region 106 generated will be uniform in strength. Further, it will be appreciated that the spacing of the electrodes 101 may dictate whether polymerisation can be effected. Greater spacing may reduce the potential for polymerisation but also reduce the potential for damage of a substrate 1 or arcing between electrodes. The extended plasma field may also be of particular advantage as the strength of the plasma field may be such that introduced monomers may be polymerised, while reducing the potential for undesired reactive monomers to break down or be polymerised. This may also be of particular advantage with regards to existing treatment layers which have been deposited onto a substrate 1 which are not to be re-polymerised or otherwise be altered (undesirably) by the plasma field.

While the use of gases and plasma within non-chamber environments is desirable from a cost saving perspective, there are a number of known problems with regards to using plasma within open atmosphere conditions. For example, particles not within a delivery gas, treatment fluid, or particles not of a predetermined monomer may enter the plasma field and can be polymerised or vaporised by the plasma. This can lead to damage of the electrodes 101 or to damage of the substrate 1 or result in potentially hazardous fluids being produced due to reactions in the plasma field. As such, open plasma fields may be dangerous for use and produce high volumes of hazardous by-products. The system 10 may overcome this by ejecting a high volume of delivery gas, such as argon, which evacuates the local region 5 between the substrate 1 and the plasma field of local atmosphere which greatly reduces or eliminates the potential for undesired particles from being activated, polymerised or otherwise ionised in a plasma formed in the plasma region 106. It may be preferred that breathable or inert gases are used to evacuate a local region 5 of local atmospheric gases. Gases which may be suitable for such a purpose may include argon, oxygen, nitrogen, helium, neon, krypton, xenon, radon or any other predetermined gas. It is preferred that the gas used for local region 5 evacuation is also a delivery gas such that a desired plasma region can be produced, but the volume of evacuation gas may be such that the electrodes cannot consume all gas and a region of inert gas or other controlled gas may surround or substantially surround the plasma field and deny local atmospheric gases entry into the plasma region 106.

The stack of modules 20 having sufficient spacing to allow for a substrate 1 to pass between respective modules 20 as shown. The spacing between the modules and the substrate 1 may be any predetermined distance, but is preferably within the range of 2mm to 50mm. Other spacing may be used depending on processing treatments desired. It will be appreciated that each module 20 in the stack may have a predetermined spacing from the surface of a substrate 1. For example, a coating module 20 may require a distance of 50mm from a surface of a substrate 1 to reduce spattering while a plasma module 20 may be desirably 3mm from the surface of the substrate 1 to effectively treat the surface. The system 10 may be adapted to automatically detect module 20 functions and/or the substrate 1 thickness and space the modules 20 and/or the rollers 12 appropriately. As shown in Figure 1, all modules 20 are stacked vertically and the module lengths are generally horizontal. Having modules 20 disposed in this way may allow for treatments to be directed relatively downwardly, which may be beneficial in non-chambered environments as gravity may impact fluids exiting from a module. In addition, as the system 10 is preferably in open atmosphere, having module 20 outlets 112 directly downwardly may allow for easier collection of excess or non-consumed fluids to be controlled and collected. Having module outlets 112 facing upwardly may require more energy as fluids will be required to be propelled upwardly.

The plurality of rollers 12 shown in Figures 1 to 5 are exemplary only. Each roller 12 may be replaced with a pair of rollers 12 (not shown) which allows for easier vertical movements of portions of the module 20 stack of the system 10. Pairs of rollers 12 may be moved relative to each other vertically or horizontally depending on treatment processes. Other roller or support structures may also be used by the system 10.

Another schematic embodiment of a system 10 is illustrated in Figure 2. While similar to Figure 1, a portion of the stack of modules has been modified such that the modules 20 are disposed generally perpendicular to the ground or more generally are disposed vertically as is shown. This portion of a stack may be referred to as an angled stack portion, which may comprise modules 20 which are disposed at an angle which is not horizontal. These modules 20 may provide for specialised treatments or may be more effective arrangements for specific treatments. For example, heat treatment modules 20 may be used in this orientation to apply a coating or sterilant more effectively. As shown, the direction of the substrate 1 also conforms to follow the vertical modules (angled stack portion) for processing.

Yet another embodiment of a schematic is illustrated in Figure 3 in which a variant of the angled stack portion is shown where said portion comprises modules 20 angled between 0 to 90 degrees. The angled stack portion modules 20 may provide for a more effective desired treatment process for a substrate. While all modules 20 may be considered to be part of the stack, the sections of the stack may have any predetermined angling to allow for installation of a desired module or orientating a module for a desired treatment method. Deposition of fluids at an angle may also generate functional properties on the surface of a substrate. For example, a deposition method at an angle of 45 degrees may provide a more porous application of a deposition relative to that of a module which is generally disposed horizontally (around 0 degrees as is shown in the stack of Figure 1). Other functional properties may also be imparted to a substrate 1 depending on the angle of the modules 20.

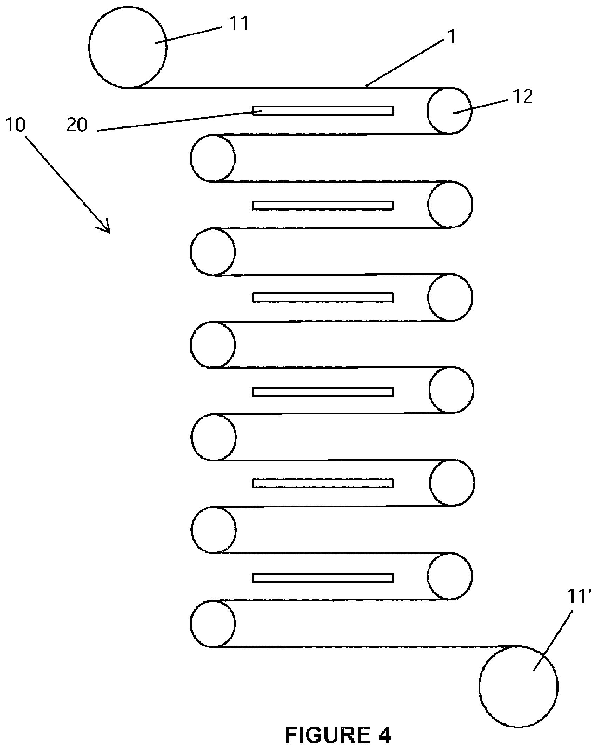

It can be seen that in Figures 1 to 3, the system 10 may be adapted to treat both sides (both surfaces) of a substrate 1; however it may be desirable to treat only one surface of a substrate 1. Referring to Figure 4, there is shown an embodiment of a single surface treatment system 10. In this embodiment the modules 20 are arranged such that the only one side of the substrate 1 will receive a treatment. This is achieved by providing modules 20 relatively above a single surface of the substrate 1 instead of both. It will be appreciated that a single surface coating or treatment may also be provided by the systems 10 of Figures 1 to 3 by selectively turning off pre-determined modules.

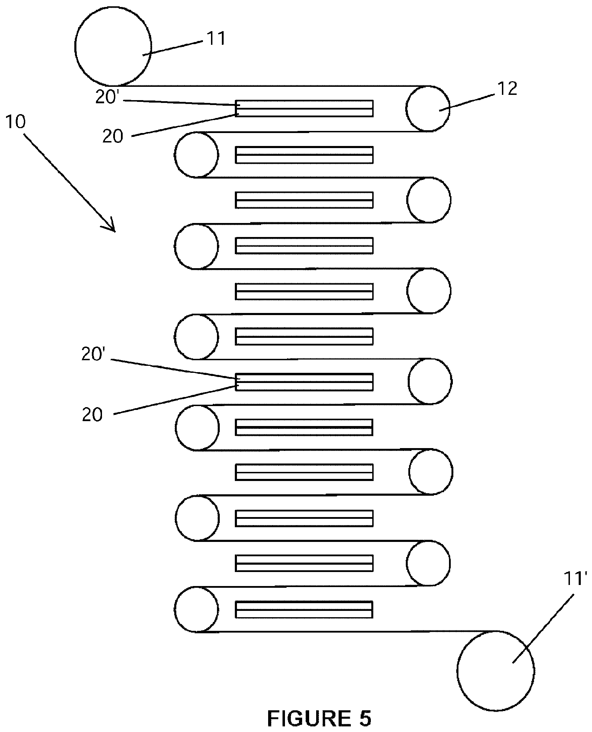

Referring to Figure 5 there is shown yet another schematic embodiment of a system 10. The system 10 is shown with twin modules with one module directed upwardly and another directed downwardly. The twin modules may allow for treatments in opposing directions and may allow faster coating of a substrate. The twin modules may be used for the same treatment process, or may be used for different treatment processes. For example, the upper module 20' may be used for pre-treatment and the lower module 20 may be used for applying a chemical treatment or coating. Any combination of modules 20 may be used if desired. Optionally, a twin module 20, 20' may have a single fluid inlet which can be used for delivery of a fluid via both the upper 20' and the lower 20 modules. Similar to Figures 2 and 3, a portion of the stack may be an angled stack portion in which the twin modules are disposed at an angle. Optionally, the twin modules each comprise a respective set of electrodes, however in other embodiments, the twin modules comprise respective sets of electrodes for the upper and lower modules. Optionally, at least one of the upper modules 20' may be fluid collection systems which allow for collection of treatment fluids.

While the illustrations in Figures 1 to 5 are generally shown as having discrete single modules 20, each of the modules 20 may be formed from a plurality of modules connected together, referred to as a module series 25. The module series 25 may be controlled individually or as a single homogeneous unit. In at least one embodiment, a module 20 may have a plurality of blocks 120 installed therein which can be used for individual treatment processes, and not just a single treatment process. Electrodes 101 may also form a portion of a module 20 if electrodes 101 are required, such as for a plasma module.

It is preferred that at least a portion of the processing line of the system 10 be operational without degassing or depressurisation. While atmosphere can be locally evacuated between a module 20 and the substrate 1 using a delivery gas, the pressure between the module 20 and the substrate 1 may be generally atmospheric or at a higher pressure than atmospheric. A delivery gas may be any fluid that can be used to carry a further fluid and/or be used as to form a plasma. It will also be appreciated that any reference to the term "delivery gas" may encompass "delivery fluid" which may include liquids, vapours, gases and plasmas. The system 10 disclosed herein therefore provides an advantage over the state of the art as degassing need not occur which can save substantial amounts of energy and time, and therefore improve the efficiency and operational costs of the system.

The module 20 is moved relatively to the substrate 1 such that the distance and/or angle of deposition or treatment can be modified. It is preferred that the distance between module and the substrate 1 to be coated or treated is minimised such that the monomer and/or sterilant gases or plasma field are closer to the substrate 1 after leaving the module. In this way ambient atmosphere can be more effectively removed from between the module outlets 112 and the textile which may remove potential impurities when the processing line is not within a sealed environment or is not in a vacuum or partial vacuum.

Delivery gases may be ejected from the module 20 at a known flow rate of between 0.1 litres per minute (LPM) to 20 litres per minute (LPM). The flow rate of the delivery gases may be dependent on the speed of the substrate 1 in the processing line, the desired residence time in a controlled gas and may also be dependent on the desired final thickness of a coating.

The system 10 may utilise radiation to remove static electricity from modules 20 prior to activation or may use radiation to clean components of the system 10, such as the rollers 12 and/or modules 20. Optionally, the system may be flushed by pressurised gases or pressurised liquids, or a combination thereof. Alternatively, chemical flushing may also be used which can chemically remove build-up of monomers or other residual processing materials in the system. Cleaning or sterilising may be performed during predetermined periods, or at predetermined intervals, such as when substrates are not being processed, or when modules are deactivated in relation to treatments. For example, cleaning may occur when the system has finished processing a substrate, or between processing steps. In this way the system may always be processing and/or being cleaned such that minimal downtime of the system 10 is achieved. Modules or components thereof may be removed from the system for cleaning and swapped for clean components to also reduce downtime of the system 10. The system 10 may be adapted to prevent shut-down until all modules are cleaned. It will be appreciated that typical emergency shut-down functions may be employed for use with the system 10.

The terms 'fabric', 'textile' or 'substrate' may include any materials that are non-woven as well as woven or knitted textiles, which may be manufactured into articles, such as articles of apparel for; application in daily use, industrial environments, personal protective equipment (PPE), sport and leisure environments and any other common use for fabrics or textiles. For simplicity, the terms 'fabric' and 'textile' may be referred to herein as "substrate". Substrates may include any planar material which may be processed. Optionally, in further embodiments the substrate 1 may be replaced with particulate materials or objects to be processed on a conveyor belt or similar transport apparatus, which may be of particular use in food processing or manufacture of medical devices.

Substrates 1 which may be used with the system may include ceramics, polymers, elastomers and metal assemblies are all good candidates for plasma treatments or other desired treatments. Plasma treatments may improve adherence properties therefore and reduce the volume of defective processed products (processed substrates) as plasma treatments may reduce the potential for insufficient bonding of paints (or pigments), inks, mouldings and other coatings.

The system 10 may be used to treat substrates 1 and/or coat substrates 1. Treatment processes may require the use of a plasma field and/or a treatment fluid. The treatment fluid may be a sterilant, such as ozone, hydrogen peroxide, ethylene oxide or any other sterilant gas. Other treatment fluids may also be used to provide a treatment such as argon to evacuate a local region 5 between the shower head and the substrate 1 to be treated, and other gases may include a vaporised fluid comprising a treatment chemical which may bond to the substrate 1 or may alter, at least temporarily, the surface properties of the substrate. Altering surface properties of a substrate 1 may allow for a subsequent treatment or deposition to be more effective or more efficient.

For example, a pre-treatment of a substrate 1 through a plasma field may require the use of a generally inert fluid or noble gas, such as argon, to evacuate the local region 5 between the shower head and the substrate 1 such that a plasma field can be used to activate or treat the substrate 1 without undesirable gases or materials entering the plasma zone while the substrate 1 is being treated. Evacuating the local region 5 may reduce the potential for polymerisation or undesirable surface modification of the substrate 1 from undesired reactants in the plasma field. Evacuation of gases and other potential contaminants in the local region 5 may be required as the processing line is preferably outside of a vacuum chamber or similar constrictive chamber.

It will be appreciated that if a substrate 1 comprises a monomer at the surface or near to the surface, the monomer may be polymerised by the plasma region. This may be of particular advantage with respect to thicker coatings which cannot be efficiently deposited by the flow rate of a module 20, or may be desirable if a monomer is applied in a predetermined array or pattern and can then be polymerised in the predetermined array or pattern. Other reasons for pre-coating a substrate 1 with a monomer will be readily understood by persons of skill in the art. The array or pattern applied to the substrate 1 may be achieved by sputtering, spattering, printing and/or any other desired method of deposition or application. While an array or pattern of a material doped with a monomer or entirely comprising monomers may be applied prior to the substrate 1 entering a plasma treatment area in the local region 5, the monomers may be adhered to the substrate 1 prior to plasma treatment and a superior bonding may be achieved by polymerisation of the monomer(s) by the plasma treatment. Optionally, the material in the array or pattern may comprise at least two monomer species which react in the plasma field and bond or react in a desired manner in said plasma field.

Materials deposited on the surface of a substrate 1 may melt and/or substantially coat at least one surface of the substrate 1 when in the plasma field. Optionally, the substrate 1 can be pre-coated with a reactant and the module 20 may be adapted to deliver a monomer or other desired species which reacts with the pre-coated reactant. In this way the pre-coated reactant may be used to bond with the substrate 1 (at the proximal side) and the distal side of the pre-coated reactant may be imparted with a desired functional property such as a hardened surface, a flexible surface, a protective layer, a tactile property, a hydrophilic property, a hydrophobic property, or a desired aesthetic.

The relative distance between the bottom of the electrodes and the substrate 1 may be increased or decreased if desired. The relative distance may be changed by moving a module 20 relative to the substrate 1 or moving the substrate 1 relative to the module. It is preferred that the module 20 be moved relative to the substrate 1 such that the substrate 1 has a level bed and coatings can be applied more easily. Further, as the substrate 1 may be passed over a collection bed which can be used to collect fluids from the module, it is desirable to have the substrate 1 in these embodiments near to the collection bed.

Relative movement between the module 20 and the substrate 1 is achieved by movement of at least one of the substrate 1 and the module 20. The system 10 may be adapted to modify the distance between a surface of the substrate 1 and the module automatically based on inputs received before processing. Inputs received may be pre-set by the system 10 based on at least one of; substrate 1 type, treatment processes, and substrate 1 thickness. It will be appreciated that the thickness of the substrate 1 will also change the relative distance between the substrate 1 surface and the module, and therefore to maintain a minimum distance or maximum distance the relative location of the module to the surface of the substrate 1 may be changed. Actuators may be used to adjust the heights or locations of the modules which may allow for modification of heights during processing such that processing does not need to stop.

Thicknesses of coatings or treatments may also be measured during processing and module heights may be adjusted dynamically based on a desired treatment thickness deposition or overall thickness of the substrate. There are a number of different methods which may be used by the system 10 to test the thickness or density of a coating or layer on the substrate. It is preferred that non-destructive means of measuring thicknesses and densities may be used by the system. For example, ultrasonic testing methods may be used, laser testing, x-ray fluorescent testing (XRF), magnetic testing, micro-resistance testing, duplex measurement testing, eddy current method testing, phase-sensitive testing, coulometry testing, beta-backscatter measuring, STEP testing methods, or any other desired non-destructive testing methods which can be used while the substrate 1 is being processed. Thickness testing may be taken at predetermined time intervals or predetermined length intervals such that a known length of substrate 1 can be tested. Incremental testing may also allow for identification and/or tagging of potentially defective regions of substrate 1 which can be removed after processing if necessary. Thickness testing apparatuses may be provided after a deposition module or treatment module which provides a measurable coating or treatment to a substrate 1. Optionally, thickness testing modules may be provided before and after a treatment module which can be used to record the thickness of a substrate 1 and compare before and after treatment thicknesses. This may allow for variations in the thickness of the substrate 1 to be ignored and an accurate thickness measurement of the deposition or coating to be obtained.

The collection bed may use a vacuum and/or fluid channel which allows for excess fluids to be collected and recycled, disposed of or reused. Filtration systems may be used to separate monomers from fluids which may then be reused or disposed of appropriately. Separation of fluids or treatment chemicals may be achieved by the system or may be removed from the system to be treated elsewhere. Optionally, liquids and gases may be separated into individual chambers for easier recycling, reuse or disposal.

As monomers, fluids and gases pass through a plasma region 106 they may be changed from known fluids/monomers to unknown fluids/monomers, it may be advantageous to collect samples of the post-delivery gas/monomers to be tested for safety. As such, collection beds may also be used to collect testing samples of the ionised fluids/monomers. Collection of samples may be achieved by a fluid collection system 40 which may capture unused or excess fluids from modules 20.

Fluid collection systems 40 may be positioned relatively underneath a substrate (See Figure 6) during processing and have a collection reservoir which may be used to collect fluids passing through the substrate (if the substrate is porous enough) or may be used to capture runoff fluids from the substrate or fluids which exit a module and are not deposited onto the surface of a substrate 1. A vacuum apparatus may be used to draw in unused fluids for collection and recycling. The vacuum may also be used to draw down a substrate and retain the substrate in a desired position.

In one embodiment the collection system comprises a reservoir with a mesh or permeable upper surface (not shown) which can be used to support a substrate 1. The mesh may allow fluids to pass through into the reservoir and be taken away from the processing area to be reused, recycled or disposed of. Gases or fluids not consumed during processing may be captured and recycled by the system. Gas extractors or drains may be used to collect excess fluids which can either be responsibly disposed of or recycled for use by the system 10 or may be collected for use elsewhere. As the system preferably uses a high purity of gases, monomers and chemicals, it may be advantageous to collect and separate impurities within a gas, monomer or chemical such that the gas, monomer or chemical can be reused within the system 10. In this way, waste products from the system 10 may be reduced or otherwise eliminated.

Optionally, filters may be used to assist with capture of fluids or filtration of fluids captured. For example, carbon filters or no-woven material filters may be used to capture fluids and retain potentially harmful fluids therein. Fluids from filters may be extracted at a later time if desired.

Gas extraction methods may include ventilation and fan systems which can be used to extract used plasma fluids and monomer from the system. The monomer and plasma fluids can be collected or redirected after leaving a module 20 if they are not bonded to a substrate 1.

Cooling systems may be used wherein the electrode can be cooled with liquid cooling. Suitable liquids may include plasma gases and inert gases. The utility of using plasma gases is that if there are electrode failures or faults and cooling fluids leak into the plasma region, the electrodes will lose cooling but coating quality will not degrade or contaminants will not be introduced into the system.

Referring now to Figures 6 to 15C there are provided embodiments of modules for use with the system and components therefor.

Figure 6 illustrates a schematic side view of a plurality of electrodes 101 which may be used to generate a plasma region 106. The electrodes 101 shown are a series of alternating electrodes 101 comprising ground electrodes 102 and radiofrequency (RF) electrodes 104. A plasma region 106 may be made between two electrodes (ground electrode 102, RF electrode 104) when RF electrode 104 is charged with the presence of a suitable delivery gas. As discussed above, the delivery gas may be an inert or non-reactive gas which can be charged and causes ionisation of the gas to generate the desired plasma region. The desired plasma region may have the following levels of ionisation; weak ionisation, partial ionisation or full ionisation of fluids in the plasma region. The extent to which ionisation occurs depends on the frequency and/or voltage applied to the electrodes and may also relate to operational temperatures. Different levels of ionisation may have different functionality for treatment processes and levels may be varied depending on the substrate 1 and desired treatments. As inert gases move from a charged state the molecules will return to their original inert state without reacting with other elements or compounds near to or within the plasma region. Some fluids supplied to the plasma region may generate degradable gases, such as ozone, which may be used to sterilise a substrate, and may degrade within a reasonably short time period to form breathable gases. Optionally, non-inert gases may also be used to treat or cause reactions at the surface of the substrate. Non-inert gases may have utility for cleaning and activation of the surface.

Plasma cleaning uses an ionised gas (such as the ionised delivery gas in the above mentioned embodiments) to remove organic matter or other contaminants from the surface of the substrate 1. It will be appreciated that the delivery gases used for cleaning processes may include, but are not limited to, at least one of oxygen, argon, nitrogen, hydrogen and helium. Based on the composition of the delivery gas, the sterilisation or cleaning processes may be used to modify the surface tension, modify the surface energy, modify contact angle properties, improve inter-surface bonding and/or adhesion, removal of oxides from the surface of a substrate, alter surface wettability to create hydrophobic or hydrophilic properties, or be used for coating processes such as those for imparting a property or improving a property such as; adhesion, wettability, corrosion and wear resistance, electrical conductivity and insulation, magnetic response, reflective/anti-reflective, antimicrobial, anti-scratch, waterproofing, tinting.

In yet another embodiment, a module 20 may use plasma activation processes in which a polymer can be treated to improve its ability to be painted or printed on. This may be achieved by using oxygen plasma to oxidize the outer layer of the polymer. Metals that oxidize easily may be treated with an argon delivery gas. This produces not only a clean product, but also an increase in the polar groups, directly improving the printability and coatability of the polymer product. Oxygen argon plasma can also used for plasma activation in some processes.

A fluid delivery means (shown in Figures 8 to 14) may be used to supply delivery gas to a module to then be charged by the electrodes 101. Provision of delivery gas to the electrodes 101 may form a plasma region which can polymerise monomers. A substrate 1 is shown as passing below the electrodes and plasma region which can treat a substrate. It will be appreciated that the plasma region 106 may not be in direct contact with a substrate 1 to treat the substrate, and ionised gases are pushed towards or flow towards the substrate 1 to be deposited thereon or may interact with the substrate 1. Without charge to ionise the delivery gas the ionised gas may return to an uncharged state within a relatively short period of time. In yet another embodiment, the distance between the module 20 and the substrate is between 20mm to 0.1mm, but more preferably between 10mm to 1mm, such that as the substrate 1 moves under the module 20, the speed of the substrate 1 causes a movement of plasma from the plasma region 106 towards the substrate such that activated species within the plasma region 106 can interact with the surface of the substrate. Using this method the substrate surface may be coated or treated more efficiently.

In another embodiment, microwaves can be used to cause ionisation of the delivery gas and generate the plasma region. If microwaves are used to generate a plasma region, radiation shielding may be used such that any microwaves generated are blocked from extending beyond a desired region.

Ionised fluids in the plasma region may fall through to a substrate 1 under gravity as the system is adapted to operate in atmospheric conditions. As plasma may be influenced by magnetic fields and electromagnetic radiation, the plasma region 106 may be subject to at least one of a magnetic field or magnetic radiation which may influence the movement of the ionised fluids. Movement of ionised fluids may be urged towards a substrate 1 which may also improve interaction and/or treatment rates, thereby improving the processing speeds of the system 10.

In another embodiment shown in Figure 7, a high-pressure region 50 and low pressure region 55 may be created by the system 10 causing fluids to move from the plasma region towards the lower pressure region 55. Preferably the high-pressure region 50 is above the electrodes 101 and the low pressure region 55 is near to the treatment surface of the substrate 1 causing ionised fluids to move towards the low pressure region 55 which may more effectively cause a desired flow of plasma or fluid flow. The low-pressure region 55 may alternatively be generated below the substrate 1 which may cause a similar improved flow of fluids. Changing the pressure of the high pressure and/or the low-pressure regions may be used to increase or decrease flow of plasma or other fluids to the substrate 1. Increasing the flow rate may be advantageous to improve the processing speeds of the system. Having high- and low-pressure regions may also be used to move plasma more effectively and therefore improve cooling of the electrodes 101.

A Bernoulli effect may also be imparted to the substrate to lift a substrate from a supporting surface when the substrate is moving at a predetermined speed. In this way a high pressure is created below the substrate 1 and the surface of the substrate 1 near to the module 20 is of a relatively lower pressure which may cause lift of the substrate if the substrate is allowed to lift, and also causing fluids to move from the high pressure region 50 of the module 20, to the low pressure region 55 at the surface of the substrate 1. Alternatively, the Bernoulli effect may be used to move fluids towards the substrate 1. Movement of fluids from high pressure regions to low pressure regions may also impart a laminar flow to the fluids.

Turning to Figure 8 there is shown an embodiment of a module 20 for plasma treatment. A delivery gas can be provided to the module via fluid delivery system 37. Fluid delivery system comprises an inlet 107, a fluid conduit 110 and an outlet 112. As shown, this embodiment also comprises a manifold 108 connected to the inlet 107 and the fluid conduits 110. A plurality of blocks 120 are shown as being in fluid communication with the fluid conduits 110 and the blocks being used to direct the fluid to the outlets 112. The blocks 120 are used to evenly distribute delivery gases in the module 20 to subsequently be provided to plasma regions 106 via the outlets 112. The blocks 120 may be integrally formed with the module 20, or are removably mounted in a block rack 130 of the module 20. The block rack may be used to assist with directing flow of delivery gases from the blocks towards the electrodes. As seen the block rack 130 is tapered to funnel or direct fluids from the block 120 towards the electrodes 101.

While the fluid delivery system 37 as shown in Figure 8 comprises blocks and a manifold, the system 37 may only need comprise a fluid inlet 107, a fluid conduit 110 and an outlet 112 to supply a delivery gas to the plasma region 106 between electrodes 101. Optionally, at least one of the fluid inlet 107, fluid conduits 110 and outlets 112 comprise a fluid flow control means which be used to restrict flow of fluids within the fluid delivery system 37. Conventional valves may be installed within the fluid delivery system 37 which can be used to alter the flow of fluids through the module, which can also be used to increase the pressure of the fluid exiting the outlets 112 into the plasma region 106. The fluid flow control means can therefore be used to more effectively control ejection (or exit) of fluids from the outlets 112 and optionally impart a desired effect to a fluid existing the outlets. In yet another embodiment, the outlets 112 are provided with vaporisers, misters, spraying devices or other means to alter the fluid stream at an outlet 112 to impart a desired effect. It is preferred that fluids exiting the outlet 112 are dispersed such that ignition and/or ionisation of fluids which enter the plasma region (such as a delivery gas and or a further fluid delivered therewith for example) occurs more easily. This may also provide for a more even plasma density across a plasma region 106 which can be more effective to treat a substrate 1.

Instead of a single conduit 110, individual delivery gas conduits 110 and monomer conduits 110 may be used to provide fluids to the plasma region 106 between the electrodes 101. In this way the monomer and the delivery gas can be mixed between the electrodes at the time the delivery gas is energised. This may provide a more effective delivery method for delivering a monomer. Further, at least one of the delivery gas/monomer conduits may be used to impart a desired fluid flow to the fluids ejected into the plasma region 106, which may improve the delivery rate of fluids to the substrate surface 1. Further, the relative heights of the outlets for the conduits may be used to impart a desired fluid flow. Further, having individual conduits may also allow for fluids to be delivered with different temperatures, different flow rates, and/or different volumes, and may also allow for fluids to be selectively turned off or flow rates altered to achieve a desired flow and/or mixture.

The number of electrodes 101 used for a module 20 may depend on the desired processing and/or the substrate 1 to be processed. More preferably, the number of electrodes 101 corresponds to the number of outlets 112 of the module 20 (the number of electrodes 101 is equal to the number of outlets 112 plus one electrode). For example, if there are five outlets 112 there will be preferably six electrodes 101. It will be appreciated that fewer electrodes 101 may be used to generate the plasma, however this may also reduce the strength of the plasma region 106 and raise operational temperatures required to maintain a desired/consistent plasma region 106.

In some embodiments, reducing the distance between the plasma discharge (plasma region 106) and the substrate 1 may also reduce the overall energy requirements of the system 10. Reducing the distance between the substrate 1 and the plasma discharge may allow for a more compact system 10 to process a substrate. In another embodiment, reducing the cross-sectional area of the electrodes may also reduce the energy requirements of the system and may allow for more outlets 112 to be installed in module 20 without an increase of size of the system 10. It will be appreciated that the smaller the cross-sectional area the more difficult it may be to cool electrodes 101 and may also reduce the plasma volume generated. As such, a minimum cross-sectional area of electrodes 101 may be around 10mm² to allow for sufficient cooling of electrodes 101 in use.

Electrodes 101 may be fabricated with a hollow structure, round, ovoid, square or rectangular stainless steel, aluminium, copper, or brass tubing, or other metallic conductors. The hollow structure may be concentric or otherwise generally conform to the shape of the electrode outer wall. The inner wall of the hollow structure may be coated with a corrosion resistant material such that coolants can be in contact with the inner region of the hollow tubular electrodes 101. A dielectric coating may also be provided to outside of the electrode 101. Preferably, the electrodes 101 are shaped to minimise the potential for arcing or other edge effects when in use, and therefore any edges of electrodes 101 may be curved or otherwise chamfered.

In one embodiment, the electrodes 101 may be formed with a width of between 1cm to 3cm and a height between 1cm to 3cm. The cross-section of the electrodes 101 is preferably uniform along the length of the electrode such that a relatively more uniform plasma field can be generated. It will be appreciated that in other embodiments, portions of the electrodes 101 may have a different diameter, cross-sectional area or cross-section such that differing effects or strengths may be imparted to a plasma region 106.

Delivery gases provided to the blocks 120 may have a vaporised monomer mixed with the delivery gas such that when the delivery gas is ionised, the monomers are polymerised. The polymerised monomers can then be deposited on a substrate 1. Alternatively, the polymers may be polymerised after contact with the surface of the substrate 1. The plasma generated from the delivery gas may also be used to activate or excite a surface of the substrate 1 which may also improve adhesion or bonding of the monomer to the substrate 1 surface. The fluid delivery system 37 may pass a delivery gas through a volume of monomer or fluid to be carried and collect a portion thereof to be delivered to the blocks 120. Preferably, the volume of monomer is upstream of the fluid inlet 107. Mixing of the delivery gas and the monomer prior to reaching the module 20 may allow time for the monomer to be more evenly distributed in the delivery gas and improve homogeneity of the plasma region 106 and the monomers delivered thereto. To reduce energy of the system 10, a monomer may be in a liquid state prior to interaction with a delivery gas which may then vaporise a portion of the monomer to carry said monomer to the blocks 120.

In another embodiment, the monomer within the delivery gas may also react or interact with species from the plasma generated from ignition of the delivery gas. It will be appreciated that the monomer may instead be a precursor fluid which may include at least one of a; monomer, further gas, or other treatment chemical. As such, any reference herein to a "monomer" being delivered or carried by a delivery gas, may instead be a "precursor" being delivered or carried by a delivery gas.

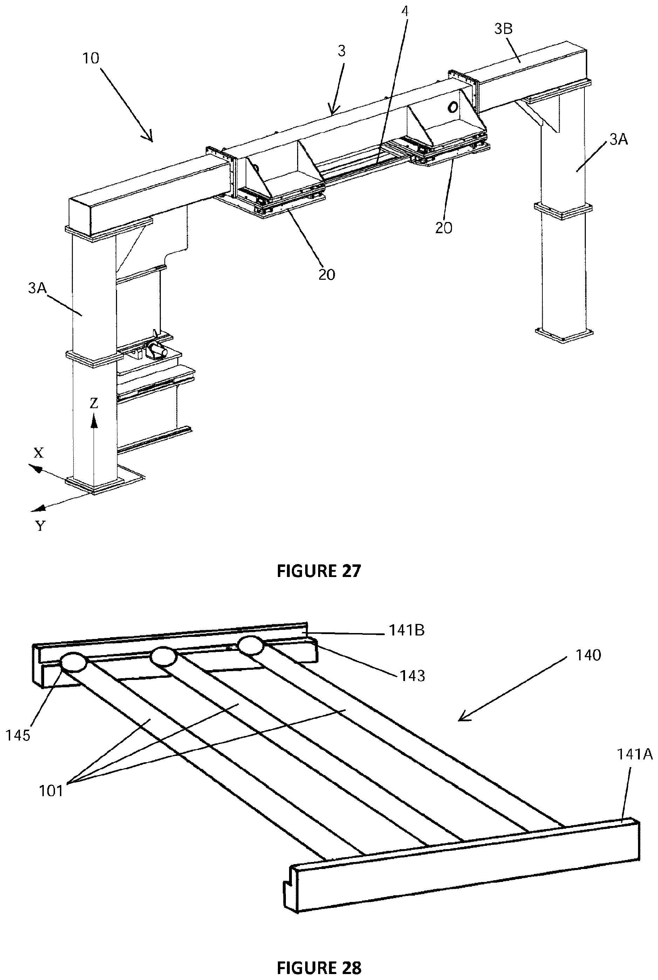

Electrodes 101 are positioned below the outlets 112 of the blocks 120 such that delivery gases can be ionised by the electrodes thus generating a desired plasma region. Each electrode 101 may be positioned offset from the outlets 112 to allow for delivery gases to more effectively be provided to between electrodes 101 to generate a plasma region 106. Electrodes 101 may be formed from hollow tubes which allow for a coolant to be passed there through. Preferably, the electrodes 101 may be constructed with parallel, grounded, hollow circular or oval tubes having a desired diameter. It is preferred that the electrodes 101 have a uniform spacing such that corona discharges are less likely to occur during use which can damage electrodes. Further, it is preferred that the electrodes comprise a uniform diameter or cross-sectional area. An electrode rack 140 (such as the rack 140 shown in Figure 28) may be used to mount the electrodes 101 with a desired spacing such a minimum or maximum distance can be achieved consistently which may improve the plasma region generated. Depending on the desired plasma to be generated, the electrodes may be coated with a dielectric. The dielectric may comprise a material such as PET, PEN, PTFE or a ceramic such as silica or alumina, however other materials may also be used for the dielectric material. Dielectric materials may be used to form the sheath of the electrode 101, and a conductive material forms the core of the electrode.

An electrode rack 140 may also allow for displacement of electrodes to match gas outlets 112 of a module 20. While electrodes 101 can be displaced, the electrodes 101 are preferably uniformly disposed in an electrode rack 140. The electrode rack 140 may be used to support respective ends of electrodes 101. The ends of the electrodes 101 may have a support formation which can mate with the electrode rack 140 to ensure that even placement of the electrodes 101 can be achieved. A cooling system 35 may be connected at the ends of the electrodes 101 and may be used to supply a coolant fluid to a hollow region of the electrodes 101. The hollow region of the electrode 101 may act as an electrode cooling duct for cooling system 35 as previously mentioned. This is beneficial as the plasma regions around the electrodes may reach temperatures of around 300°C. A radiofrequency (RF) power supply may also be used to regulate or power the cooling system 35 for the electrodes 101.

After electrodes 101 are mounted within the electrode 140 rack the rack 140 may be connected to the module 20. In one embodiment, the block rack 130 and the electrode rack 140 are a single rack which allows for mounting of both blocks 120 and electrodes 101. In the embodiment of Figure 8, the electrode rack and the block rack are illustrated as being separate. Ends of electrodes 101 may be shaped or keyed to allow for mounting in specific electrode racks to ensure that all electrodes 101 are in a predetermined or desired configuration. Once electrodes 101 are mounted in the electrode rack 140, the electrodes 101 can be connected to a power supply. Depending on the desired plasma to be generated, the power supply may be DC or AC as previously discussed.

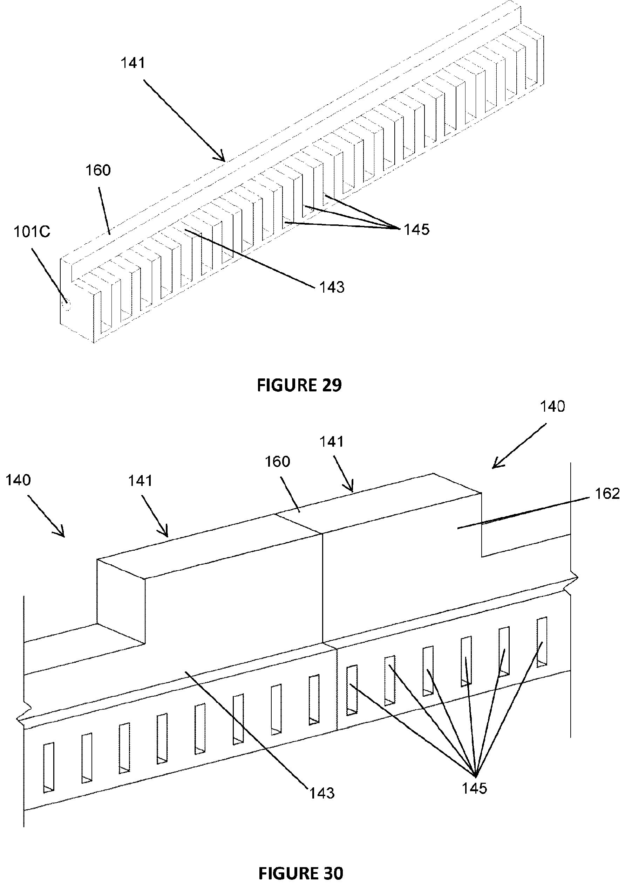

As seen in Figure 28, the rack 140 may support and/or retain the electrodes 101 at the ends of said electrodes 101. Another electrode rack 140 embodiment is illustrated in Figure 29. The electrodes 101 may be connected to wiring or fluid conduits at the sides 141A, 141B of the rack 140. The rack preferably allows for fluids to pass through a core of the electrode from side 141A to side 141B. The sides may have keyed or formed depressions or recesses 145 which allow for electrodes to be mounted and connected to power supply 30 or cooling system 35. Sides 141A and 141B may be similar in structure, or may have a predetermined recess 145 formation which allows for mounting of electrodes 101 in a specific manner. The sides 141A, 141B can be connected to sides 141C (not shown) such that a unitary frame can be formed. The unitary support frame may provide a desired rigidity to the electrodes 101. The sides 141, 141B and optionally 141C may form the electrode rack 140. A lip 143 may be provided for recesses 145 to be formed within or may be used to abut or mate with a portion of the module 20 to allow connection of the electrode rack 140. While side 141A is shown as a solid feature, apertures or sockets may be provided to allow for connection of wiring and/or fluid conduits of the cooling system. The recesses 145 may be instead replaced with electrode mounts (see Figure 29) which can be moved along a track of the sides 141A/141B to allow for electrodes 101 to be spaced at a desired distance. Other movement means for moving electrodes relative to adjacent electrodes may also be used. Electrode mounts can be locked in place such that electrodes 101 are not moved during use. Electrodes 101 in a rack 140 are preferably locked, secured or clamped such that movement of said electrodes 101 is restricted or prevented. Multiple electrode racks 140 can be mounted adjacently or in a series. Electrode racks 140 are preferably formed from a non-conductive material. In yet another embodiment, the module housing 22 has an electrode rack 140 integrally formed therein.

In another embodiment, a plurality electrode racks 140 are connected via a rack connector 140A. The rack connector 140A may also allow for mounting of one or more electrodes 101 such that spacing between electrodes is not irregular or interrupted. Rack connectors 140A may be fixed with one or more electrode racks 140 to form a desired electrode configuration or arrangement.

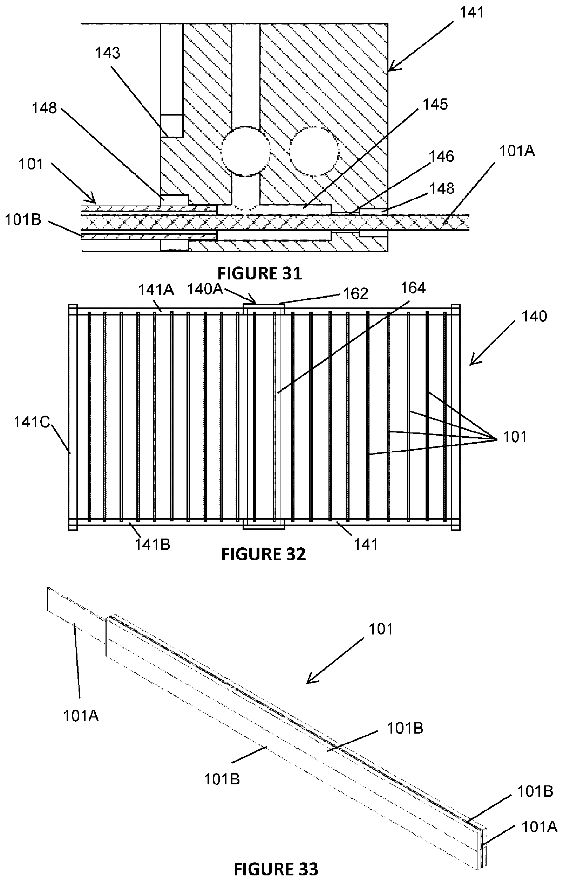

An embodiment of an electrode rack side 141 is illustrated in Figure 29. The side 141 can be used to form a portion of an electrode rack 140. Recesses 145 have been made within the side 141 to receive a plurality of electrodes 101 therein. In the embodiment illustrated, the recesses are configured to receive blade type electrodes 101 (see Figure 31). The side 141 as shown is formed with a body portion, a plurality of recesses formed in the body, and a lip 143. A projection may be formed extending from the body projecting relatively upwardly and may be used to define the lip 143. The projection may have at least one fixing location which can be used to fix, bolt, secure or otherwise attach the side 141 to a module 20. The side may also have an edge which is adapted to abut another side portion 141 or an end portion.

Referring to Figure 30, there is illustrated an embodiment of two electrode rack portions 141 abutting. The electrode rack portions 141 form a part of an electrode rack 140. The abutment edge of the electrode racks may have a material which can form a fluid tight seal disposed therebetween. The fluid tight seal may be formed with the use of a rubber or polymer for example, and can preferably withstand operating temperatures in the range of 0°C to around 300°C. A seal recess may be disposed in the edges which can seat a seal. The projections 162 can be disposed near to, or at the end of the rack portion 141 which allows for the racks to be supported. The projections 162 may be provided with mounting means or an extension 164 to allow for mounting to a module 20. An extension 164 may be used to extend between two sides 141, 142 of the rack 140 (see Figure 32). The mounting means may be ports or apertures in which a connection element can be situated. The connection element may be any predetermined element which allows for the connection of two or more members, such as a male and female fitting, a tongue-in-groove fitting, an interference fitting or any other conventional fitting. It is preferred that any fitting used is not exposed to plasma or near enough to electrodes to cause arcing or adverse plasma conditions if the connection element is formed from conductive material. Preferably the electrode racks are supported or suspended by the projections 162 to allow for electrodes to be positioned as close as possible to a substrate to be treated. In another embodiment, the rack sides 141 may be connected to the manifold, or integrally formed with the manifold.

Plurality of recesses 145 are disposed within the rack portion 141 which are configured to receive electrodes 101. Different sizes of electrodes 101 can be mounted within the recesses with the use of an adapter portion (not shown) which seat the electrodes at a desired height or location within the recesses 145. Adapter portions may have a dielectric or insulative coating on the side exposed to plasma to reduce degradation of the adapter during use. Each electrode 101 selected may have the same sheath shape, or may have varying shapes. Optionally, the electrode cores may have the same, or different shapes. Preferably, the electrode shapes and/or core shapes alternate in an A-B-A pattern such that generally the same plasma profile may be formed between adjacent electrodes 101.

If two or more sides 141 are connected together, the sides 141 may have a seal or other means to form a tight fitting arrangement, or more preferably a fluid tight arrangement along the abutment edge 160. Having a fluid tight arrangement may allow for coolant to be passed through the entire rack 140 without the need for separate coolant injection ports for each rack side 141.

Optionally, the electrode rack 140 is formed from a dielectric material, or an insulation material. In one embodiment, the electrode rack is formed from an alumina or is coated with an alumina material. The electrode sheaths 101B may be also formed from the same materials as that of the electrode rack 140 or any other predetermined combination of materials. Optionally, the rack 140 may be formed from a polymer, a metal, a composite, a ceramic or a combination thereof.

Mounting means of the electrode racks 140 may be integrally formed with the rack or may be affixed to the rack 140 when desired. The lip 143 of the rack side 141 may be configured to receive a gas outlet plate. Guides or other positioning means may be disposed on the lip 143 to allow for alignment of gas apertures with the configuration of the electrodes 101. Preferably at least one fluid channel is disposed in the side and extends through to mounting locations of at least one of the electrodes 101. The fluid channel is preferably in communication with a fluid channel 101C of the electrodes 101.

As illustrated in Figure 29, the electrode recesses 145 can form a portion of the lip 143 and allow for mounting of electrodes 101 in more than one direction. Fluid channels may be disposed within the rack sides 141 which allow for coolant to be provided to and from electrodes during use. Coolant may include inert fluids, such as a plasma gas or noble gas, or may be a liquid, such as water, or any other desired fluid.

Racks 140 may be marked with placement instructions to ensure correct placement of electrodes, or may be formed with a key or stopper to prevent insertion of electrodes which are not designed to be mounted therein. Correct placement of electrodes 101 with polarities alternating is required to allow for generating a plasma and racks and/or electrodes are colour coded, marked or shaped to allow for placement in a predetermined configuration. Optionally, electrode sheaths 101B are keyed with a predetermined mounting shape, or electrode cores 101A are offset to allow for a predetermined placement.

Staggering of electrode cores 101A may also be used to ensure correct placement of electrodes. It will be appreciated that while cores 101A may be staggered the sheaths 101B may have a uniform configuration without evidence of staggered cores 101A when mounted.

As shown in Figure 31, the core 101A may extend to an outer side of the rack 140 and allow for coupling with a power supply. Each core may be individually coupled to a power source, or several cores may be coupled simultaneously to a single power source. A portion of the exposed core 101A may be coated with an insulating material, a dielectric or a corrosion resistant coating, which may also assist with reduction of arcing outside of the rack 140. The rack 140, or sides 141 thereof, may be formed with coupling connectors such that the rack 140 can be connected to a power supply.

The sheath 101B as shown is mounted in a recess which is sized to fit the sheath 101B, and the core 101A is received in a core recess 146 which is sized to receive the core 101A. in this way the electrodes can be mounted correctly within the rack, and the core and the sheath can separately be supported. This is of particular advantage if the core is suspended within the sheath 101B and a fluid gap surrounds or partially surrounds the core 101A within the sheath 101B. Optionally, the cores 101A may be post-tensioned after installation to reduce flex of the electrode 101, or the electrode core 101A. A gasket 148 may be mounted within a recess 145, 146 such that the gasket 148 can reduce fluid ingress into the recess 145, 146 during use. Gaskets 148 may be formed from a dielectric material, or a heat resistant material and have an insulative or dielectric coating.

A top view of an electrode rack 140 is illustrated in Figure 32. The rack comprises a plurality of electrodes mounted within the rack, and a connecter portion to join the rack sides 141, 142. Connector portions may be used instead of forming the rack sides 141, 142 with projections 162.

Figure 33 illustrates an embodiment of a blade electrode 101. The electrode comprises a rectangular core conductor which is disposed between two dielectric sheath parts. An infill or adhesive is disposed above and below the electrode core 101A which encloses the core between the sheath dielectrics 101B and the infill. In this configuration the infill forms a portion of the sheath 101B. One or more fluid channels 101C can be provided in the electrode 101. While the core is illustrated as a rectangular core, any core shape may be used. The core projects from the sheath such that is can be coupled with a power supply. Alternatively, the core 101A may not extend from the sheath, and a power supply can be inserted into the sheath to couple with the core 101A. Each of the electrodes 101 may be in the form of a blade as seen in Figure 33. The blades may have a cross section which is a rectangle or is generally triangular. This may allow for formation of elongated channels which can assist with directing plasma fluids.

Preferably, a dielectric has been coated on the surfaces of the electrodes 101, or the sheath 101B is formed from at least one dielectric material. Each electrode 101 may be connected to a power supply 30 by connecting bar electrodes at a common end of each electrode 101 to said power supply 30. Optionally, electrodes may mounted in an electrode rack 140 of the module 20 which can retain the electrodes 101 in a desired configuration or array. While dielectric materials can be used to form part of the electrodes 101, the electrodes 101 may have at least one coating or segment with a non-dielectric material. A non-dielectric material may be used where there is need for insulation or protection on the electrodes 101 or module 20.

Preferably, if ceramics are used, the ceramics are non-porous such that the potential for damage to electrodes is reduced from fractures or other physical failures. This may assist with the lifespan or durability of the electrodes during use. Other materials may be used to fill gaps within porous ceramics which can assist with heat reduction or cooling of the electrodes during prolonged use.

Coatings may be applied to electrodes 101 with conventional dipping and heat treatment processes. Tempered glass, annealed glass, and toughened glass may also be used to form a shell or coating on the electrodes which may reduce the porosity at the surface of the electrode 101. Tempered glass may include borosilicate glass, gorilla glass, safety glass, laminated glass, fire glass, superglass, lead glass and low iron glasses.

Dielectric materials and thickness of materials. Wherein the thickness of the dielectric materials on the electrode is 5mm or less in thickness from a surface of the electrode 101. The dielectric properties of the material should be sufficient to withstand temperatures of at least 40°C, but more preferably may withstand temperatures of at least 100°C. In other embodiments, the dielectric material can be heated to temperatures of around 100°C to 350°C without failure of the dielectric. The dielectric material may be selected from the group of; ceramics, alumina, paper, mica, glass, polymer, composites of the aforementioned, air, nitrogen, and sulfur hexafluoride.

Alumina (aluminium oxide) may be used to form the electrodes. Preferably, alumina 90% to 99.5% may be used to form the electrodes. Preferably, 92%, 95% and 97% alumina are preferred in some specific embodiments. While it is preferred that at least 90% alumina materials are used, other embodiments may allow for the used of a minimum of 80% alumina or higher. Alumina selected preferably have a flexural strength in the range of 280Nm to 365Nm, and with a hardness R45N between 72 to 83.

Barium strontium titanate (BST) and ferroelectric thin films may also be used for dielectric purposes in some embodiments. These materials may be formed in laminations or applied to the surface of the core 101A of the electrode or to a surface of a sheath 101B or dielectric material.

Poly(p-xylylene), also commonly referred to as the trade name "Parylene", coatings can also be used to assist with dielectric properties of the electrodes 101, and may also be coated onto electrodes 101 to assist with hydrophobic properties of the electrodes 101, which may reduce build-up of monomer and/or polymer. Further, hydrophobic coatings may assist with reducing the frequency of cleaning electrodes 101 if monomers or chemistry are changed for different treatment processes. Preferably, Parylene coatings are selected which can withstand short- and long-term temperature exposure.

Electrodes 101 and racks 140 for electrodes 101 may be machined, extruded and/or cast into a desired shape. While embodiments show electrode racks 140 formed from a plurality of sides segments 141, the rack 140 may instead be formed as a single integral rack and electrodes 101 may be inserted from an outer side of the rack 140 into the desired mounted location.

As arcing may occur when power loads vary, surface defects are present or surface potentials being present, anti-arcing systems may be used to supress the likelihood of arcs forming. Anti-arcing systems may be in communication with individual electrodes 101 or electrode racks 140. These systems can reduce supplied power to an electrode 101 or plurality of electrodes 101 when measurable power spikes or power above thresholds is measured. This may limit voltages which will increase the potential for arcs to form between one or more electrodes 101.

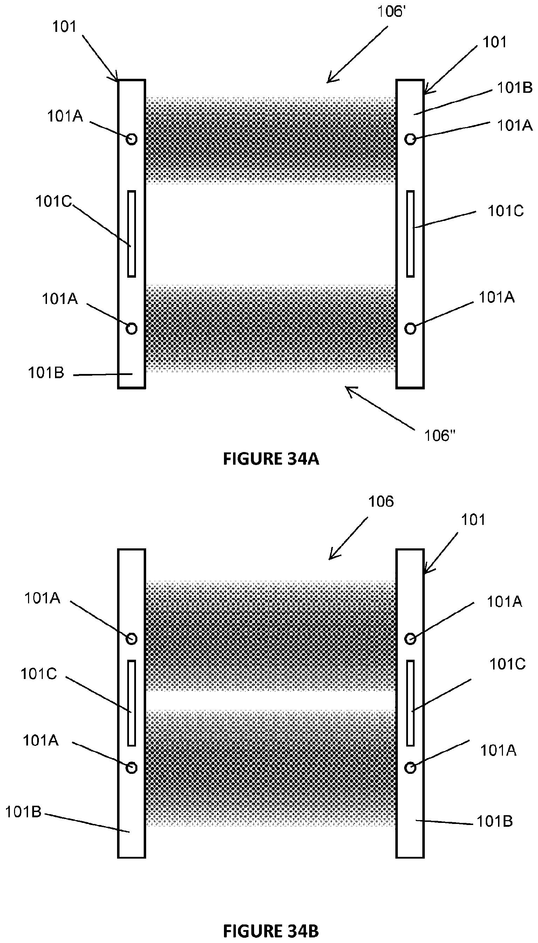

Referring to Figures 34A and 34B, two sets of electrode cores 101A are disposed within an electrode sheath 101B, which may be used to form two or more plasma regions 106 within the reaction gap 103. Each plasma region may allow for polymerisation and/or repolymerisation of monomers and polymers. Optionally, the spacing of the cores 101A may be spaced close enough such that a single plasma region 106 is formed rather than two discrete plasma regions 106', 106" in the case of two sets of cores. If the respective plasma regions 106', 106" are formed to be a combined plasma region 106, the combined plasma region 106 may expose the monomer to variable densities passing from the top of the electrode to the substrate 1. It will be appreciated that any number of cores 101A may be used to create any desired number of plasma regions 106A set of electrodes 101 may include one or more electrodes 101 which can be used to form a plasma region 106. Each of the plasma regions 106 may utilise the same plasma fluid or may utilise different plasma fluids.

Electrode core 101A spacing can be altered such that electrodes cores 101A are arranged in one or more planes. For example, a first series of electrode cores 101A are disposed in a first plane and a second set of electrode cores 101A may be disposed in a second plane. The first plane and second plane may be parallel to each other such that each plane may provide a plasma region 106 which can be used to polymerise a monomer, or a first plane may be used to assist with ignition of plasma in the second plane.

A monomer may be injected directly into a respective plasma region 106 (such as 106', 106"), between plasma regions 106, or relatively above or below the plasma regions 106. Injection of the monomer between plasma regions 106 may assist with effective polymerisation of the monomer. Outlets of the monomer injection system can be located between plasma regions 106; but may optionally be disposed relatively closer to an upper plasma region 106' such that as the monomer flows downwards the residence time of the monomer within the upper plasma region 106' is generally the same as a lower plasma region 106".

Upper and lower plasma regions 106', 106" may be formed to have different plasma densities to ensure polymerisation of a monomer species which is introduced to the plasma regions 106. Each region 106 formed by the electrodes 101 may be selectively turned on or off during use to allow for different rates of polymerisation or different polymerisation effects.

For example, a first polymerisation step may be provided by upper plasma region 106' and a second polymerisation step may be achieved lower plasma region 106". Optionally, a monomer and/or plasma fluid may be provided above the upper plasma region 106', and a second monomer and/or plasma fluid may be provided relatively above lower plasma region 106", but below upper region 106'. This may allow for single and double polymerisation of monomers and fluids which may then be impinged or deposited onto a substrate 1.

Introduction of a monomer may form a Penning mixture with the plasma gases, which can assist with Penning ionisation to thereby form a desirable plasma cloud or plasma glow within the plasma region.

Recirculation of monomer, polymer and plasma fluids may be achieved by recirculation equipment. Optionally, a photo ionisation detector or other monitoring/sampling device may be installed within the recirculation equipment, such that the collected fluids from the system 10

Production monitoring equipment may include IR systems, such as Fourier-transform infrared spectroscopy (FTIR) devices which can detect the presence of monomer compounds on a surface of a substrate. Other monitoring systems may also be used to detect the thickness of coatings applied to a substrate.

Penning traps may be used to reduce movement of ionised particles in one or more predetermined directions, and/or urge ionised particles or polymerised monomer in a predetermined or desired direction.

A bias plate may be used to attract ionised matter which can assist with increasing deposition rates or imparting a fluid movement to the ions. Preferably, the bias plate is a DC bias plate which is negatively charged. It will be appreciated that the bias plate may be positively charged if desired. Penning traps may be used above and/or below the plasma region, such that ionised matter in the plasma region can be repelled or attracted in specific directions. Preferably, if a Penning trap is used, the polarity of the Penning trap is opposite that of the bias plate if the bias plate is present. A magnetic field may also be used to induce movement of ions within a plasma region and can urge positive and/or negative ions in a desired vector or direction.

Methods for treating a substrate 1 may include providing a polymer to a substrate, having a generally sheet or planar form, in which the polymer has been formed by plasma polymerisation. The substrate 1 may have at least one fibre or yarn exposed at a surface which can be treated by the system 10. Polymers may be formed by plasma at atmospheric pressure wherein the energy of the plasma is sufficient to cause polymerisation of monomers and subsequent bonding of the polymer to a substrate 1. The thickness of the polymer coating applied to the substrate 1 may be dependent on the density of the plasma, the coating time, and the volume of monomer introduced into a plasma region 106.

In another embodiment, there may be provided an electrode rack 140 which can be used to generate a stable plasma at power densities between 0.1 W/cm³ and 200 W/cm³. Atmospheric pressure may be in the range of between 380 Torr and about 1200 Torr.

**In** yet a further embodiment, active monomer species of the plasma exit the plasma region 106 before impinging on a substrate 1. This may allow for surface processing without simultaneous exposure of the substrate to the electric fields or ionic components of the plasma. The plasma during prolonged and continuous operation may generate species including gas metastables and radicals. The high-power densities and the placement of the material to be processed exterior to the plasma, permit accelerated processing rates, and treatment of substrates. **In** some embodiments, the plasma source may be used for monomer polymerisation, surface cleaning and modification, etching, adhesion promotion, and sterilization.

Plasma may be formed as a corona treatment, a dielectric barrier discharge, atmospheric glow discharge and hybrid combinations thereof. Each of these plasmas may be utilised for continuous processing and/or batch processing. When a voltage is provided to the electrodes 101 sufficient to form a plasma and ionise monomer, a polymer may be formed. At least one of coating, etching, activation and cleaning of a substrate may be achieved by the plasma and/or monomer.

Plasma may be struck at approximately room temperature and at about atmospheric pressure. The monomers may be injected into a plasma chamber as a liquid spray, a vapor or atomized particles and may assist with forming desirable plasma conditions as monomers the monomers may be adapted to stabilise a plasma streamer or plasma corona condition. Stabilising a plasma condition may mean forming a plasma glow or a stable plasma within the plasma region. It will be appreciated that the voltage applied will also assist with maintaining and/or forming a stable plasma.

In yet a further embodiment, the plasma may be used to treat only a first side of a substrate, while the second side of the substrate may be protected from treatments, or may be separately treated by a different coating or treatment process. This may allow for selective modification of one side of a substrate. Protection of one side of the substrate may be achieved by application of a film or protective layer on the second side of the substrate, or by pressing the second side of the substrate against a surface which will not allow coatings or treatments to be applied to said second side of the substrate.

Processing speeds may be used to press or bias the substrate in a desired position during treatment to allow for selective treatment of the substrate. Preferably processing speeds are in the range of 0.1m/s to 60m/s. Exposure time of the substrate is preferably sufficient to allow for application of a coating in the range of 5 micron to 100nm thick. Exposure time of the substrate will be dependent on the speed of the substrate, the desired thickness of the coating and polymerisation rate of monomer species.

In some embodiments the substrate 1 is not exposed to plasma, but only plasma polymerised species or coatings formed by plasma. Other embodiments may allow for pre-treatment of a substrate with plasma to clean or activate a surface of the substrate and subsequent coating without exposure to plasma, but being exposed to polymerised species which may for a coating.

In yet another embodiment, portions of a substrate surface may be coated with a first coating thickness, while other portions of the surface may be coated with a second thickness. A gradient may be observed between the first coating thickness and the second coating thickness. The gradient may be linear, slope, radial, angle, reflected, or diamond gradient. Any gradient may be a transition from the first coating thickness to the second coating thickness. In another embodiment, the first thickness transitions to the second thickness without a gradient.

The gradient may also be a transition region from a first functionalised coating to a second functionalised coating. This may allow for more controlled fluid direction. For example, the first thickness may have a hydrophobic functional coating while the second thickness may have a hydrophilic coating which can generate wicking channels or wicking regions. Other functional coatings and treatments can be applied to a substrate for desired properties. More than one functional coating may be applied to the substrate. Patterns may also be formed on the surface of the substrate using plasma coating techniques. Etching may also be used to expose a functional treatment below one or more surface treatments. If one or more functional treatments are disposed on a substrate etching may be used to expose selected functional treatments. Etching coatings may not be readily visible without microscopy equipment and preferably does not alter the feel of a coated surface.

The plasma module 20 may be an APG treatment module 20, according to an embodiment of the present invention, which comprises a gas inlet 107 and an outlet 112 through which a gas can be delivered into a plasma region 106 generated by the electrodes 101. At least a portion of the module 20 may be adapted to be flexible or expand when in use due to the temperatures generated near to the plasma region 106. Optionally, expansion of the module 20 may be limited by using materials which do not exhibit significant thermal expansion.

In one embodiment, nitrogen gas having a velocity of 2 m/sec may be fed into the plasma region 106. It will be appreciated that the plasma region may also be referred to as a "discharge space" and is disposed within the reaction gap 103.

In one embodiment the electrodes may be charged with an AC power supply having a voltage of 2.8 V peak to peak and frequency of 13 kHz in order to generate the desired plasma. As the desired plasma region comprises an APG, common arcing locations or arcing points near to the electrodes may be rounded or removed to encourage a consistent APG. In another embodiment, the peak to peak voltage may be in the range of 1 V to 10 kV.

The temperature of the plasma from the plasma module 20 may be modified depending on the delivery gas used, a monomer and/or the substrate 1 to be treated. Further, the plasma generation may also dictate the temperature of the plasma region. Preferably, the APG module 20 can use a low-temperature glow which may be less than 100°C, and more preferably less than 50°C, and even more preferably around or less than 40°C. Plasma at these temperatures may be considered to be a cold atmospheric plasma (CAP) glow. A CAP glow may also be a "room temperature" plasma glow, in which the temperature of the plasma is within around 5°C to 40°C of room temperature. It will be appreciated that any module previously mentioned may be adapted to generate a CAP glow such that treatments do not burn substrates 1. Further, CAP may be suitable for controlling reactive species, neutral particles, and may be influenced by electromagnetic fields and/or UV radiation. CAP glows may have particular use for sterilisation and/or other cleaning purposes. Further, the use of CAP glows allow for safer use of the machine if modules are exposed to atmosphere as persons operating equipment may have exposure to the plasma temperature and/or plasma without prolonged or any adverse effects.

In one embodiment, the APG module 20 uses a peak to peak voltage of 5.8 kV with an AC voltage of 3.16 kV having a frequency of 12.6 kHz. It will be appreciated that the voltages and frequencies may be altered depending on the desired plasma, the delivery gases and/or the substrate to be treated. All voltages mentioned may be ±3.5 kV and frequencies mentioned may be ± 5 kHz. Other voltages and frequencies may also be used if desired.

Referring to Figure 9 there is shown another embodiment of a module 20. The module comprises a plurality of blocks 120 mounted in a block rack 130. The blocks are spaced by the rack evenly and the electrodes 101 are held in parallel by stanchions or support structures 132 such that lateral movement of the electrodes 101 is reduced or, more preferably, eliminated. The blocks 120 may be releasably secured to the supports 132. Electrodes 101 are mounted in the module 20 and are disposed in a plane relatively below the blocks 120. This configuration allows gases to move from the blocks 120 to the gaps between electrodes 101 to allow for ionisation of the gas from the blocks 120. The electrodes shown are a series of alternating ground 102 RF electrodes 104. Each block 120 has a manifold 108 discrete fluid delivery conduits 110 extending from a delivery gas source 33 which feeds the respective block 120. Each discrete fluid delivery conduits 110 may be adapted to provide a uniform pressure to a block, or each discrete fluid delivery conduits 110 may be adapted to provide a different pressure to a respective block 120. Each block of a module 20 preferably receives the same delivery gas, however the delivery gases may be changed for different blocks 120, or blocks may receive doped delivery gas or delivery gas carrying a monomer.

Blocks 120 installed each have a separate gas cavity (or more generally a fluid cavity) in which the delivery gas via which the delivery gas can exit the block through the outlet 112 of the gas cavity 122. Gas cavities 122 are shown as being generally circular with a tapered section 124 or curved section at the lower end of the cavity forming a portion of the outlet 112 of the cavity 122. Directly below the blocks 122 is an array of electrodes 101 which can be used to generate a plasma region 106 as shown. Ionised molecules from the plasma region 106 can be used to treat a substrate 1 surface 1, or polymerise a monomer which can be either polymerised on the substrate 1 (if a substrate 1 is pre-coated with monomer) or said polymerised monomer can be deposited onto the surface of the substrate 1.

Electrodes 101 are connected to a power source 30 which can be used to charge the electrodes 101. Power conduits from the power source 30 to the electrodes 101 may be installed within the support structures 132, and optionally electrodes may also be grounded via a grounding means in the support structures 132 as shown. The electrodes 101 of Figure 9 are square/rectangular electrodes 101 with each electrode 101 having a hollow core to allow for a coolant to be provided therein. The hollow cores may be connected to the cooling system 35. Having linear sided electrodes 101 may be used to form a longitudinal region or column of plasma with a uniform density there between. Forming a column of plasma may be more difficult or impossible to achieve with respect to electrodes with circular or ovoid cross-sections. The linear sides 105 of adjacent electrodes 101 may be parallel such that sections the plasma region are not more dense than other regions and arcing is less likely to occur. Typical electrode 101 spacings formed between alternating RF and grounded electrode surfaces may be between about 0.2 mm and approximately 10 mm, and more particularly between about 1mm and about 5mm. As such, the plasma regions 106 illustrated may not be to scale and have been enlarged for illustrative purposes.

Electrode lengths, widths, gap spacings, and the number of electrodes 101 can be chosen depending on the material or substrate 1 to be treated. An example of a module apparatus for industrial-scale textile fabric treatment may comprise electrodes with a spacing of between 1mm to 4mm, and at least two plasma regions. It is preferred that each plasma module 20 comprises more than one plasma region.

The racks 130, 140 for the blocks 120 and/or electrodes 101 can be formed from a plastic material or another non-conductive material. The blocks 130, 140 may be housed and supported in a plastic module housing 22 block 120 fabricated from thermoplastics such as polyetherimide or polyetherketone. Optionally, a non-conductive coating may be applied to a metal rack 130, 140 to form a non-conductive barrier. **In** another embodiment the racks are made at least in part from ceramic to more effectively transfer heat away from the substrate 1 and also transfer heat away from the electrodes which can allow electrode coolant to be more effective or reduce the amount of coolant required for the system.

Figure 10 shows yet another embodiment of a module 20. The module is a plasma module 20 comprising elongate electrodes 101 which can be used to generate plasma regions 106. The plasma regions may be fed delivery gas from gas blocks 120 or directly from fluid conduits 110. The embodiment shown illustrates direct delivery of gas from fluid conduits 110 to between the RF and ground electrodes 104, 102. Forming plasma regions which are elongated may provide for a laminar plasma flow or a laminar flow of polymerised monomers through the plasma region 106. This may be used to achieve a more uniform coating or treatment application due to the laminar nature of the fluids which can be used to cause a flow to the substrate from the plasma region 106. In one embodiment, it may be considered that plasma is pushed to a substrate 1 from a plasma region 106.

The system 10 may be fitted with laminar flow means to provide a fluid to a substrate 1 more effectively. It will be appreciated that turbulent flows from a module may be useful for providing a treatment fluid to a substrate 1 more effectively, which may be particularly useful for substrates with undulating surfaces, woven surfaces or non-woven surfaces . In some cases a laminar flow from a module 20 may be used to increase processing speeds.

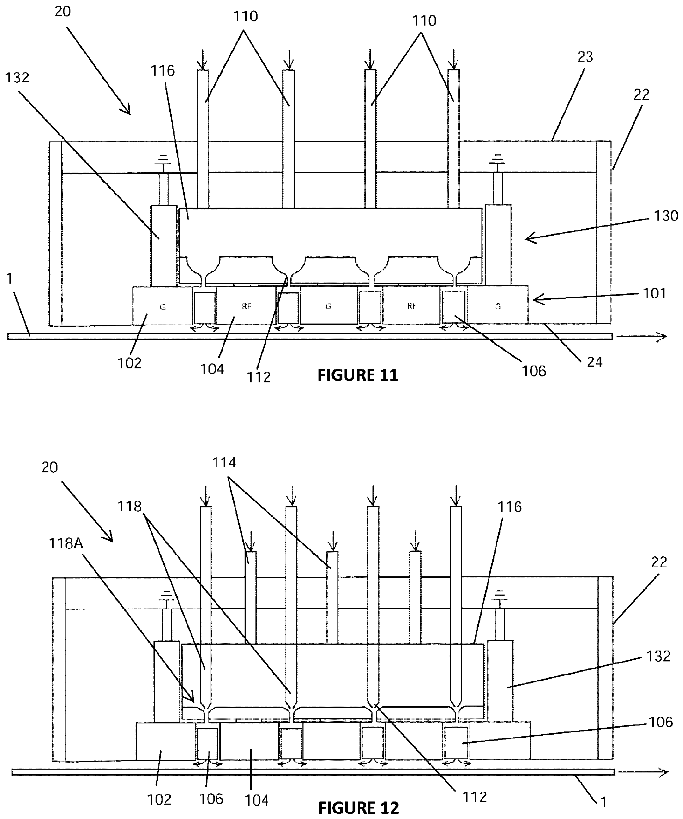

Turning to Figure 11, there is provided a further embodiment of a plasma module 20 similar to the embodiment of Figure 9. The module 20 has a common gas chamber 116 in which delivery gases are injected into. A further gas input may also be provided to the common gas chamber 116 which allows for injection of a vaporised or evaporated monomer which can be carried out of the chamber by the delivery gas or directed to the plasma region 106 for polymerisation.

More than one outlet 112 may be in fluid communication with the common gas chamber 116 such that delivery gas may be provided to a single chamber without the need for multiple fluid conduits from the manifold. While there are a number of gas inlets directed into the common chamber in Figure 11, the common chamber may need only a single fluid inlet to allow for delivery of fluids into the chamber 116. The outlets 112 may also be a plate with apertures, such as that shown in Figures 22A-22C.

With more gas injected or pumped into the chamber the fluids within the chamber will be forced out of the chamber via the outlets 112 and towards the plasma region 106. This may cause a relatively high pressure within the chamber which may be varied by the flow rate of the delivery gas provided to the chamber. Optionally, multiple delivery gas chambers 116 can be provided such that each chamber 116 can have a different delivery gas, or a different gas flow provided to the outlets 112. Each chamber may also have at least one further gas input which may provide a monomer or other fluid to the gas chamber 116.

Referring to Figure 12 there is provided a further embodiment of a plasma module 20. This embodiment also comprises a gas chamber 116, but unlike the embodiment of Figure 11 the chamber is for a further fluid such as a vaporised monomer. The further fluid may be injected into the chamber by a chamber gas inlet 119. Gas injectors may extend into the chamber and are positioned relatively above the outlets 112. Gas injectors may be used to provide a delivery fluid, such as a delivery gas, to the outlets and can be used to entrain a fluid within the chamber 116. As the delivery fluid is ejected from the outlet of the gas injector, the shear induced flow draws in fluids within the chamber and transports both the delivery fluid and the fluids from the chamber to the outlet 112 towards the plasma region 106. In this way a delivery gas and a monomer can be mixed near to the electrodes 101 and ensure that the monomer is predominantly in a vapour form when entering into a plasma region 106 which can reduce monomer build up in the system 10. Reducing monomer build-up in the system 10 may also reduce the amount of repairs required or downtime for the system 10. The high-pressure gas may be provided from the gas injector 118 and the chamber 116 houses a low-pressure gas which can be entrained with the high-pressure gas. Preferably, the high-pressure gas is a feed gas or delivery gas which may also function as the delivery gas. The low-pressure gas may be another feed gas, or may include a vaporised monomer which can be polymerised in the plasma region 106 or at the surface of substrate 1.

While the above mentioned modules are specifically referred to as plasma treatment modules, the modules 20 may not comprise electrodes and may be used for other treatment processes. Alternatively, the electrodes may not be activated or the electrodes may be removed to allow for the module to function as another module type, for example a coating module. Alternatively, the electrodes may be adapted to function as a heating element and as such function as a heating module 20.

The side of the chamber proximal to the substrate 1 comprises a number of entrainment ports. The entrainment ports 118A may be angled between 0° to 15° depending on the outlet 112 of the gas injector. As fluids flow from the gas injector nozzle towards the outlet(s) 112 of the chamber to the plasma region 106, the gas within the chamber 116 is also entrained. In this way a desired flow rate can be supplied to the plasma region 106 and may also provide for a desired flow of fluids through the plasma region 106 and to the substrate 1.

Entrainment of a fluid may increase processing speeds as higher volumes of fluids can be ejected from the module 20 towards the substrate 1. While the gas injector and outlet 112 may have any predetermined cross-sectional shape, the shape may be preferably circular or ovoid. The diameter of the gas injector and the diameter of the outlet 112 may dictate the flow rate. Each of the gas injectors may be moved relative to their respective outlet 112. Preferably movements of gas injectors relative to outlets 112 are within the axial direction of the gas injectors only, such that the outlet of the gas injector is substantially aligned or is concentric with the outlet 112. Relative movement of the gas injector 118 may also allow for larger volumes or smaller volumes of fluids from the chamber to be entrained with the delivery fluids. Actuators and/or motors may be used to move the gas injectors relative location it the chamber 116. Actuators may also be powered by the power source 30 which powers electrodes 102, 104.

In this way a greater control of fluid delivery to the electrodes 101 can be achieved by the module 20. Further, entrainment of fluids can also improve or control the flow of fluids or cause a laminar flow to be achieved for processing. Fluids provided to the chamber 116 may optionally be urged into a vortex which may also impart a desired fluid flow to fluids exiting an outlet 112 towards a substrate 1.

Optionally, the outlet 112 diameters may also be varied by opening or closing an iris. The iris may be actuated by an actuator in communication with a controller. The controller may be remotely activated by a user of the system 10. Optionally, the iris can be dynamically operated during use if fluid flows are outside of a desired flow rate or an adverse processing effect is observed.

Entrainment of fluids may also be used for other treatment modules which require mixing of fluids or delivery of two fluids. For example, a catalyst may be desirably mixed with a fluid via entrainment prior to being applied to a substrate 1. The catalyst may be used to begin a chemical reaction or may be required for a chemical treatment process.

It will be appreciated that entrainment of fluids cannot be adequately achieved with conventional plasma processing systems as low atmospheric conditions cause fluids to behave in a manner which would not allow for entrainment of fluids. As such, entrainment of fluids in atmospheric or near atmospheric conditions may be advantageous as this may be used to improve flow rates and therefore improve processing speeds of the system 10.

A rack 130 may be used to retain the chamber 116 in a desired position. Similarly, an electrode rack 140 may be used to retain the electrodes in a desired position. Optionally, internal the chamber supports (not shown) may be provided to restrict movement of gas injectors in directions away from the axis of the gas injector. As can be seen in Figure 12, the electrodes 101 can be connected to the chamber 116. The chamber in combination entrainment ports and gas injector 118 may be a block 120 which is mounted in a block rack 130, and the electrodes 101 can be supported by the block rack 130 or an electrode rack 140 can be coupled or connected with the block rack 130.

In a variant embodiment of Figure 12, the gas injector may be replaced with a venturi device. The Ventrui device may provide a delivery fluid and a further fluid, such as a monomer, to a choke point such that the fluids are mixed and are delivered to the outlet 112.

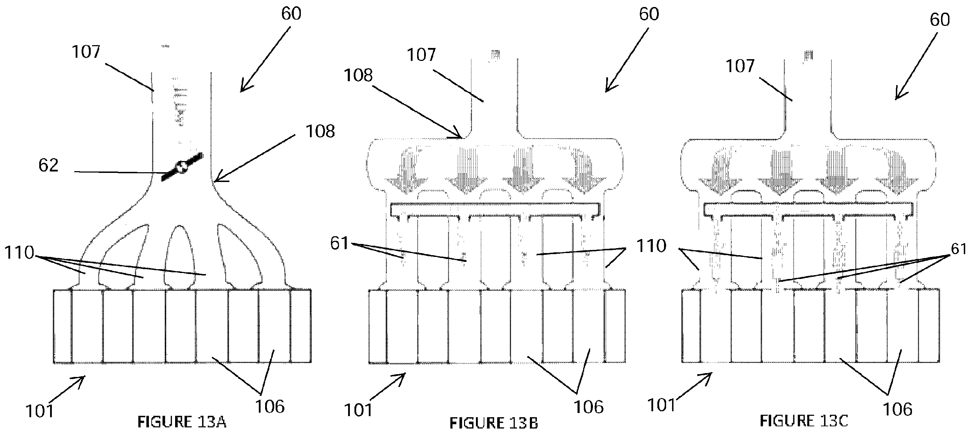

Vaporisation of fluids may be achieved by a number of fluid injector assemblies 60. Three such systems are illustrated in Figures 13A to 13C. It will be appreciated that the assemblies 60 illustrated are exemplary only and other methods may also be used by the system 10. For example, fluid vaporisation assemblies similar to those used for vamping or vaporising ingestible fluids may also be suitable for use with a module 20.

Figure 13A illustrates a single point injection assembly 60 for a module 20. A fluid injector 61 is positioned within a fluid inlet 107 in which a delivery gas stream is flowing. The fluid injector 61 may inject a vapour or vaporised fluid into the delivery gas stream to be mixed therewith to create a mixed fluid. A fluid flow control means 62, or throttle 62, is positioned downstream of the fluid injector (and therefore also the mixed fluids). The fluid flow control means 62 may control the flow rate and/or direction of the mixed fluids to the manifold 108. Mixed fluids move through the manifold channels (fluid conduits110) and are ejected via outlets 112 to the electrode 101. The mixed fluid can then be ionised and/or polymerised and used to treat a substrate 1.

A variant of an injection assembly 60 is shown in Figure 13B. Figure 13B illustrates a multipoint injection assembly for a module 20. The fluid inlet 107 is again provided with a throttle 62 to control the flow of delivery gas to the manifold 108. A vaporised fluid may be provided to each of the manifold channels via respective fluid injectors 61 and the delivery fluid mixes with the vaporised fluids within the manifold channels 110 to then be provided to the electrode arrangement 101. It will be appreciated that the fluids provided to the electrodes 101 may be polymerised to form a coating on a substrate 1, or another coating may be applied by the module to the substrate 1.

Figure 13C illustrates a further embodiment of an injector assembly 61 which uses a direct injection configuration. Similar to Figure 13B the manifold 108 channels (fluid conduits 110) house respective fluid injectors 61, however the vapour or vaporised fluids are injected directly into the plasma region 106 between the electrodes 102, 104 and the delivery gas interacts with the vaporised fluids when the delivery gas gets to the plasma region 106. In this way a monomer delivered from an injector 61 can be polymerised as it exits from said fluid injector 61. This method may also expose the injector to high temperatures and may also be positioned in a location in which arcing may occur. As such, the fluid injector 61 may be coated with a dielectric or other non-conductive material to minimise the potential for adverse plasma formations. Further direct delivery of monomer to a plasma region 106 may improve polymerisation rates and also reduce monomer build-up within the manifold 108 of the module 20. The embodiments of Figures 13A to 13C are not illustrated with a gas block, however the outlets for the fluid conduits may be in communication with a gas block 120. Optionally, the gas block 120 may comprise fluid injectors 61 instead of fluid injectors 61 being housed within fluid conduits 110. Fluid injectors 61 may be any conventional vaporiser which can be used to vaporise a fluid.

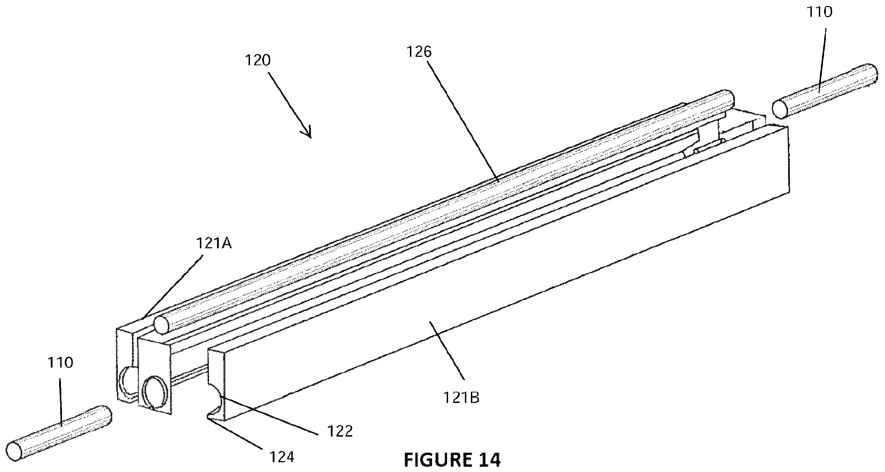

An embodiment of a block is shown in Figure 14. The block 120 shown comprises two corresponding block halves 121. The block halves 121 house a central elongate porous element 126 which receives gas flow from a gas source via fluid conduits 110 which is then directed towards the electrodes 101. A plurality of gas injection blocks 120 may be provided in a module 20 for delivery of fluids. Each gas injection block 120 may be used to deliver a discrete gas, with each gas injection block 120 being adapted to optionally provide a different discrete gas than adjacent gas injection blocks. While the gas injection block 120 is primarily used for delivery of gas, liquid may also be delivered by the gas injection block 120.

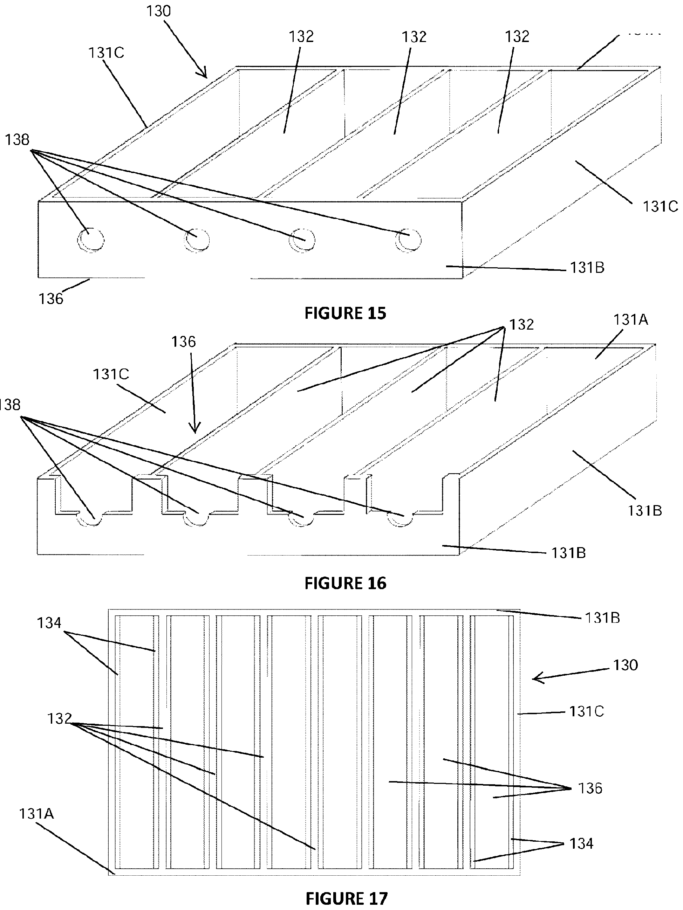

Preferably, the gas injection blocks 120 are removably mounted in the module 20 such that they can be removed, cleaned, replaced, modified or otherwise individually installed in the module. Embodiments of suitable racks for the blocks 120 are illustrated in Figure 15 to 18. Having gas injection blocks 120 individually mounted in the module 20 may allow for the outlets 112, such as outlets 112, of the gas injection blocks to be widened or narrowed. This may impact the flow rate of gases exiting the gas injection block 120 to be delivered to the plasma region 106. It is desirable for gases to generally exit the gas injection block in a uniform manner, however there may be instances in which a graduated treatment of a substrate 1 is desired, and therefore gases leaving different injection blocks 120 may have different flow rates or different exit pressures. Optionally, if a graduated treatment is desired for the substrate, the outlets 112 of the gas injection block(s) 120 have varying sizes to allow for a smaller or larger amount of fluids to exit from the block 120 which is then provided to a plasma region 106 if the module is a plasma module 20. This may provide for differences in deposition thicknesses which can be desirable if modules are depositing more than one activated species or for graduated treatment processes.

It is preferred that the fluid supplied to the elongate porous element is provided equally along the length of the element such that fluids are more evenly distributed to enter the plasma region 106 and subsequently coat or treat the surface of at least one substrate 1. The pores of the elongate porous element 126 may be evenly distributed along the length of the elongate porous elements 126.

The elongate element 126 may be formed from any desired material which is generally non-reactive, easy to flush or clean, or provides for a desired finished surface which allows for a desired flow of gas. Such materials may include, Teflon, PTFE, PFA, thermoplastic polymers, ceramic, metals, metal alloys or any other desired material. It is preferred that the elongate elements 126 are removable such that they can be readily replaced for a desired treatment process or to be cleaned. Autoclave processes may be used to clean electrodes or elongate elements after being removed. In one embodiment, the system can be flushed with water or a similar cleaning fluid which can be converted to steam or vaporised by electrodes 101 which can assist with cleaning a module.

Optionally, after treatment processes have been completed, the elongate elements 126 may be flushed with a sterilant gas, a cleaning gas, steam, or a cleaning or flushing fluid. Cleaning fluids may be provided to the elongate element 126 at a relatively high-pressure This may assist with retaining a desired porosity and reduce the build-up of deposited fluids, vaporised materials solidifying or otherwise blockages in the fluid delivery system.

The porosity of the elongate element 126 may also dictate the flow of gases or fluids through the system 10 to the electrodes 101. For example, lower porosity tubes may have higher back pressures, and tend to be more uniform; however, they allow less delivery gas flow, and consequently limit substrate 1 processing speed. Therefore, a higher porosity may be desirable for use to achieve a desired fluid flow.

As stated hereinabove, typical delivery gases may include helium, oxygen, non-noble gases, noble gases or mixtures thereof, and small amounts of additives such as nitrogen or oxygen, as examples. The substrate 1 may be treated with a chosen composition, which may react in the presence of the species exiting the plasma and, as will be discussed hereinbelow, a monomeric species may be polymerized and caused to adhere to the substrate 1 by such species.

The monomer may have various functional groups suitable for imparting desired properties to the fabric including repellency, wicking, antimicrobial activity, flame retardancy, as examples. After application to the fabric, the treated portion is moved into the vicinity of plasma regions such that excited species therefrom impinge thereon. The monomer is cured as the treated fabric is exposed to the plasma from the plasma region 106, forming thereby a polymeric material which adheres to the fabrics.

When the delivery gas is exposed to sufficient electric field from the electrode, active species generation occurs. Electrode heights investigated range from 1inch to 0.25 inch. The thinner electrodes 101 have smaller plasma volume, and hence require less RF power to maintain the plasma at a constant power density; therefore, RF power can be saved and smaller power generators can be used.

In yet another embodiment, the local area above the substrate 1 may have a low pressure and the gas and/or monomer and/or treatment chemical entering into the plasma region may have a relatively high pressure such that the monomer or treatment chemical will move into the region of relatively lower pressure. In this way gases, monomers and treatment chemicals may be more effectively applied to substrates or treat substrates.

Low pressure may be created by variances in temperature near to the substrate. For example, cold gases or cold fluids may be provided near to the local region 5 causing a low pressure and the heated fluids (from the plasma or heated in the module) above to be drawn towards the low pressure and onto the substrate.

The outlet 112 of the gas injection block 120 may impart a desired flow to fluids exiting to the plasma region. A desired flow may be a laminar flow which can be used to more effectively disperse gases into the plasma region and then to the substrate. This is particularly useful as at least one embodiment of the system 10 is used outside of a chamber and therefore the flow of fluids towards a substrate 1 may be more critical to successful deposition or treatment processes. The system 10 may be adapted to create a pressure differential such that activated species are drawn towards a substrate 1 to be treated or processed. This may be effected by causing a pressure differential between the plasma region and the substrate 1 surface (to be treated) causing activated species to more quickly move from the plasma region to the substrate 1 which may improve processing times in atmospheric conditions or improve coating or treatment of the substrate.

Figures 15 to 17 show rack variants which may be used to house blocks and/or electrodes 101 for the modules 20. These racks may have additional mounting means which allow for racks to be mounted in a module housing 22, or a wall mounting means to mount the rack in a section of the system 10.

Brackets (not shown) may be used to support the racks within a module 20 and are preferably formed from a rigid material to prevent movement of the blocks or rack when in use. Racks 130, 140 may be formed from any desired material, such as a metal, metal alloy, polymer, ceramic of any other desired material. However, it will be appreciated that the most desired materials for forming a rack are non-conductive materials, such as polymers. Similarly, module housings 22 may also be formed from similar materials as that of the racks. Polymers may be selected from the group of; Acrylonitrile Butadiene Styrene (ABS), Polypropylene, Polyethylene, High impact polystyrene (HIPS), Vinyl, Flexible PVC, Nylon, Polycarbonate, Lexan, TPE, Synthetic Rubber and Acrylic. It will be appreciated that if a conductive material is to be used, the conductive material may be coated with a dielectric or a non-conductive film or layer. For example, Teflon may be used to coat portions of a conductive surface.

Each of the racks 130 shows a plurality of block mounts which allow for placement of blocks 120 in the racks 130. Figure 15 illustrates a post-assembly rack in which a block must be mounted in the rack and then a fluid inlet can be connected to the block after mounting. This may make the rack 130 a more secure support for blocks 120 and the fluid inlet 107 may also act as an anchor location for the block 120 and thereby reduce the movement of the block 120 further. Blocks 120 may be secured or locked into the rack 130 to restrict block movement and allow for angling of the block and/or rack and/or module 20. Multiple apertures may be provided to a block rack 130 to allow for connection of more than one fluid inlet and/or fluid outlet. Further, blocks may be connected to a power supply depending on the type of module 20 the block rack 130 is to be installed within. An electrode rack 140 may be integrally formed with a block rack 130, or may be mounted with the block rack 130, or mounted with the housing 22 of the module.

Figure 16 shows a variant of Figure 15, which allows pre-connected blocks 120 to be installed within the rack 130. A portion of the outer wall 131 can be removed to allow seating of the block 120 which has already been connected to at least one of a power supply and/or fluid supply. The outer wall 131 has a front 131A and a rear 131B and a pair of side walls 131C. As shown, the rear wall 131B has been cut away to allow for a pre-connected block to be mounted therein.

In one embodiment, an electrical connector is provided in the rack for blocks and a corresponding electrical connector is formed in the block 120 such that a predetermined placement of a block can be made, and also an electrical connection can be established between the rack 130 and the block 120 by correct mounting of the block 120. Wiring and/or circuitry for the blocks 120 may be housed in the rack 130 or may be housed remotely, or in the module 20 and only wiring or grounding locations are provided in the rack 130.

A top view of a block rack is shown in Figure 17. The rack comprises an outer wall 131, and a plurality of block mounts defined by the outer wall 131 and at least one support structure 132. Support structures 132 may be generally parallel to the side walls 131CA flange 134 or retaining means 134 is provided at the base of the mount to allow seating of a block 120. When a block 120 is seated in the rack 130, the block 120 can be secured therein by screws, a fastening means, a locking rack, a clamping means or any other suitable securing means. The flanges may extend from the support structures and define an aperture through which fluids from gas blocks 120 can be ejected out output. Preferably, the apertures are sized to correspond to outlets 112 of the blocks 120. An inlet aperture 138 can be provided in the wall 131 of the rack to allow a block to be connected to a fluid supply.

The electrode rack 140 can house electrodes 101 in a predetermined array or in a predetermined configuration. While all electrodes of the system are shown as being a linear configuration, any predetermined configuration may be used. For example, electrodes 101 can be offset from each other, or pairs of electrodes (such as ground 102 and RF 104) can be staggered or otherwise displaced in a different plane that that of adjacent electrode pairs. Optionally, more than one array of electrodes may be used in a module, and may allow for fluids to pass through more than one plasma region with each plasma region having a different plasma density. This may be advantageous as initial excitation or ionisation of a fluid can be established at a high voltage or high temperature and move through a second plasma region which is of a relatively lower voltage and/or lower density to maintain excitation or ionisation.

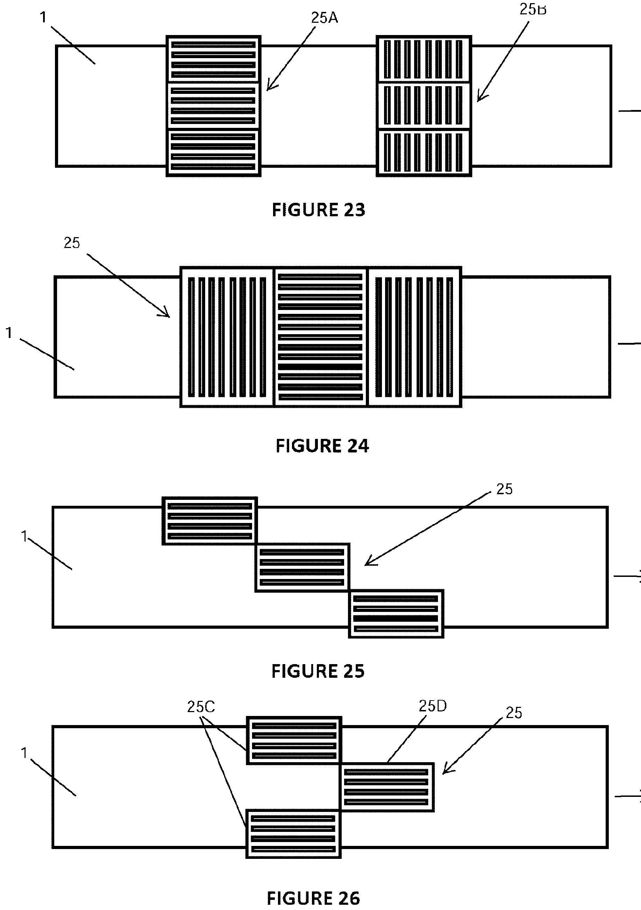

Electrodes 101 can be mounted in a direction which is parallel to the direction of movement of the substrate 1 , or may be mounted perpendicular to the direction of movement of the substrate 1 (See Figures 23 to 26 for examples of module mounting). Other orientations of the electrodes 101 may be facilitated by an electrode rack 140. As a substrate 1 may be between 1000mm to 3500mm in width, it is desirable to form an electrode rack 140 which can span at least the width of the substrate 1. However, electrodes with longer lengths may suffer from sagging which can cause; damage to electrodes, electrode movement out of a parallel arrangement, arcing, variable or undesired plasma densities, and/or require more energy to generate a plasma. Therefore, if electrodes are to be used with lengths greater than 500mm the electrodes may require additional electrode support structures within the rack which can reduce the potential for sagging of electrodes. If electrode support structures are used within the electrode rack, the electrode supports may be staggered or offset relatively such that the electrode supports do no adversely impact treatment of a substrate 1 by creating weak plasma densities in rows or lines. Multiple electrode support structures may be used within an electrode rack to allow for support of electrodes 101. Preferably, the electrode rack allows electrodes to be connected to a power supply and/or cooling system. Cooling system conduits may be installed in hollow electrodes which can provide coolant fluids to cool electrodes in use.

Electrode support structures may generally be used for electrodes 101 which are perpendicular to the flow of the substrate. It will also be appreciated that the electrode support structures for electrodes 101 may be clamps, clips or rests, and may not be similar in structure or appearance as the support structures for the block racks 130.

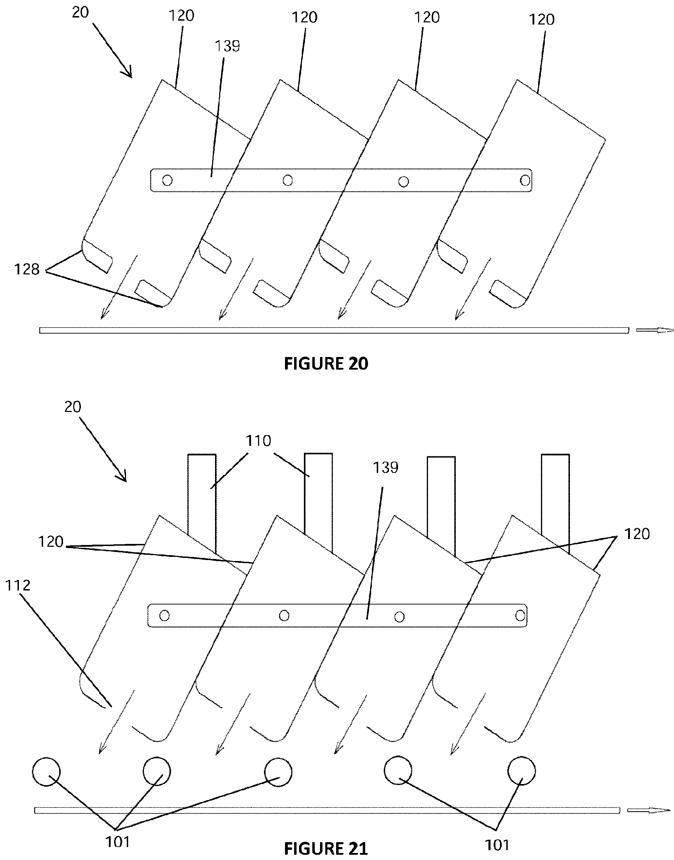

If the electrodes 101 are mounted to be substantially parallel to the movement direction of the substrate 1, the electrodes 101 may not require support structures as lengths of the electrodes can be limited. A plurality of electrode racks may be mounted adjacently as shown in Figures 19 and 20.

As the modules may use outlets 112 to eject fluids, the direction of the electrodes may not impact the orientation or the structure of the block rack. However, if a channel outlet 112 is used for the blocks which allows for ejection of fluids in a line, the orientation of the electrodes 101 may dictate the block sizing and block orientations, and therefore the block rack orientation and sizing also. Preferably, if a line outlet 112 is used the outlet 112 line may be generally parallel to the electrodes such that the fluids from the outlet 112 pass into a plasma region 106 more effectively and also reduce build-up of monomer and fluids on the electrodes 101 which can cause shorting or damage to electrodes 101. As such, block racks 130 and electrode racks 140 may have a keyed mating arrangement to ensure that blocks 130, 140 and electrode arrangements are matched to ensure effective treatment of the substrate 1.

Referring more specifically to Figures 19 and 20, there is shown an embodiment of a plurality of modules 20 mounted side by side to form a module series 25. A module series 25 may have any number of modules mounted together to allow for a desired treatment process. Modules may be mounted together parallel to the direction of movement of the substrate, or may be mounted together perpendicular to the direction of movement of the substrate 1.

Module series may comprise a plurality of the same module type, such as a plasma module or a coating module. Preferably, when mounting modules in series perpendicular to the movement direction of the substrate 1 the modules are the same type of module to allow for the same treatment across the width of the substrate 1 (see Figure 19). However, if modules are mounted in series parallel to the direction of movement of the substrate, the modules may advantageously be different module types as is seen in Figure 20.

A plurality of top views of embodiments of module series 25 arrangements are illustrated in Figures 23 to 26. Each module may be approximately 500mm in width, such that a series of three modules may be used to span a 1500mm width, which may be a standard substrate 1 width fed to a system 10 to be processed. It will be appreciated that any number of modules may be connected as a module series 25 to accommodate any width of substrate 1.

Figure 23 illustrates a top view of two module series 25 comprising three modules with electrodes 101. The first module series 25A comprises modules with a plurality of electrodes disposed parallel with the direction of movement of the substrate 1. Another module series 25B also comprises a plurality of electrodes 101 which are arranged generally perpendicularly to the direction of movement of the substrate 1. Within Figure 23 three modules are require o span the width of the substrate 1. Each module of this embodiment may be between 250mm to 1000mm in width. While the modules are shown as rectangular, the modules 20 may be square or any other desired shape.

Referring to Figure 24, there is illustrated another top view of an embodiment of a module series 25 which comprises two modules with electrodes 101 arranged perpendicular to the direction of movement of the substrate 1 and a module 20 with electrodes 101 parallel to the direction of movement. In this embodiment, the modules 20 are arranged in an alternating arrangement. Each of the modules 20 may be between 250mm to 2000mm in length such that they may be used to span the width of a substrate 1. Due to the length of the electrodes in the first and last modules 20, the electrodes may be supported at predetermined intervals.

Figure 25 shows yet another top view of an embodiment of a module series 25 comprising a staggered module arrangement. The modules are shown as being staggered or stepped with electrodes 101 being parallel to the direction of movement of the substrate 1. This configuration may allow for each module to be connected o fluid supplies and/or power supplies relatively more easily. This arrangement may also provide for a desired effect to be disposed on the surface of the substrate 1.

Figure 26 shows yet a further top view of an embodiment of a module series 25 comprising modules 20C and 20D in which module 20D is offset relative to modules 20C. The offset module 20D may be the same as modules 20C, but is offset in the direction of movement of the substrate 1. It will be appreciated that modules 20C may instead be offset relative to module 20D (not shown) in the direction of movement of the substrate 1. While module 20D is offset by an entire length of a module 20, the offset distance may be any desired distance or length.

Figure 19 illustrates a side view of three modules 20 which are mounted in series which are three of the same type of module. Each of the modules 20 can be connected such that treatment processing is not impacted near to connection sides of adjacent modules 20.

Optionally, the connection sides 131C of the racks are removable or are generally thinner (around half thickness) than the front 131A and rear 131B sides the rack. In this way when module are connected blocks for treatment are not spaced unevenly, or more generally modules are not spaced unevenly which could impact a treatment of a substrate 1.

The modules of Figures 19 and 20 are shown without module housings 22, but illustrate the close relationship of the block racks or fluid delivery portion of the modules. Further, as seen below the block racks, electrodes 101 can be spaced evenly below the outlets 112.

Figure 20 illustrates a mixed module series comprising an electrode module (such as a plasma module), a coating module, and a further electrode module. As shown the modules 20 are arranged in a series which extends parallel to the direction of movement of the substrate 1 and can allow for multiple treatments to be effected. In this embodiment, the first electrode module 20A may provide a pre-treatment to a substrate 1 which may activate a surface of a substrate. After the surface has been pre-treated, the substrate 1 moves to below the coating module 20B which can apply a fluid coating to the substrate 1. As the substrate 1 surface has been activated by the first module 20A, the coating may have an improved adhesion or other functional property imparted thereto. The final module 20C may treat or activate the fluid coating provided by the second module 20B. If the coating comprises a monomer, module 20C may be used to polymerise the monomer in the fluid.

It will be appreciated that any combination or number of modules 20 may be in a series. A module series 25 comprises two or more modules connected together, or closely spaced, or modules which function as a group. If multiple different modules 20 are connected to form a module series 25, the module series 25 is adapted to perform a treatment process which requires more than one step. Optionally, the stack of modules of the system 10 allows for a multistage processing treatment to be imparted to a substrate 1.

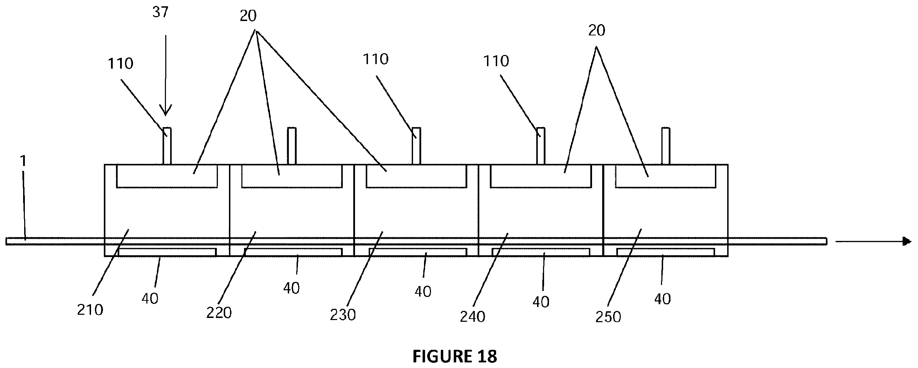

An optional processing portion is illustrated in Figure 18 in which a series of partial pressure chamber apparatus 200 are provided to process a substrate. The series of partial pressure chambers 200 may comprise at least one chamber which is partially depressurised compared to atmospheric pressure. Shown are five series of partial pressure chambers 210, 220, 230, 240, 250. Each chamber 210-250 may have a module 20 disposed therein which can treat or pre-treat a substrate 1 passing though the chamber. As each chamber is partially depressurised, a seal may be provided at the sides of each chamber which allows a substrate 1 to enter and leave, while limiting loss or increase of pressure undesirably. The series of partial depressurised chambers may be used to ramp up and/or ramp down pressures slowly such that portions of the processing line can be treated in a modified atmosphere. In such a configuration the middle most chamber, in this case chamber 230, may have the lowest or highest pressure of all the partial pressure chambers. Optionally, pressures of the first 210 and last 250 chambers may also be comparable or generally equal to each other. Similarly chambers 220 and 240 may also have substantially the same pressures therein. The chambers 210-250 may also be at atmospheric pressure, and hazardous treatments may be applied therein for safer function of the system 10. In yet another embodiment, the treatments in chambers 210-250 may allow for more effective recovery of fluids which may be cost effective if fluids used are expensive. Any fluids collected in the chambers may be recycled or reused.

In another embodiment, blocks 120 mounted in a module 20 may be adapted to be rotated or angled. Examples of such a configuration are shown in figures 20 and 21. Altering the angle of the blocks as shown may allow for faster processing speeds as treatment fluids can be propelled towards a substrate 1 at a faster flow rate. This may also allow for a substrate 1 to move at a faster speed relatively. The angle of the blocks may be related to a speed of the substrate 1 or may be used to provide an effect or property to the substrate. A predetermined aesthetic may be imparted to a substrate 1 by angling a block within the module. Other functional properties may also be imparted by angling the blocks. Notably, angling a block may allow voids to be formed if depositing a fluid onto a substrate. The flow rate of the treatment fluid may also dictate whether any voids are formed within the surface treatment provided.

While the blocks 120 are illustrated as being angled parallel to each other, adjacent blocks 120 may be adapted to be angled away complimentarily such that two adjacent blocks 120 are focused towards a single focal point or focal line. Fluids ejected from the complimentary blocks 120 may be focused to provide a thicker coating point which also may assist with depositing a functional fluid.

If the blocks 120 are part of a plasma module 20 (see Figures 20 or 21, electrodes 101 may also be adapted to move in relation to an angle of the blocks 120 such that the gas streams from the blocks are generally directed to between the electrodes to allow for a desired plasma to be formed therebetween. In another embodiment, the electrodes 101 are spaced such that any orientation of the blocks 120 allows for a plasma region to be formed. Preferably, an APG is a desired plasma to be formed in the plasma region 106. While the electrodes of Figure 21 are shown as circular electrodes 101, the electrodes 101 may be any predetermined or desired shape.

Referring to Figures 20 and 21, there are illustrated schematic side views of a module 20 with pivoting blocks 120. The picoting blocks may be similar to other gas delivery blocks 120 as described herein. The corners of the blocks at the proximal end 24 are preferably rounded 128 such that treatment processes may not be impacted by linear block corners (such as those of the block in Figure 14). The pivot bar 139 may be used as the block rack 130 and allow the blocks to be angled in the module 20. Alternatively, pivot bar 139 forms a portion of the rack 130 in which the blocks 120 can be mounted within. The blocks 120 may be fixed to the pivot bar 139 such that movement of the bar in a direction generally parallel to the substrate can angle the blocks 120 for a desired treatment process. Angling of blocks 120 may be useful for higher speed treatments as fluids from the blocks can be ejected at relatively higher velocities while maintaining a desired treatment rate.

In yet another embodiment, the system 10 can be retrofitted to an existing processing line. This may be hugely beneficial for inclusion of further treatment processes within an existing processing line and may allow for line gaps to be filled with further treatment processes. For example, a system 10 may allow for pre-treatment or surface activation treatment of a substrate, preferably using a plasma module 20. An example of a retrofitted system 10 is shown in Figure 27. The retrofitted system 10 may be a permanent fixture for the processing line, or may be a temporary fixture for the processing line. A frame 3 for the system may be placed over an existing conveyor or movement device transporting a substrate or other material. The X axis may be the direction of movement of an existing processing line, such that the modules 20 can be disposed relatively above the processing line. A predetermined number of modules 20 may be installed on the frame 3, and the modules 20 placed at a desired height or location above the existing processing line. In one embodiment, the modules 20 may be in a fixed location on the frame 3 and the frame heights and/or orientations may be changed to place the modules 20 at a desired location. Changes of the frame heights may be caused by extending or retracting the legs 3A of the frame 3, while the cross-member 3B can also be extended or shortened by similar means to allow for placement of the retrofitted system in narrow areas. Optionally, the modules may be adapted to slide on the module support 4 of the frame 3. Optionally, further modules may be mountable to the module support 4 on the frame.

The retrofitted system 10 can be turned on when desired to allow for the additional treatments to take place. If a retrofitted system is used, the system may only comprise modules mounted to a frame or other similar module support structure. The retrofitted system 10 can be on a moveable frame which allows frames to be moved to other sections of the processing line. Any module may be mounted in a retrofitted system to allow for a desired treatment to take place. Each retrofitted system may be in communication with a user terminal or user device which can be used to turn the system 10 on and program treatments. The retrofitted system 10 may include a fluid source 33, fluid delivery system 37, a power source 30, a controller to power and control modules 20 of the system 10. A fluid collection system may also be provided on the retrofitted system which can collect unused, fluid runoff or excess treatment fluids.

Optionally, any number of frames 3 and modules 20 may be used to form a retrofitted system 10. It will also be appreciated that multiple retrofitted systems 10 may be installed on an existing processing line.

In another embodiment, the retrofitted system is positioned transversely to the processing line, such that the processing line generally moves in the Y-axis. In this case, the module support 4 may extend in the X-axis to allow placement of modules 20 above the processing line. This retrofitted system 10 may be of particular advantage for processing lines which are against walls or in congested environments. Optionally, the retrofitted device is fitted with shielding or housing which can cover the module processing areas such that persons working proximal the retrofitted device 10 are protected from treatment processes.

It will be appreciated that an existing processing line may be any processing line and is not restricted to treatment of substrates. For example, the retrofitted system 10 may have use within automotive industries, material processing industries, food treatment industries, or other manufacturing industries.

The outlets 112 of the module 20 may be covered or coated with a non-conductive material such that "parasitic plasma" formation is reduced or eliminated. In one embodiment, parasitic plasma may also be reduced by increasing the length of the outlet 112 such that gases to be excited are not prematurely excited before being ejected or dispersed from the outlet 112. This may therefore reduce the potential for monomer build-up in the module and/or the gas injection block.

In one example, a monomer is pre-applied to a substrate 1 to be treated and/or polymerised. The monomer may be applied to the fabric by spraying, as an example. The monomer may have various functional groups suitable for imparting desired properties to the fabric including fluid repellency, wicking, antimicrobial activity, flame retardancy, as examples. After application to the fabric, the treated portion is moved into the vicinity of plasma regions such that excited species therefrom impinge thereon. The monomer is cured as the treated fabric is exposed to the plasma products, forming thereby a polymeric material which adheres to the fabrics.

As described in the embodiments above, coating materials may be provided to the substrate 1 from the module, and the substrate 1 is not pre-coated with monomer to be polymerised. Any desired functional coating may be provided to a substrate 1 via a module 20 of the system 10. Functional coatings may be any coating which changes a property of the substrate 1, or applies a property to a surface of the substrate 1. Functional coatings will be readily understood by a person of skill in the art.

When the delivery gas is exposed to sufficient electric field from the electrode 101, active species generation occurs. The thinner electrodes have smaller plasma volume, and hence require less RF power to maintain the plasma at a constant power density; therefore, RF power can be saved and smaller power generators can be used.

While reference is made to treatment of substrates 1 the system 10 may have other applications in treatment of other articles which may be larger articles which have multiple surfaces and are not considered to be substrates. In this unillustrated embodiment, the system 10 may have a number of treatment modules as discussed above and a conveyor or other movement system for said articles. The modules may be used to treat the articles on the conveyor movement system or process the articles on said conveyor or movement system. This may have particular utility in packaging items and food stuffs, medical items, hazardous goods, or any other item which may be advantageously be treated.

In yet another embodiment, a plasma module 20 is adapted to use low pressure discharges and may be configured to generate at least one of the following plasmas selected from the following group; glow discharge plasmas, capacitively coupled plasma, a cascaded arc plasma source, inductively coupled plasma and wave heated plasma. Glow discharge plasmas are non-thermal plasmas generated by the application of DC or low frequency RF (<100 kHz) electric field to the gap between two metal electrodes. Capacitively coupled plasma (CCP) may be similar in some respects to glow discharge plasmas, but are generated with high frequency RF electric fields, typically around 13.56 MHz. These plasmas may have particular use for plasma etching and plasma enhanced chemical vapour deposition processing. Low density, but high-pressure plasmas may be generated by cascaded arc plasma sources. Inductively coupled plasma (ICP) is another method in which an electrode consists of a coil wrapped around the region where plasma is formed. ICP may be similar to CCP processes. Wave heated plasma may be similar to CCP and ICP in that it is typically RF (or microwave).

Although the invention has been described with reference to specific examples, it will be appreciated by those skilled in the art that the invention may be embodied in many other forms within the scope of the claims.

The present invention and the described preferred embodiments specifically include at least one feature that is industrial applicable.

## Claims

1. A system (10) for treating a substrate (1), the system (10) comprising;
a treatment module (20), wherein the treatment module (20) is a plasma module;
the treatment module (20) comprising at least two elongate electrodes (101);
wherein the elongate electrodes (101) comprise a ground electrode and a RF electrode;
each of the ground electrode and the RF electrode having at least one elongated planar surface, in which the planar surface of the ground electrode and the planar surface of the RF electrode are parallel;
a substrate plane along which a substrate (1) extends; and
wherein a fluid is deliverable via the treatment module (20) to a plasma region between the treatment module (20) and the substrate plane to form a plasma for treating the substrate (1); and
**characterised in that** the relative distance between the treatment module (20) and the substrate (1) is changeable, to permit the passage of a sample from outside a plasma region (106) generated by the elongate electrodes (101) into the plasma region.

2. The system (10) as claimed in claim 1, wherein the treatment module (20) comprises more than two electrodes (101).

3. The system (10) as claimed in claim 2, wherein the electrodes (101) comprise at least one ground electrode (102) and one radiofrequency electrode (104).

4. The system (10) as claimed in any one of the preceding claims, wherein the plasma region (106) is formed between the electrodes (101) relatively above the substrate (1).

5. The system (10) as claimed in any one of the preceding claims, wherein the treatment module (20) is operational in the pressure range of 0,666 Bar-1,333 (500 Torr-1000 Torr).

6. The system (10) as claimed in anyone of the preceding claims, wherein the treatment module (20) is connected to a fluid supply (33) for delivery of fluid to the treatment module (20).

7. The system (10) as claimed in anyone of the preceding claims, wherein the treatment module (20) is connected to a power source (30) and a controller, the power source (30) being adapted to power the treatment module (20) and the controller being adapted to control functions of the treatment module (20).

8. The system (10) as claimed in anyone of the preceding claims, wherein the substrate plane is defined by a pair of rollers either side of the treatment module.

9. The system (10) as claimed in anyone of the preceding claims, wherein a vertical stack of treatment modules (20) are provided to treat a substrate (1).

10. The system (10) as claimed in anyone of the preceding claims, wherein a fluid collection means (40) is disposed relatively under the substrate (1) to collect excess fluids from the treatment module (20).

11. The system (10) as claimed in anyone of the preceding claims, wherein the system comprises a further treatment module which is selected from the group of a; coating module, film applicator module, plasma module, dyeing module, heat module, radiation module, and a thermal module.

12. The system (10) as claimed in any one of the preceding claims, wherein the treatment module (20) is a plurality of treatment modules (20) arranged in series.

13. The system (10) as claimed in anyone of the preceding claims, wherein the fluid is a delivery gas and a further fluid is provided to the plasma region (106), in which the further fluid is a monomer.

14. The system (10) as claimed in claim 13, wherein the monomer is polymerised in the plasma region (106) and said polymerised monomer from the plasma region (106) is deposited onto the surface of the substrate (1).

## Patentansprüche

1. System (10) zur Behandlung eines Substrats (1), wobei das System (10) umfasst:
ein Behandlungsmodul (20), wobei das Behandlungsmodul (20) ein Plasmamodul ist;
wobei das Behandlungsmodul (20) mindestens zwei längliche Elektroden (101) umfasst;
wobei die länglichen Elektroden (101) eine Masseelektrode und eine HF-Elektrode umfassen;
wobei jede der Masseelektrode und der HF-Elektrode mindestens eine längliche planare Oberfläche aufweist, wobei die planare Oberfläche der Masseelektrode und die planare Oberfläche der HF-Elektrode parallel sind;
eine Substratebene, entlang derer sich ein Substrat (1) erstreckt; und
wobei ein Fluid mittels des Behandlungsmoduls (20) an eine Plasmaregion zwischen dem Behandlungsmodul (20) und der Substratebene abgegeben werden kann, um ein Plasma zur Behandlung des Substrats (1) zu bilden; und
**dadurch gekennzeichnet, dass** der relative Abstand zwischen dem Behandlungsmodul (20) und dem Substrat (1) geändert werden kann, um den Durchtritt einer Probe von außerhalb einer Plasmaregion (106), die durch die länglichen Elektroden (101) erzeugt wird, in die Plasmaregion zu ermöglichen.

2. System (10) nach Anspruch 1, wobei das Behandlungsmodul (20) mehr als zwei Elektroden (101) umfasst.

3. System (10) nach Anspruch 2, wobei die Elektroden (101) mindestens eine Masseelektrode (102) und eine Hochfrequenzelektrode (104) umfassen.

4. System (10) nach einem der vorhergehenden Ansprüche, wobei die Plasmaregion (106) zwischen den Elektroden (101) relativ über dem Substrat (1) gebildet wird.

5. System (10) nach einem der vorhergehenden Ansprüche, wobei das Behandlungsmodul (20) im Druckbereich von 0,666 Bar - 1,333 Bar (500 Torr - 1000 Torr) betreibbar ist.

6. System (10) nach einem der vorhergehenden Ansprüche, wobei das Behandlungsmodul (20) mit einer Fluidzufuhr (33) zur Abgabe von Fluid an das Behandlungsmodul (20) verbunden ist.

7. System (10) nach einem der vorhergehenden Ansprüche, wobei das Behandlungsmodul (20) mit einer Energiequelle (30) und einem Controller verbunden ist, wobei die Energiequelle (30) dazu eingerichtet ist, das Behandlungsmodul (20) mit Energie zu versorgen, und der Controller dazu eingerichtet ist, Funktionen des Behandlungsmoduls (20) zu steuern.

8. System (10) nach einem der vorhergehenden Ansprüche, wobei die Substratebene durch ein Paar von Walzen auf beiden Seiten des Behandlungsmoduls definiert ist.

9. System (10) nach einem der vorhergehenden Ansprüche, wobei ein vertikaler Stapel von Behandlungsmodulen (20) vorgesehen ist, um ein Substrat (1) zu behandeln.

10. System (10) nach einem der vorhergehenden Ansprüche, wobei ein Fluidsammelmittel (40) relativ unter dem Substrat (1) angeordnet ist, um überschüssige Fluide von dem Behandlungsmodul (20) zu sammeln.

11. System (10) nach einem der vorhergehenden Ansprüche, wobei das System ein weiteres Behandlungsmodul umfasst, das aus der Gruppe von einem: Beschichtungsmodul, Filmapplikatormodul, Plasmamodul, Färbungsmodul, Heizmodul, Strahlungsmodul und einem Wärmemodul ausgewählt ist.

12. System (10) nach einem der vorhergehenden Ansprüche, wobei es sich bei dem Behandlungsmodul (20) um eine Vielzahl von Behandlungsmodulen (20) handelt, die in Reihe eingerichtet ist.

13. System (10) nach einem der vorhergehenden Ansprüche, wobei das Fluid ein Abgabegas ist und ein weiteres Fluid an die Plasmaregion (106) bereitgestellt wird, wobei das weitere Fluid ein Monomer ist.

14. System (10) nach Anspruch 13, wobei das Monomer in der Plasmaregion (106) polymerisiert wird und das besagte polymerisierte Monomer aus der Plasmaregion (106) auf der Oberfläche des Substrats (1) abgeschieden wird.

## Revendications

1. Un système (10) de traitement d'un substrat (l), le système comprenant : un module de traitement (20), dans lequel le module de traitement (20) est un module plasma ; le module de traitement comprenant au moins deux électrodes allongées (101) ; dans lequel les électrodes allongées (101) comprenant une électrode de masse et une électrode RF ; chacune de l'électrode de masse et de l'électrode RF présentant au moins une surface plane allongée, dans lequel la surface plane de l'électrode de masse et le côté de la surface plane de l'électrode RF étant parallèles ; un plan de substrat le long duquel s'étend un substrat (l) ; et dans lequel un fluide pouvant être délivré via le module de traitement (20) à une région plasma entre le module de traitement (20) et le plan de substrat pour former un plasma destiné à traiter le substrat (l) ; et **caractérisé en ce que** la distance relative entre le module de traitement (20) et le substrat (l) est modifiable, pour permettre le passage d'un échantillon depuis l'extérieur d'une région de plasma (106) générée par les électrodes allongées (101) dans la région de plasma.

2. Le système (10) selon la revendication 1, dans lequel le module de traitement (20) comprend plus de deux électrodes (101).

3. Le système (10) selon la revendication 2, dans lequel les électrodes (101) comprennent au moins une électrode de masse (102) et une électrode radiofréquence (104).

4. Le système (10) selon l'une quelconque des revendications précédentes, dans lequel la région de plasma (106) est formée entre les électrodes (101) relativement au-dessus du substrat (1).

5. Le système (10) selon l'une quelconque des revendications précédentes, dans lequel le module de traitement (20) est opérationnel dans la plage de pression de 0,666 bar à 1,333 bar (500 torr à 1000 torr).

6. Le système (10) selon l'une quelconque des revendications précédentes, dans lequel le module de traitement (20) est connecté à une alimentation en fluide (33) pour la distribution de fluide au module de traitement.
(20).

7. Le système (10) selon l'une quelconque des revendications précédentes, dans lequel le module de traitement (20) est connecté à une source d'alimentation (30) et à un contrôleur, la source d'alimentation (30) étant adaptée pour alimenter le module de traitement (20) et le contrôleur étant adapté pour contrôler les fonctions du module de traitement (20).

8. Le système (10) selon l'une quelconque des revendications précédentes, dans lequel le plan de substrat est défini par une paire de rouleaux de chaque côté du module de traitement.

9. Le système (10) selon l'une quelconque des revendications précédentes, dans lequel une pile verticale de modules de traitement (20) est prévue pour traiter un substrat (l).

10. Le système (10) selon l'une quelconque des revendications précédentes, dans lequel un moyen de collecte de fluide (40) est disposé relativement sous le substrat (1) pour collecter les fluides en excès provenant du module de traitement (20).

11. Le système (10) selon l'une quelconque des revendications précédentes, dans lequel le système comprend un module de traitement supplémentaire qui est sélectionné dans le groupe comprenant : un module de revêtement, un module applicateur de film, un module plasma, un module de teinture, un module thermique, un module de rayonnement et un module thermique.

12. Le système (10) selon l'une quelconque des revendications précédentes, dans lequel le module de traitement (20) est une pluralité de modules de traitement (20) disposés en série.

13. Le système (10) selon l'une quelconque des revendications précédentes, dans lequel le fluide est un gaz de distribution et un autre fluide est fourni à la région de plasma (106), dans lequel l'autre fluide est un monomère.

14. Le système (10) selon la revendication 13, dans lequel le monomère est polymérisé dans la région de plasma (106) et ledit monomère polymérisé provenant de la région de plasma (106) est déposé sur la surface du substrat (l).
